(19) Europäisches Patentamt
European Patent Office
Office européen des brevets

(11) EP 4 412 429 B1

(12) # EUROPEAN PATENT SPECIFICATION

(45) Date of publication and mention of the grant of the patent:
**18.03.2026 Bulletin 2026/12**

(21) Application number: **24154414.7**

(22) Date of filing: **29.01.2024**

(51) International Patent Classification (IPC):
***H10K 50/19*** *(2023.01)* ***H10K 85/60*** *(2023.01)*

(52) Cooperative Patent Classification (CPC):
**H10K 50/19; H10K 85/615; H10K 85/622; H10K 85/623**

(54) **ORGANIC LIGHT-EMITTING ELEMENT**
ORGANISCHES LICHTEMITTIERENDES ELEMENT
ÉLÉMENT ÉLECTROLUMINESCENT ORGANIQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **31.01.2023 JP 2023013436**
**01.11.2023 JP 2023187534**

(43) Date of publication of application:
**07.08.2024 Bulletin 2024/32**

(73) Proprietor: **CANON KABUSHIKI KAISHA**
**Tokyo 146-8501 (JP)**

(72) Inventors:
- **NISHIDE, Yosuke**
**Tokyo, 146-8501 (JP)**
- **IWAWAKI, Hironobu**
**Tokyo, 146-8501 (JP)**
- **TAKAYA, Itaru**
**Tokyo, 146-8501 (JP)**
- **OHRUI, Hiroki**
**Tokyo, 146-8501 (JP)**
- **SHIOBARA, Satoru**
**Tokyo, 146-8501 (JP)**
- **YAMADA, Naoki**
**Tokyo, 146-8501 (JP)**

(74) Representative: **TBK**
**Bavariaring 4-6**
**80336 München (DE)**

(56) References cited:
**JP-A- 2014 075 347**
**KR-A- 20150 039 631**
**US-A1- 2011 108 810**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 412 429 B1

## Description

### BACKGROUND OF THE INVENTION

#### Field of the Invention

The present disclosure relates to an organic light-emitting element.

#### Description of the Related Art

An organic electroluminescent element (hereinafter also referred to as an "organic EL element" or an "organic light-emitting element") is an element that emits light by energizing a positive electrode, a negative electrode, and an organic compound layer including a light-emitting layer disposed between these electrodes.

In recent years, in addition to single-color organic light-emitting elements that contain light-emitting materials for emitting red light, green light, and blue light in one light-emitting layer and emits white light, multilayer organic light-emitting elements have been developed in which light-emitting layers that emit red light, green light, and blue light are stacked. Multilayer organic light-emitting elements tend to have a higher drive voltage than monolayer organic light-emitting elements. Thus, a known structure includes an intermediate layer referred to as a charge generation portion or an intermediate electrode. The intermediate layer may be more likely to deteriorate than other organic layers. The degradation of the intermediate layer results in an increase in voltage, a decrease in efficiency, and a decrease in durability, and there is a need for the development of a stable charge generation layer.

U.S. Patent Application Publication No. 2016/0104844 (PTL1) describes a configuration in which an organic compound with a pyrene skeleton is used in an n-type charge generation layer. JP2014075347 A discloses an OLED with an n-type and a p-type charge generation layer. The n-type charge generation layer contains a mixture of two organic compounds.

However, the multilayer organic light-emitting element described in PTL1 has a heterocycle as a substituent on the pyrene skeleton in the n-type charge generation layer. A compound with a heterocyclic group may have low stability to holes. Thus, the multilayer organic light-emitting element disclosed in PTL1 has room for improvement in the durability of the n-type charge generation layer.

### SUMMARY OF THE INVENTION

The present disclosure has been made in view of the above circumstances and provides an organic light-emitting element with high durability.

The present disclosure in its first aspect provides an organic light-emitting element as specified in claims 1 to 16.

The present disclosure in its second aspect provides a display apparatus as specified in claims 17 and 18.

The present disclosure in its third aspect provides a photoelectric conversion apparatus as specified in claim 19.

The present disclosure in its fourth aspect provides an electronic equipment as specified in claim 20.

The present disclosure in its fifth aspect provides a wearable device as specified in claim 21.

The present disclosure in its sixth aspect provides a lighting apparatus as specified in claim 22.

The present disclosure in its seventh aspect provides a moving body as specified in claim 23.

The present disclosure in its eighth aspect provides an image-forming apparatus as specified in claim 24.

Further features of the present disclosure will become apparent from the following description of exemplary embodiments with reference to the attached drawings.

### BRIEF DESCRIPTION OF THE DRAWINGS

Fig. 1 is a schematic cross-sectional view of an example of an organic light-emitting element according to an embodiment of the present disclosure.

Fig. 2A is a schematic cross-sectional view of an example of a pixel of a display apparatus according to an embodiment of the present disclosure.

Fig. 2B is a schematic cross-sectional view of an example of a display apparatus including an organic light-emitting element according to an embodiment of the present disclosure.

Fig. 3 is a schematic view of an example of a display apparatus according to an embodiment of the present disclosure.

Fig. 4A is a schematic view of an example of an imaging apparatus according to an embodiment of the present disclosure.

Fig. 4B is a schematic view of an example of electronic equipment according to an embodiment of the present disclosure.
Fig. 5A is a schematic view of an example of a display apparatus according to an embodiment of the present disclosure.
Fig. 5B is a schematic view of an example of a foldable display apparatus.
Fig. 6A is a schematic view of an example of a lighting apparatus according to an embodiment of the present disclosure.
Fig. 6B is a schematic view of an example of an automobile with a vehicle lamp according to an embodiment of the present disclosure.
Fig. 7A is a schematic view of an example of a wearable device according to an embodiment of the present disclosure.
Fig. 7B is a schematic view of an example of a wearable device according to an embodiment of the present disclosure with an imaging apparatus.
Fig. 8A is a schematic view of an example of an image-forming apparatus according to an embodiment of the present disclosure.
Fig. 8B is a schematic view of an example of an exposure light source for an image-forming apparatus according to an embodiment of the present disclosure.
Fig. 8C is a schematic view of an example of an exposure light source for an image-forming apparatus according to an embodiment of the present disclosure.

## DESCRIPTION OF THE EMBODIMENTS

In the present specification, the halogen atom is, for example, but not limited to, a fluorine atom, a chlorine atom, a bromine atom, an iodine atom, or the like. In particular, a fluorine atom can be used.

An alkali metal atom is, for example, but not limited to, a lithium atom, a sodium atom, a potassium atom, a rubidium atom, a cesium atom, or the like. In particular, a lithium atom or a cesium atom can be used.

An alkaline-earth metal atom is, for example, but not limited to, a beryllium atom, a magnesium atom, a calcium atom, a strontium atom, or the like.

The alkyl group may be an alkyl group with 1 to 20 carbon atoms. Specific examples include, but are not limited to, a methyl group, an ethyl group, a n-propyl group, an iso-propyl group, a n-butyl group, an iso-butyl group, a sec-butyl group, a tert-butyl group, a n-pentyl group, an iso-pentyl group, a tert-pentyl group, a neopentyl group, a n-hexyl group, an octyl group, a cyclohexyl group, a 1-adamantyl group, a 2-adamantyl group, and the like. The alkyl group can have 1 or more and 10 or less carbon atoms, or 1 or more and 6 or less carbon atoms. More specifically, a methyl group or a tert-butyl group can be used.

The alkoxy group may be an alkoxy group with 1 or more and 10 or less carbon atoms. Specific examples include, but are not limited to, a methoxy group, an ethoxy group, a n-propoxy group, an iso-propoxy group, a n-butoxy group, a tert-butoxy group, a 2-ethyl-octyloxy group, a benzyloxy group, and the like. The alkoxy group can have 1 or more and 4 or less carbon atoms. More specifically, a methoxy group can be used.

The aryl group may be an aryl group with 6 or more and 30 or less carbon atoms. Specific examples include, but are not limited to, a phenyl group, a naphthyl group, a phenanthryl group, an anthryl group, a fluorenyl group, a biphenylenyl group, an acenaphthylenyl group, a chrysenyl group, a pyrenyl group, a triphenylenyl group, a picenyl group, a fluoranthenyl group, a perylenyl group, a naphthacenyl group, a biphenyl group, a terphenyl group, a phenylene group, a naphthylene group, a phenanthrenylene group, a biphenyl group, a fluoranthenylene group, a chrysenylene group, a pyrenylene group, and the like.

A heterocyclic group may be a heterocyclic group with 3 or more and 27 or less carbon atoms. Specific examples include, but are not limited to, a thienyl group, a pyrrolyl group, a pyrazinyl group, a pyridyl group, an indolyl group, a quinolyl group, an isoquinolyl group, a naphthyridinyl group, an acridinyl group, a phenanthrolinyl group, a carbazolyl group, a benzo[a]carbazolyl group, a benzo[b]carbazolyl group, a benzo[c]carbazolyl group, a phenazinyl group, a phenoxazinyl group, a phenothiazinyl, a benzothiophenyl group, a dibenzothiophenyl group, a benzofuranyl group, a dibenzofuranyl group, an oxazolyl group, an oxadiazolyl group, and the like.

The silyl group may be more specifically, but is not limited to, a trimethylsilyl group, a triphenylsilyl group, or the like.

The amino group may be more specifically, but is not limited to, an N-methylamino group, an N-ethylamino group, an N,N-dimethylamino group, an N,N-diethylamino group, an N-methyl-N-ethylamino group, an N-benzylamino group, an N-methyl-N-benzylamino group, an N,N-dibenzylamino group, an anilino group, an N,N-diphenylamino group, an N,N-dinaphthylamino group, an N,N-difluorenylamino group, an N-phenyl-N-tolylamino group, an N,N-ditolylamino group, an N-methyl-N-phenylamino group, an N,N-dianisolylamino group, an N-mesityl-N-phenylamino group, an N,N-dimesitylamino group, an N-phenyl-N-(4-tert-butylphenyl)amino group, an N-phenyl-N-(4-trifluoromethylphenyl)amino group, or the like. The amino group can be an N,N-dimethylamino group or an N,N-diphenylamino group.

An optional substituent of the alkyl group, the alkoxy group, the aryl group, the heterocyclic group, the silyl group, and the amino group is, for example, but not limited to, an alkyl group, such as a methyl group, an ethyl group, a n-propyl group, an iso-propyl group, a n-butyl group, an iso-butyl group, a sec-butyl group, a tert-butyl group, a n-pentyl group, an iso-pentyl group, a tert-pentyl group, a neopentyl group, a n-hexyl group, or a cyclohexyl group; an alkoxy group, such as a methoxy group, an ethoxy group, an iso-propoxy group, a n-butoxy group, or a tert-butoxy group; a substituted amino group, such as an N-methylamino group, an N-ethylamino group, an N,N-dimethylamino group, an N,N-diethylamino group, an N-methyl-N-ethylamino group, an N-benzylamino group, an N-methyl-N-benzylamino group, an N,N-dibenzylamino group, an anilino group, an N,N-diphenylamino group, an N,N-dinaphthylamino group, an N,N-difluorenylamino group, an N-phenyl-N-tolylamino group, an N,N-ditolylamino group, an N-methyl-N-phenylamino group, an N,N-dianisolylamino group, an N-mesityl-N-phenylamino group, an N,N-dimesitylamino group, an N-phenyl-N-(4-tert-butylphenyl) amino group, or an N-phenyl-N-(4-trifluoromethylphenyl)amino group; an aryl group, such as a phenyl group, a naphthyl group, a phenanthryl group, an anthryl group, a fluorenyl group, a biphenylenyl group, an acenaphthylenyl group, a chrysenyl group, a pyrenyl group, a triphenylenyl group, a picenyl group, a fluoranthenyl group, a perylenyl group, a naphthacenyl group, a biphenyl group, or a terphenyl group; a heteroaryl group, such as a thienyl group, a pyrrolyl group, a pyrazinyl group, a pyridyl group, an indolyl group, a quinolyl group, an isoquinolyl group, a naphthyridinyl group, an acridinyl group, a phenanthrolinyl group, carbazolyl group, a benzo[a]carbazolyl group, a benzo[b]carbazolyl group, a benzo[c]carbazolyl group, a phenazinyl group, a phenoxazinyl group, a phenothiazinyl group, a benzothiophenyl group, a dibenzothiophenyl group, a benzofuranyl group, a dibenzofuranyl group, an oxazolyl group, or an oxadiazolyl group; a cyano group, a trifluoromethyl group, or the like.

The fused polycyclic hydrocarbon skeleton is a skeleton composed only of a carbon atom, a hydrogen atom, and a deuterium atom in which a plurality of rings are fused. The hydrocarbon compound is a compound composed only of a carbon atom, a hydrogen atom, and a deuterium atom.

HOMO (H1), HOMO (H2), HOMO (H3), HOMO (H4), and HOMO (D1) refer to the HOMO energy level of the first organic compound, the HOMO energy level of the second organic compound, the HOMO energy level of the third organic compound, the HOMO energy level of the fourth organic compound, and HOMO energy level of the first light-emitting compound, respectively. HOMO stands for the highest occupied molecular orbital.

LUMO (H1), LUMO (H2), LUMO (H3), LUMO (H4), and LUMO (D1) refer to the LUMO energy level of the first organic compound, the LUMO energy level of the second organic compound, the LUMO energy level of the third organic compound, the LUMO energy level of the fourth organic compound, and LUMO energy level of the first light-emitting compound, respectively. LUMO stands for the lowest unoccupied molecular orbital.

The durability of an organic light-emitting element can be evaluated by the time taken for the luminance to decrease. When the time taken for the luminance to decrease from the initial luminance to a certain luminance is compared, it can be said that a longer time indicates higher durability.

(1) Organic light-emitting element

An organic light-emitting element according to one aspect of the present disclosure includes a first electrode, a first light-emitting unit, a charge generation portion, a second light-emitting unit, and a second electrode in this order, wherein the charge generation portion includes at least one n-type charge generation layer, the n-type charge generation layer contains at least a first organic compound and a second organic compound, and the second organic compound is represented by any one of the general formulae [1-1] to [1-10]:

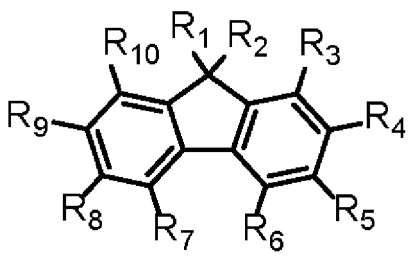

[1 − 1]

wherein $R_1$ to $R_{10}$ are each independently selected from the group consisting of a hydrogen atom, a deuterium atom, a halogen atom, a substituted or unsubstituted alkyl group, a substituted or unsubstituted alkoxy group, a substituted or unsubstituted aryl group and a substituted or unsubstituted silyl group.

$R_1$ to $R_{10}$ can be a hydrogen atom, a deuterium atom, a substituted or unsubstituted alkyl group, or a substituted or unsubstituted aryl group, or can be a hydrogen atom, a substituted or unsubstituted alkyl group with 1 or more and 4 or

less carbon atoms, or a substituted or unsubstituted aryl group with 6 or more and 30 or less carbon atoms. More specifically, they can have a hydrogen atom, a deuterium atom, a methyl group, a $CD_3$ group, a terphenyl skeleton, a biphenyl skeleton, a fluorene skeleton, a naphthalene skeleton, a pyrene skeleton, a quinquephenyl skeleton, a chrysene skeleton, a fluoranthene skeleton, or a benzofluorene skeleton, can have a hydrogen atom, a methyl group, a $CD_3$ group, a pyrene skeleton, a quinquephenyl skeleton, a chrysene skeleton, or terphenyl skeleton, or can have a hydrogen atom, a methyl group, a $CD_3$ group, a pyrene skeleton, a quinquephenyl skeleton, a chrysene skeleton having a naphthalene skeleton as a substituent, or a terphenyl skeleton having a phenyl skeleton and a fluorene skeleton.

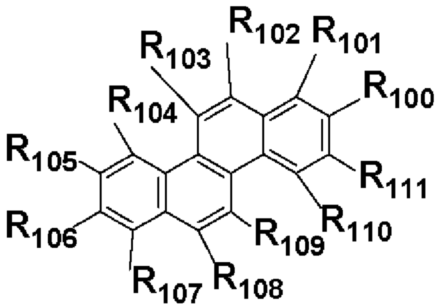

[1 − 2]

In the general formula [1-2], $R_{100}$ to $R_{111}$ are each independently selected from the group consisting of a hydrogen atom, a deuterium atom, a halogen atom, a substituted or unsubstituted alkyl group, a substituted or unsubstituted alkoxy group, a substituted or unsubstituted aryl group and a substituted or unsubstituted silyl group.

$R_{100}$ to $R_{111}$ can be a hydrogen atom, a deuterium atom, or a substituted or unsubstituted aryl group, can be a hydrogen atom or a substituted or unsubstituted aryl group with 6 or more and 20 or less carbon atoms, or can be a hydrogen atom or a substituted or unsubstituted aryl group with 10 or more and 16 or less carbon atoms. More specifically, they can have a hydrogen atom, a deuterium atom, a benzene skeleton, a biphenyl skeleton, a terphenyl skeleton, a naphthalene skeleton, a triphenylene skeleton, a phenanthrene skeleton, or a pyrene skeleton, can have a hydrogen atom, a naphthalene skeleton, or a pyrene skeleton, or can be a hydrogen atom, a naphthalene skeleton, or a pyrene skeleton.

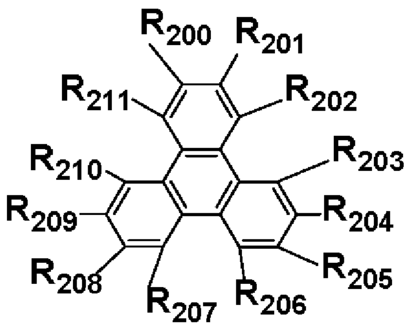

[1 − 3]

In the general formula [1-3], $R_{200}$ to $R_{211}$ are each independently selected from the group consisting of a hydrogen atom, a deuterium atom, a halogen atom, a substituted or unsubstituted alkyl group, a substituted or unsubstituted alkoxy group, a substituted or unsubstituted aryl group and a substituted or unsubstituted silyl group.

$R_{200}$ to $R_{211}$ can be a hydrogen atom, a deuterium atom, or a substituted or unsubstituted aryl group, can be a hydrogen atom or a substituted or unsubstituted aryl group with 6 or more and 20 or less carbon atoms, or can be a hydrogen atom or a substituted or unsubstituted aryl group with 10 or more and 16 or less carbon atoms. More specifically, they can have a hydrogen atom, a deuterium atom, a naphthalene skeleton, a phenanthrene skeleton, a pyrene skeleton, a triphenylene skeleton, a chrysene skeleton, a terphenyl skeleton, a benzene skeleton, or a fluoranthene skeleton, can have a hydrogen atom or a pyrene skeleton, or can have a hydrogen atom or a pyrene skeleton having a biphenyl skeleton as a substituent.

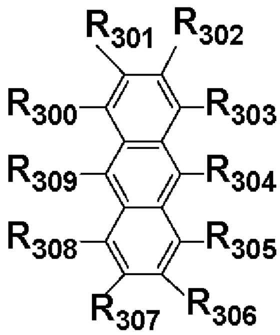

[1 − 4]

In the general formula [1-4], $R_{300}$ to $R_{309}$ are each independently selected from the group consisting of a hydrogen atom, a deuterium atom, a halogen atom, a substituted or unsubstituted alkyl group, a substituted or unsubstituted alkoxy group, a substituted or unsubstituted aryl group and a substituted or unsubstituted silyl group.

$R_{300}$ to $R_{309}$ can be a hydrogen atom, a deuterium atom, or a substituted or unsubstituted aryl group, can be a hydrogen atom or an aryl group with 6 or more and 20 or less carbon atoms, or can be a hydrogen atom or a substituted or unsubstituted aryl group with 6 or more and 10 or less carbon atoms. More specifically, they can have a hydrogen atom, a deuterium atom, a phenanthrene skeleton, a benzene skeleton, a triphenylene skeleton, or a naphthalene skeleton, can have a hydrogen atom, a naphthalene skeleton, or a benzene skeleton, or can have a hydrogen atom, a naphthalene skeleton, or a benzene skeleton having a naphthalene skeleton as a substituent.

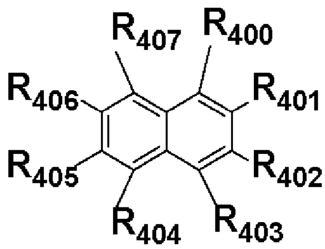

[1 − 5]

In the general formula [1-5], $R_{400}$ to $R_{407}$ are each independently selected from the group consisting of a hydrogen atom, a deuterium atom, a halogen atom, a substituted or unsubstituted alkyl group, a substituted or unsubstituted alkoxy group, a substituted or unsubstituted aryl group and a substituted or unsubstituted silyl group.

$R_{400}$ to $R_{407}$ can be a hydrogen atom, a deuterium atom, or a substituted or unsubstituted aryl group or can be a hydrogen atom or an aryl group with 16 or more and 20 or less carbon atoms. More specifically, they can have a hydrogen atom, a deuterium atom, a chrysene skeleton, a pyrene skeleton, a triphenylene skeleton, or a fluoranthene skeleton.

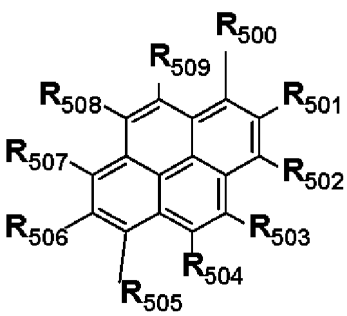

[1 − 6]

In the general formula [1-6], $R_{500}$ to $R_{509}$ are each independently selected from the group consisting of a hydrogen atom, a deuterium atom, a halogen atom, a substituted or unsubstituted alkyl group, a substituted or unsubstituted alkoxy group, a substituted or unsubstituted aryl group and a substituted or unsubstituted silyl group.

$R_{500}$ to $R_{509}$ can be a hydrogen atom, a deuterium atom, or a substituted or unsubstituted aryl group, can be a

hydrogen atom or a substituted or unsubstituted aryl group with 6 or more and 20 or less carbon atoms, or can be a hydrogen atom or an aryl group with 10 or more and 16 or less carbon atoms. More specifically, they can have a hydrogen atom, a deuterium atom, a benzene skeleton, a biphenyl skeleton, a terphenyl skeleton, a phenanthrene skeleton, a pyrene skeleton, a fluoranthene skeleton, or a perylene skeleton, can have a hydrogen atom or a benzene skeleton, or can have a hydrogen atom or a benzene skeleton having a pyrene skeleton as a substituent.

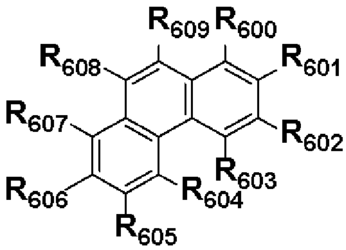

[1-7]

In the general formula [1-7], $R_{600}$ to $R_{609}$ are each independently selected from the group consisting of a hydrogen atom, a deuterium atom, a halogen atom, a substituted or unsubstituted alkyl group, a substituted or unsubstituted alkoxy group, a substituted or unsubstituted aryl group and a substituted or unsubstituted silyl group.

$R_{600}$ to $R_{609}$ can be a hydrogen atom, a deuterium atom, or a substituted or unsubstituted aryl group or can be a hydrogen atom or a substituted or unsubstituted aryl group with 12 or more and 30 or less carbon atoms. More specifically, they can have a hydrogen atom, a deuterium atom, a biphenyl skeleton, a terphenyl skeleton, or a quinquephenyl skeleton, can have a hydrogen atom, a terphenyl skeleton, or a quinquephenyl skeleton, or can be a hydrogen atom, a terphenyl skeleton, or a quinquephenyl skeleton.

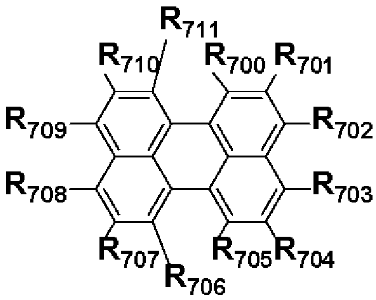

[1-8]

In the general formula [1-8], $R_{700}$ to $R_{711}$ are each independently selected from the group consisting of a hydrogen atom, a deuterium atom, a halogen atom, a substituted or unsubstituted alkyl group, a substituted or unsubstituted alkoxy group, a substituted or unsubstituted aryl group and a substituted or unsubstituted silyl group.

$R_{700}$ to $R_{711}$ can be a hydrogen atom, a deuterium atom, or a substituted or unsubstituted aryl group, can be a hydrogen atom or a substituted or unsubstituted aryl group with 6 or more and 30 or less carbon atoms, or can be a hydrogen atom or a substituted or unsubstituted aryl group with 20 or more and 30 or less carbon atoms. More specifically, they can have a hydrogen atom, a deuterium atom, a benzene skeleton, a naphthalene skeleton, a terphenyl skeleton, a chrysene skeleton, a perylene skeleton, or a quinquephenyl skeleton, can have a hydrogen atom, a perylene skeleton, or a quinquephenyl skeleton, or can be a hydrogen atom, a perylene skeleton, or a quinquephenyl skeleton.

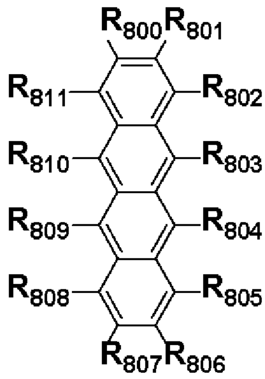

[1 − 9]

In the general formula [1-9], $R_{800}$ to $R_{811}$ are each independently selected from the group consisting of a hydrogen atom, a deuterium atom, a halogen atom, a substituted or unsubstituted alkyl group, a substituted or unsubstituted alkoxy group, a substituted or unsubstituted aryl group and a substituted or unsubstituted silyl group.

$R_{800}$ to $R_{811}$ can be a hydrogen atom, a deuterium atom, or a substituted or unsubstituted aryl group, can be a hydrogen atom or a substituted or unsubstituted aryl group with 6 or more and 18 or less carbon atoms, or can be a hydrogen atom or a substituted or unsubstituted aryl group with 6 or more and 12 or less carbon atoms. More specifically, they can have a hydrogen atom, a deuterium atom, a benzene skeleton, a naphthalene skeleton, a terphenyl skeleton, or a biphenyl skeleton, can have a hydrogen atom, a benzene skeleton, or a biphenyl skeleton, or can be a hydrogen atom, a benzene skeleton, or a biphenyl skeleton.

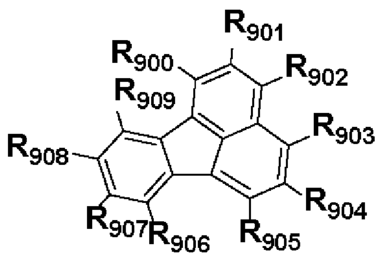

[1 − 1 0]

In the general formula [1-10], $R_{900}$ to $R_{909}$ are each independently selected from the group consisting of a hydrogen atom, a deuterium atom, a halogen atom, a substituted or unsubstituted alkyl group, a substituted or unsubstituted alkoxy group, a substituted or unsubstituted aryl group and a substituted or unsubstituted silyl group.

$R_{900}$ to $R_{909}$ can be a hydrogen atom, a deuterium atom, or a substituted or unsubstituted aryl group, can be a hydrogen atom or a substituted or unsubstituted aryl group with 6 or more and 20 or less carbon atoms, or can be a hydrogen atom or a substituted or unsubstituted aryl group with 12 or more and 20 or less carbon atoms. More specifically, they can have a hydrogen atom, a deuterium atom, a phenyl skeleton, a biphenyl skeleton, a fluoranthene skeleton, a benzofluoranthene skeleton, or a perylene skeleton, can have a hydrogen atom, a biphenyl skeleton, or a benzofluoranthene skeleton, or can be a hydrogen atom, a biphenyl skeleton, or a benzofluoranthene skeleton.

Another aspect of an organic light-emitting element according to the present disclosure is an organic light-emitting element including: a first electrode; a first light-emitting unit; a charge generation portion; a second light-emitting unit; and a second electrode in this order, wherein the charge generation portion includes at least one n-type charge generation layer, the n-type charge generation layer contains at least a first organic compound and a second organic compound, and the second organic compound is a hydrocarbon compound with a fused polycyclic hydrocarbon skeleton.

In still another aspect of an organic light-emitting element according to the present disclosure, the second organic compound is any hydrocarbon compound with a fused polycyclic hydrocarbon skeleton. The fused polycyclic hydrocarbon skeleton can be an aryl group with 10 or more and 20 or less carbon atoms and, more specifically, may be a skeleton represented by any one of the general formulae [1-1] to [1-10]. At this time, in the general formulae [1-1] to [1-10], $R_1$ to $R_{909}$ are each independently a hydrogen atom, a deuterium atom, a substituted or unsubstituted alkyl group, or a substituted or unsubstituted aryl group. When $R_1$ to $R_{909}$ further have a substituent, the substituent is a deuterium atoms, an alkyl group, or an aryl group.

An organic light-emitting element according to the present embodiment may include a third light-emitting unit in

addition to the first light-emitting unit and the second light-emitting unit. The third light-emitting unit may be provided between the first electrode and the first light-emitting unit, between the first light-emitting unit and the second light-emitting unit, or between the second light-emitting unit and the second electrode.

The first electrode may be a positive electrode, and the second electrode may be a negative electrode.

The organic light-emitting element according to the present embodiment may have an element structure that can emit white light. More specifically, the first light-emitting unit may emit red light and green light, and the second light-emitting unit may emit blue light. The first light-emitting unit, the second light-emitting unit, and the third light-emitting unit may emit red light, green light, and blue light, respectively.

The organic light-emitting element according to the present embodiment may have an element structure that can emit light other than white light. More specifically, the first light-emitting unit and the second light-emitting unit may emit light of the same color. With such an element structure, an organic light-emitting element with higher luminance can be produced.

The present disclosure will be described in more detail below with reference to Fig. 1.

Fig. 1 is a schematic cross-sectional view of an organic light-emitting element according to an embodiment, in which a first electrode 200, a first light-emitting unit 300, a charge generation portion 400, a second light-emitting unit 500, and a second electrode 600 are stacked in this order on a substrate 1.

In an organic light-emitting element according to the present disclosure, the first light-emitting unit 300 has a first light-emitting layer 303. The first light-emitting layer 303 contains at least a third organic compound and a first light-emitting compound. If necessary, the first light-emitting layer 303 may contain a fourth organic compound. If necessary, the first light-emitting unit 300 may have another layer. In the organic light-emitting element according to the present embodiment, more specifically, the first light-emitting unit 300 may have a first hole injection layer 301, a first hole transport layer 302, the first light-emitting layer 303, and a first electron transport layer 304.

In the organic light-emitting element according to the present embodiment, the second light-emitting unit 500 has a second light-emitting layer 503. The second light-emitting layer 503 contains at least a guest compound. If necessary, the second light-emitting layer 503 may contain a host compound or an assist compound. If necessary, the second light-emitting unit 500 may have another layer. More specifically, the second light-emitting unit may have a second hole injection layer 501, a second hole transport layer 502, the second light-emitting layer 503, and a second electron transport layer 504.

The host compound is a compound with the highest mass ratio among the compounds constituting the light-emitting layer. The guest compound is a compound that has a lower mass ratio than the host compound among the compounds constituting the light-emitting layer and that is a principal light-emitting compound. The assist compound is a compound that has a lower mass ratio than the host compound among the compounds constituting the light-emitting layer and that assists the guest compound in emitting light. The assist compound is also referred to as a second host compound.

In an organic light-emitting element according to the present disclosure, the charge generation portion 400 has at least one n-type charge generation layer. In the organic light-emitting element according to the present embodiment, the charge generation portion 400 serves to inject an electron into the first light-emitting unit. Thus, the organic light-emitting element according to the present embodiment does not necessarily have a first electron injection layer 305. No first electron injection layer 305 can be expected to lower the drive voltage of the organic light-emitting element according to the present embodiment.

When the organic light-emitting element according to the present embodiment has the first electron injection layer 305, the first electron injection layer 305 can be provided adjacent to the n-type charge generation layer, and the n-type charge generation layer and the first electron injection layer 305 can contain a common material. This can enhance the adhesion between the n-type charge generation layer and the first electron injection layer 305 and further improve the function as the electron injection layer.

A specific structure of the charge generation portion 400 is described below; however, the structure is not limited thereto.

(i) n-type charge generation layer/hole injection layer
(ii) n-type charge generation layer/p-type charge generation layer
(iii) n-type charge generation layer/connection layer/hole injection layer
(iv) n-type charge generation layer/connection layer/p-type charge generation layer

In the organic light-emitting element according to the present embodiment, the n-type charge generation layer is a mixture layer containing the first organic compound and the second organic compound. The n-type charge generation layer may further contain an alkali metal atom or an alkaline-earth metal atom and can contain an alkali metal atom. The p-type charge generation layer may be a mixture layer containing a hole transport compound and an electron-withdrawing compound. The hole injection layer may be a layer containing an electron-withdrawing compound or a metal oxide. The connection layer may be a layer containing an electron transport compound or a hole transport compound.

The first organic compound is, for example, a nitrogen-containing heterocyclic derivative. Specific examples include, but are not limited to, a pyridyl group, a pyrimidinyl group, a pyrazinyl group, a triazinyl group, a quinolyl group, an isoquinolyl group, a phenanthrolinyl group, an oxazolyl group, an oxadiazolyl group, a diazolyl group, a thiadiazolyl group, a triazolyl group, and a derivative thereof. Among these, the first organic compound can be a phenanthroline derivative. The phenanthroline derivative refers to a compound with a phenanthroline skeleton. The phenanthroline derivative interacts particularly strongly with an alkali metal and is stable as a material for the n-type charge generation layer.

The second organic compound is an organic compound represented by any one of the general formulae [1-1] to [1-10]:

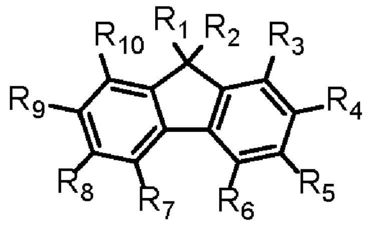

[1-1]

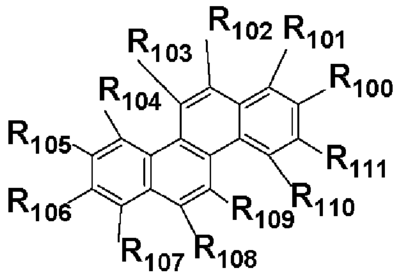

[1-2]

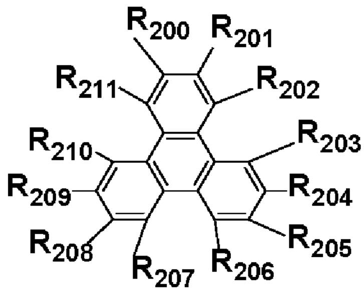

[1-3]

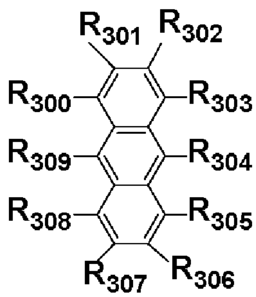

[1-4]

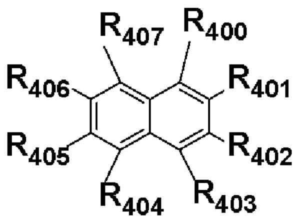

[1-5]

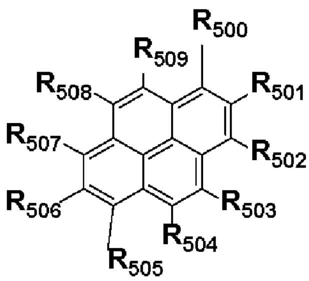

[1-6]

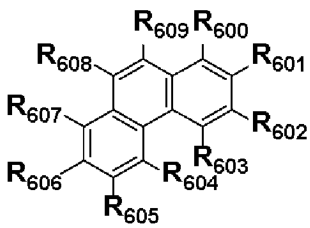

[1-7]

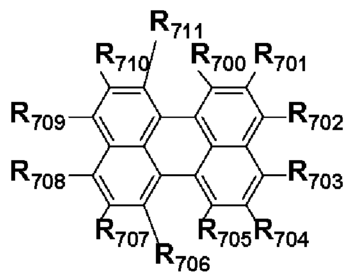

[1-8]

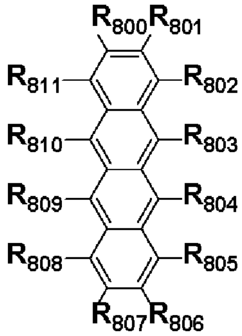

[1-9]

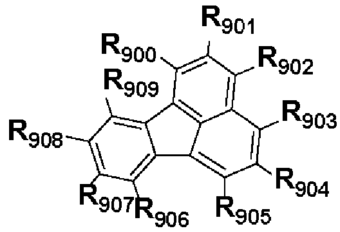

[1-10]

wherein $R_1$ to $R_{909}$ are each independently selected from the group consisting of a hydrogen atom, a deuterium atom, a halogen atom, a substituted or unsubstituted alkyl group, a substituted or unsubstituted alkoxy group, a substituted or unsubstituted aryl group and a substituted or unsubstituted silyl group.

$R_1$ to $R_{909}$ can be a hydrogen atom, a deuterium atom, a substituted or unsubstituted alkyl group, or a substituted or unsubstituted aryl group.

In an organic light-emitting element according to the present disclosure, the second organic compound may be represented by the general formula [1-1], [1-2], [1-3], [1-4], [1-5], [1-6], [1-7], [1-8], [1-9], or [1-10]. Among these, the second organic compound can be represented by any one of the general formulae [1-1] to [1-5]. The same applies to the second organic compound in another aspect of an organic light-emitting element according to the present disclosure.

An organic light-emitting element according to the present disclosure has the following feature.

(1-1) When the second organic compound is an organic compound represented by any one of the general formulae [1-1] to [1-10], the second organic compound can suppress the diffusion of an alkali metal atom and an alkaline-earth metal atom into the light-emitting layer.

This feature will be described below.

(1-1) When the second organic compound is an organic compound represented by any one of the general formulae [1-1] to [1-10], the second organic compound can suppress the diffusion of an alkali metal atom and an alkaline-earth metal atom into the light-emitting layer.

In an organic light-emitting element according to the present disclosure, the second organic compound is an organic compound represented by any one of the general formulae [1-1] to [1-10]. An organic compound represented by any one of the general formulae [1-1] to [1-10] can suppress the diffusion of an alkali metal atom and an alkaline-earth metal atom into the light-emitting layer, and an organic light-emitting element according to the present disclosure therefore has high durability.

An element with electron injection properties may be an alkali metal atom or an alkaline-earth metal atom. When a layer containing these atoms and a compound with a nitrogen-containing aromatic compound is formed for the purpose of improving the electron injection properties, the organic light-emitting element may have lower durability. This is because a nitrogen-containing aromatic compound has good electron transport properties, and it is difficult to suppress the diffusion of an alkali metal atom or an alkaline-earth metal atom into the light-emitting layer. Consequently, an alkali metal atom or an alkaline-earth metal atom may act as a quenching component (quencher) of a light-emitting material and rapidly decrease the luminance.

In contrast, an organic compound represented by any one of the general formulae [1-1] to [1-10] has poorer electron transport properties than nitrogen-containing aromatic compounds. This can suppress the diffusion of an alkali metal atom or an alkaline-earth metal atom into the light-emitting layer. Consequently, an organic light-emitting element according to the present disclosure can suppress the diffusion of an alkali metal atom or an alkaline-earth metal atom into the light-emitting layer and has high durability.

Even when the second organic compound is a hydrocarbon compound with a fused polycyclic hydrocarbon skeleton, the same effects can be obtained. This is because a hydrocarbon compound with a fused polycyclic hydrocarbon skeleton has poorer electron transport properties than nitrogen-containing aromatic compounds and can suppress the diffusion of an alkali metal atom or an alkaline-earth metal atom into the light-emitting layer. Thus, even an organic light-emitting element according to another aspect of the present disclosure can have high durability.

Table 1 shows a comparison of the voltage and durability of an organic light-emitting element in which the alkyl metal atom is a lithium atom, the first organic compound is BPhen, and the second organic compound is an exemplary compound A7 or a comparative compound 1-a. BPhen, the exemplary compound A7, and the comparative compound 1-a are as follows:

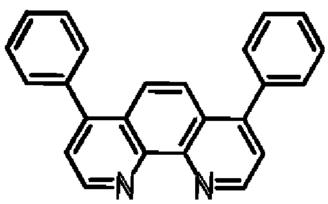

BPhen

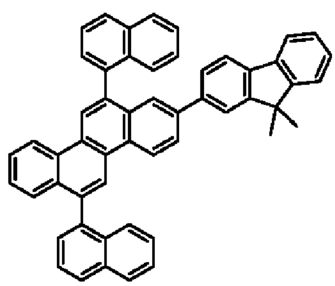

Exemplary compound A7

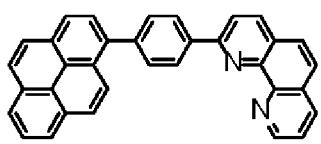

Comparative compound 1-a

Table 1

| | First organic compound | | Second organic compound | | | | Voltage | Durability |
|---|---|---|---|---|---|---|---|---|
| | Molecular structure | LUMO/eV HOMO/eV | Organic compound B | LUMO/eV HOMO/eV | ΔHOMO | ΔLUMO | Ref ratio | Ref ratio |
| Example 1 | 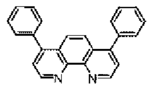 | -3.1 -6.6 | 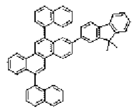 | -2.9 -6.1 | 0.5 | 0.2 | 1.0 | 1.3 |
| Comparative example 1 | 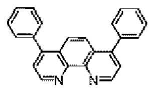 | -3.1 -6.6 | 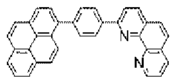 | -2.9 -6.1 | 0.5 | 0.2 | 1.0 | 1.0 |

Table 1 shows that the organic light-emitting element according to the present embodiment has higher durability, although Example 1, which is the organic light-emitting element according to the present embodiment, and Comparative Example 1, which is the organic light-emitting element described in PTL1, have the same relationship between ΔHOMO and ΔLUMO. This is because, as described above, the second organic compound is an organic compound represented by any one of the general formulae [1-1] to [1-10] and suppresses the diffusion of a lithium atom into the light-emitting layer.
In the present disclosure 1, the second organic compound is also a hydrocarbon compound with a fused polycyclic hydrocarbon skeleton. This can suppress the diffusion of a lithium atom into the light-emitting layer and results in higher durability than Comparative Example 1.
ΔHOMO and ΔLUMO are as follows:

$$\Delta HOMO = HOMO\ (H2) - HOMO\ (H1)$$

$$\Delta LUMO = |LUMO\ (H2) - LUMO\ (H1)|$$

The voltage and durability of Example 1 are values relative to the voltage and durability of Comparative Example 1, which are assumed to be 1.0.
An organic light-emitting element according to the present disclosure can further have the following features. Only one of the features may be satisfied, or a plurality of the features may be satisfied at the same time.

(1-2) When the second organic compound is an organic compound represented by any one of the general formulae [1-1] to [1-10], the n-type charge generation layer has improved hole-trapping properties.
(1-3) When the second organic compound is an organic compound represented by the general formula [1-1], the organic light-emitting element has further improved durability.
(1-4) When the second organic compound is an organic compound represented by any one of the general formulae [1-2] to [1-10], the organic light-emitting element has a further reduced voltage.
(1-5) When the relationship of the formula [2] is satisfied, the organic light-emitting element has a further reduced voltage.

$$[2]\ |LUMO\ (H2) - LUMO\ (H1)| \leq 0.1\ eV$$

These features will be described below.
(1-2) When the second organic compound is an organic compound represented by any one of the general formulae [1-1] to [1-10], the n-type charge generation layer has improved hole-trapping properties.
As a result of intensive studies, the present inventors have found that mixing the n-type charge generation layer with an alkali metal atom or a derivative thereof, the first organic compound, and the second organic compound improves the durability of an organic light-emitting element.
In an organic light-emitting element according to the present disclosure, the second organic compound is an organic compound represented by any one of the general formulae [1-1] to [1-10]. Thus, the second organic compound tends to have a high HOMO energy level (close to the vacuum level). Consequently, an organic light-emitting element according to the present disclosure has high durability.
An organic compound represented by any one of the general formulae [1-1] to [1-10] tends to have a higher HOMO energy level (closer to the vacuum level) than nitrogen-containing aromatic compounds. Nitrogen-containing aromatic compounds tend to have better electron transport properties than an organic compound represented by any one of the general formulae [1-1] to [1-10]. The present inventors have found that the n-type charge generation layer exhibits both electron transport properties and hole-trapping properties by mixing a nitrogen-containing aromatic compound and an organic compound represented by any one of the general formulae [1-1] to [1-10]. The second organic compound can trap a hole and reduce the degradation of the first organic compound due to the hole. This can reduce the degradation of the n-type charge generation layer. This can reduce the decrease in the luminance of the organic light-emitting element. The n-type charge generation layer with a hole-trapping structure inhibits a hole from reaching the p-type charge generation layer and can reduce the degradation of the organic light-emitting element. Thus, an organic light-emitting element according to the present disclosure has high durability.
Even when the second organic compound is a hydrocarbon compound with a fused polycyclic hydrocarbon skeleton, the same effects can be obtained. This is because hydrocarbon compounds tend to have a higher HOMO energy level (closer to the vacuum level) than nitrogen-containing aromatic compounds, and the second organic compound can therefore trap a hole. Nitrogen-containing aromatic compounds tend to have better electron transport properties than hydrocarbon compounds with a fused polycyclic hydrocarbon skeleton. Consequently, the n-type charge generation layer

exhibits both electron transport properties and hole-trapping properties, and a hole is less likely to reach the p-type charge generation layer. This can reduce the degradation of the organic light-emitting element. Thus, even an organic light-emitting element according to another aspect of the present disclosure can have high durability. (1-3) When the second organic compound is an organic compound represented by the general formula [1-1], the organic light-emitting element has further improved durability.

As a result of further intensive studies, the present inventors have found that when the second organic compound is an organic compound represented by the general formula [1-1], the organic light-emitting element has further improved durability.

In the skeleton represented by the general formula [1-1], $R_1$ and $R_2$ are located in a direction perpendicular to the in-plane direction of the fluorene skeleton. Thus, the skeleton represented by the general formula [1-1] is bulkier than the skeletons represented by the general formulae [1-2] to [1-10]. This can suppress intermolecular stacking, and an organic compound represented by the general formula [1-1] therefore has high sublimability. In other words, an organic compound represented by the general formula [1-1] is an organic compound with high thermal stability. Consequently, the organic light-emitting element according to the present embodiment has higher durability.

Table 2 shows a comparison of the voltage and durability of an organic light-emitting element in which the alkyl metal atom is a lithium atom, the first organic compound is BPhen, and the second organic compound is an organic compound represented by the general formula [1-1] or the comparative compound 1-a. ΔHOMO, ΔLUMO, voltage, and durability are as described above.

Table 2

| | First organic compound | | Second organic compound | | | | Voltage | Durability |
|---|---|---|---|---|---|---|---|---|
| | Molecular structure | LUMO/eV HOMO/eV | Molecular structure | LUMO/eV HOMO/eV | ΔHOMO | ΔLUMO | Ref ratio | Ref ratio |
| Example 2 | 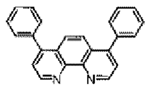 | -3.1<br>-6.6 | 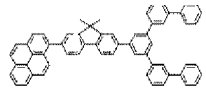 | -3.1<br>-6.1 | 0.5 | 0.0 | 0.8 | 1.5 |
| Example 3 | 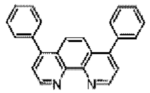 | -3.1<br>-6.6 | 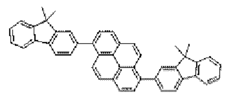 | -3.0<br>-5.9 | 0.7 | 0.1 | 0.9 | 1.5 |
| Example 4 | 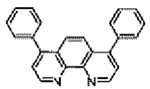 | -3.1<br>-6.6 | 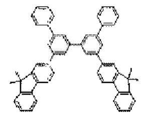 | -3.0<br>-6.5 | 0.1 | 0.1 | 0.9 | 1.3 |
| Comparative example 1 | 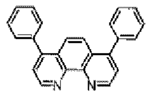 | -3.1<br>-6.6 | 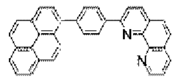 | -2.9<br>-6.1 | 0.5 | 0.2 | 1.0 | 1.0 |

In Table 2, all of Examples 2 to 4, which are the organic light-emitting elements according to the present embodiment, had higher durability. This is because, as described above, the second organic compound is an organic compound represented by the general formula [1-1] and therefore has high thermal stability.

It was also found that Examples 2 and 3 had higher durability than Example 4. This is probably because ΔHOMO of Examples 2 and 3 is higher than ΔHOMO of Example 4, and the second organic compound can more easily trap a hole. The second organic compound is an organic compound represented by the general formula [1-1] and is stable against a hole. This reduces the degradation of the n-type charge generation layer and further improves the durability of the organic light-emitting element.

In Table 2, the first organic compound and the second organic compound can satisfy the relationship of the formula [1], the relationship of the formula [1-1], or the relationship of the formula [1-2]:

$$[1]\ \mathrm{HOMO\ (H2) - HOMO\ (H1)} > 0.0\ \mathrm{eV}$$

$$[1\text{-}1]\ \mathrm{HOMO\ (H2) - HOMO\ (H1)} \geq 0.1\ \mathrm{eV}$$

$$[1\text{-}2]\ \mathrm{HOMO\ (H2) - HOMO\ (H1)} \geq 0.5\ \mathrm{eV}$$

(1-4) When the second organic compound is an organic compound represented by any one of the general formulae [1-2] to [1-10], the organic light-emitting element has a further reduced voltage.

As a result of further intensive studies, the present inventors have found that when the second organic compound is an organic compound represented by any one of the general formulae [1-2] to [1-10], the organic light-emitting element has a further reduced voltage.

An organic compound represented by any one of the general formulae [1-2] to [1-10] has a structure with particularly high planarity, is likely to cause intermolecular stacking, and tends to have high charge mobility. Consequently, when the second organic compound is an organic compound represented by any one of the general formulae [1-2] to [1-10], the organic light-emitting element has a further reduced voltage.

In this case, when the second organic compound has one or more skeletons in which at least three 5-membered rings or 6-membered rings are fused in the molecule, separation due to bond cleavage can be suppressed. Consequently, the organic light-emitting element according to the present embodiment also has higher durability.

Table 3 shows a comparison of the voltage and durability of an organic light-emitting element in which the alkyl metal atom is a lithium atom, the first organic compound is BPhen, and the second organic compound is an organic compound represented by any one of the general formulae [1-2] to [1-10] or the comparative compound 1-a. ΔHOMO, ΔLUMO, voltage, and durability are as described above.

Table 3

| | First organic compound | | Second organic compound | | | | Voltage | Durability |
|---|---|---|---|---|---|---|---|---|
| | Molecular structure | LUMO/eV HOMO/eV | Molecular structure | LUMO/eV HOMO/eV | ΔHOMO | ΔLUMO | Ref ratio | Ref ratio |
| Example 5 | 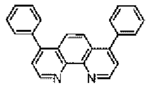 | -3.1 -6.6 | 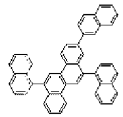 | -2.9 -6.1 | 0.5 | 0.2 | 0.9 | 1.4 |
| Example 6 | 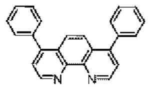 | -3.1 -6.6 | 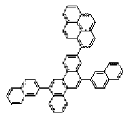 | -3.0 -6.0 | 0.6 | 0.1 | 0.8 | 1.4 |
| Example 7 | 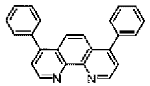 | -3.1 -6.6 | 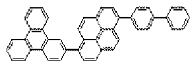 | -3.1 -6.0 | 0.6 | 0.0 | 0.7 | 1.4 |
| Example 8 | 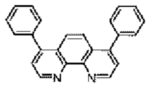 | -3.1 -6.6 | 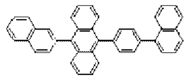 | -3.1 -6.0 | 0.6 | 0.0 | 0.8 | 1.3 |
| Comparative example 1 | 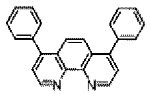 | -3.1 -6.6 | 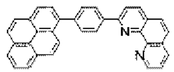 | -2.9 -6.1 | 0.5 | 0.2 | 1.0 | 1.0 |

In Table 3, all of Examples 5 to 8, which are the organic light-emitting elements according to the present embodiment, had a lower voltage. Example 6 in Table 3 had the same ΔLUMO as Example 3 in Table 2 but had a lower voltage. This is because, as described above, the second organic compound is an organic compound represented by any one of the general formulae [1-2] to [1-10] and therefore promotes intermolecular stacking.

Likewise, in the organic light-emitting element according to the present embodiment, the first organic compound and the second organic compound can satisfy the relationship of the formula [1], the relationship of the formula [1-1], or the relationship of the formula [1-2]:

$$[1]\ \mathrm{HOMO\ (H2) - HOMO\ (H1)} > 0.0\ \mathrm{eV}$$

$$[1\text{-}1]\ \mathrm{HOMO\ (H2) - HOMO\ (H1)} \geq 0.1\ \mathrm{eV}$$

$$[1\text{-}2]\ \mathrm{HOMO\ (H2) - HOMO\ (H1)} \geq 0.5\ \mathrm{eV}$$

(1-5) When the relationship of the formula [2] is satisfied, the organic light-emitting element has a further reduced voltage.

$$[2]\ |\mathrm{LUMO\ (H2) - LUMO\ (H1)}| \leq 0.1\ \mathrm{eV}$$

The organic light-emitting element according to the present embodiment satisfying the relationship of the formula [2] can improve electron mobility in the n-type charge generation layer. This further reduces the voltage of the organic light-emitting element according to the present embodiment.

As described above, the n-type charge generation layer plays a role of injecting an electron into the light-emitting layer. Thus, when the first organic compound and the second organic compound have a large difference in LUMO energy level, the electron mobility in the n-type charge generation layer may be decreased. This may increase the voltage of the organic light-emitting element.

Thus, in the organic light-emitting element according to the present embodiment, the first organic compound and the second organic compound can have a small difference in LUMO energy level. In other words, the first organic compound and the second organic compound can satisfy the relationship of the formula [2]. When the first organic compound and the second organic compound satisfy the relationship of the formula [2], the n-type charge generation layer is less likely to trap an electron, and the electron mobility in the n-type charge generation layer is therefore improved. This further reduces the voltage of the organic light-emitting element according to the present embodiment.

Specific examples of an organic compound represented by the general formula [1-1] are described below. However, the present disclosure is not limited to these examples.

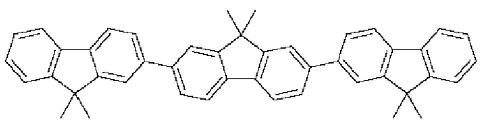

A1

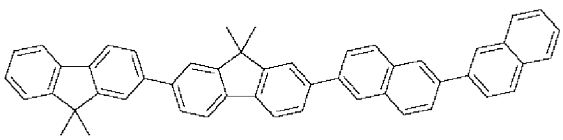

A2

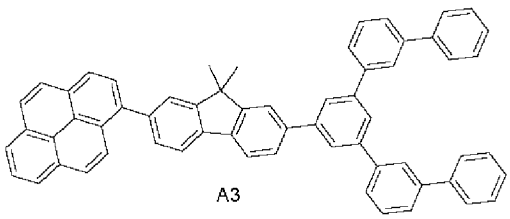

A3

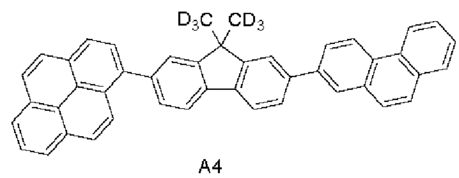

A4

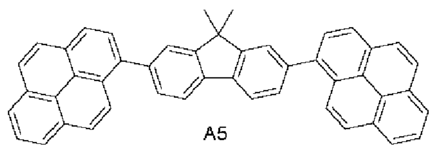

A5

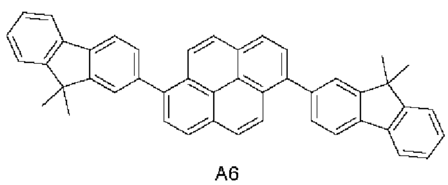

A6

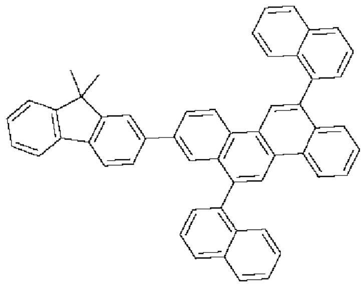

A7

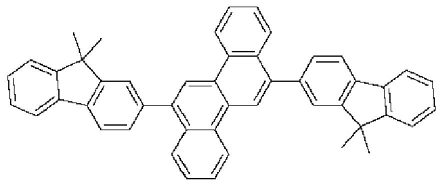

A8

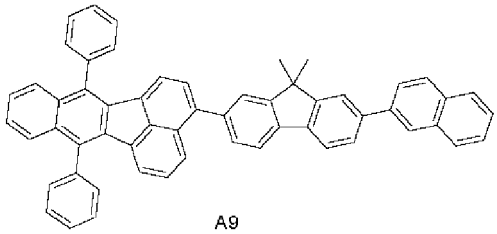

A9

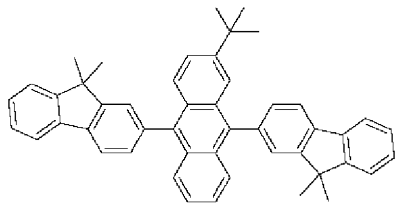

A10

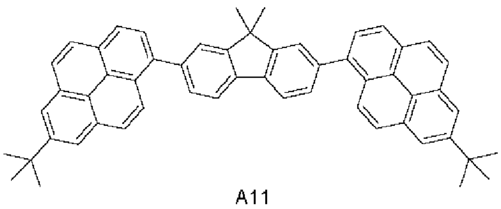

A11

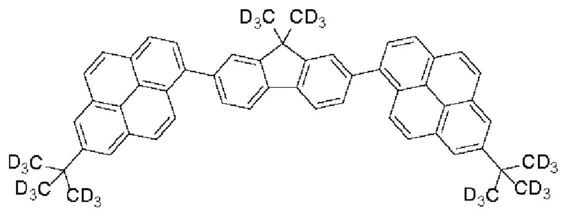

A12

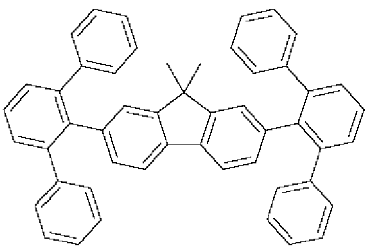

B1

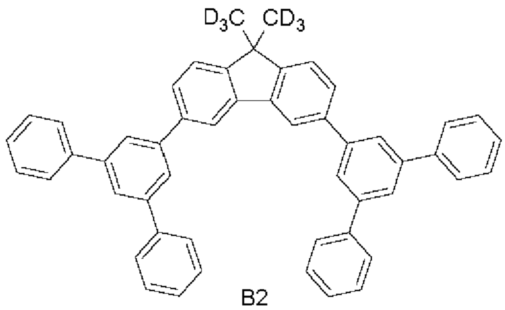

B2

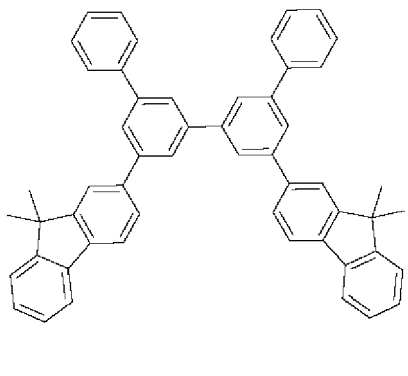

B3

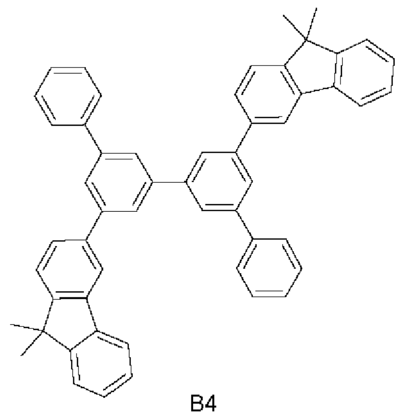

B4

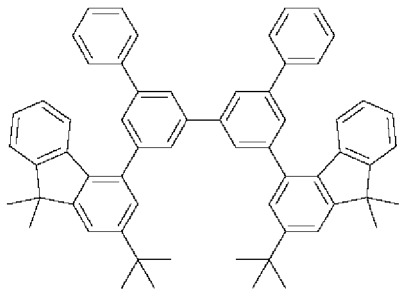

B5

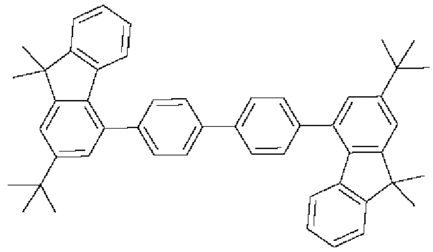

B6

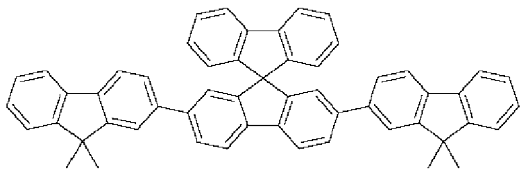

C1

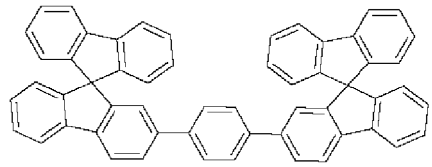

C2

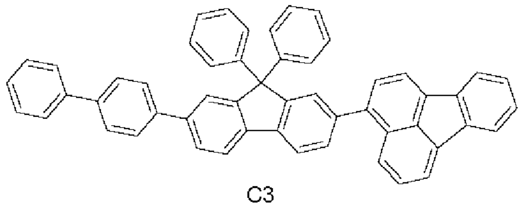

C3

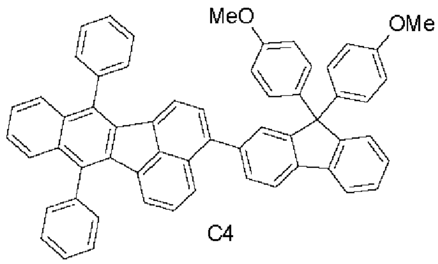

C4

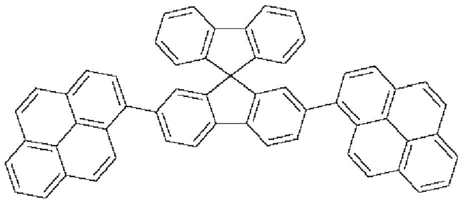

C5

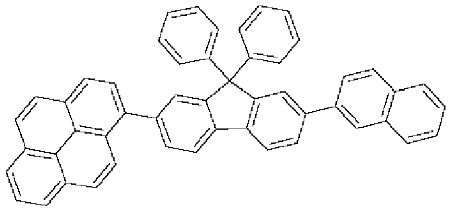

C6

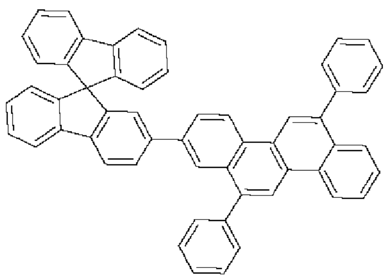

C7

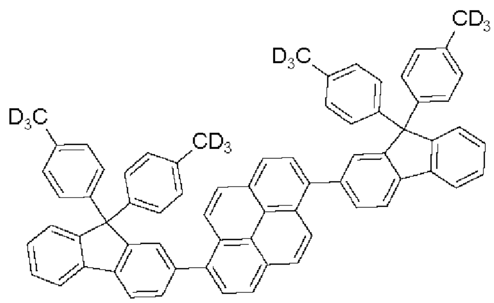

C8

These exemplary compounds are a group of compounds with a fluoranthene skeleton. As described above, compounds with a fluoranthene skeleton are bulky compounds and can suppress intermolecular stacking. Thus, the exemplary compounds belonging to Group A to Group C are a group of compounds with particularly high sublimability.

Among the exemplary compounds, the exemplary compounds belonging to Group A are compounds represented by the general formula [1-1] in which $R_1$ and $R_2$ are alkyl groups and at least one of $R_3$ to $R_{10}$ is substituted with a

fused polycyclic group with three or more rings. Thus, the exemplary compounds belonging to Group A have a high HOMO energy level (close to the vacuum level) and also have high electron mobility. They are also a group of compounds that are difficult to crystallize because $R_1$ and $R_2$ are alkyl groups.

Among the exemplary compounds, the exemplary compounds belonging to Group B are compounds in which $R_1$ and $R_2$ are alkyl groups and at least one of $R_3$ to $R_{10}$ is a phenylene group. Thus, the exemplary compounds belonging to the group B are a group of compounds that are difficult to crystallize.

Among the exemplary compounds, the exemplary compounds belonging to Group C are compounds represented by the general formula [1-1] in which $R_1$ and $R_2$ are aryl groups and at least one of $R_3$ to $R_{10}$ is substituted with a fused polycyclic group with three or more rings. The exemplary compounds belonging to Group C have a particularly high glass transition temperature and are therefore a group of compounds with high thermal stability.

Specific examples of an organic compound represented by the general formula [1-2] are described below. However, the present disclosure is not limited to these examples.

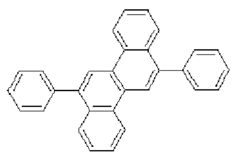

**AA1**

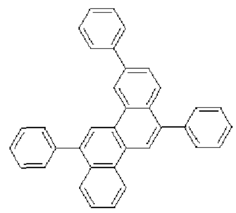

**AA2**

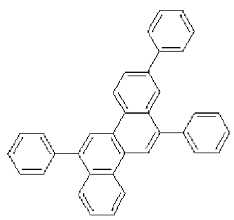

**AA3**

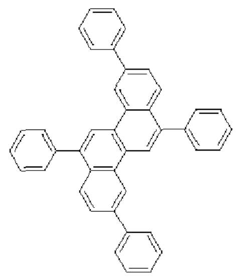

**AA4**

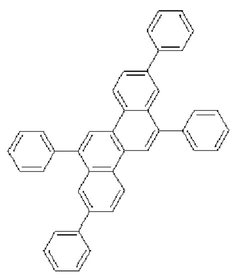

**AA5**

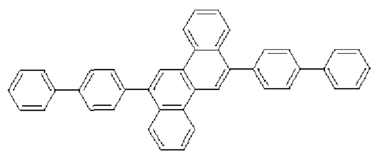

**AA6**

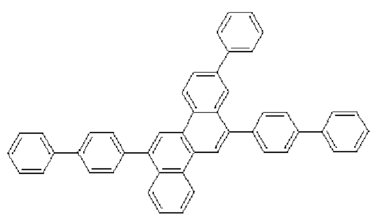

**AA7**

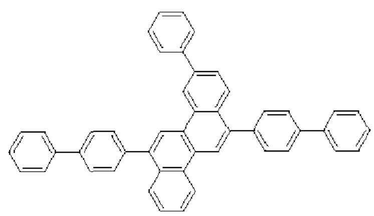

**AA8**

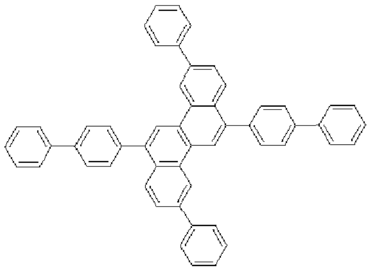

AA9

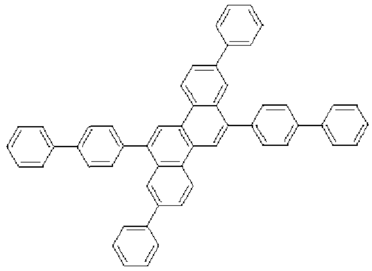

AA10

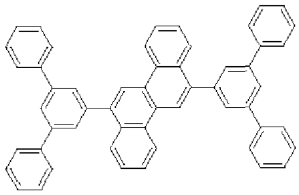

AA11

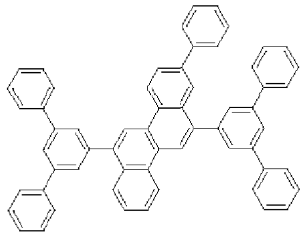

AA12

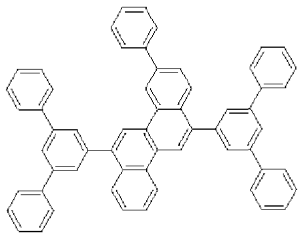

AA13

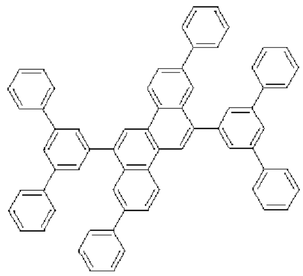

AA14

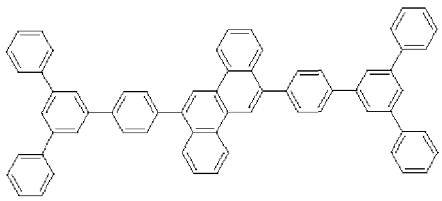

AA15

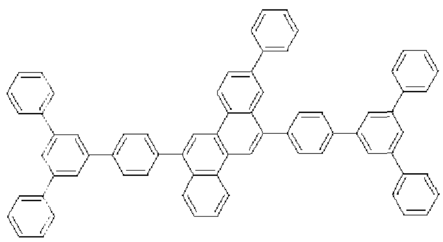

AA16

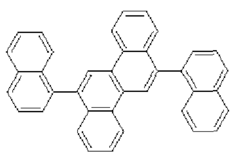

AA17

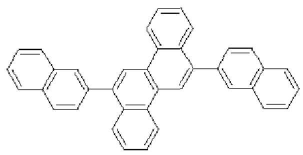

AA18

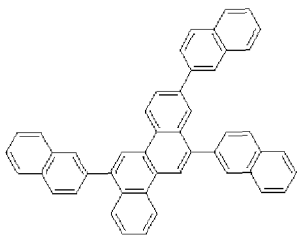

AA19

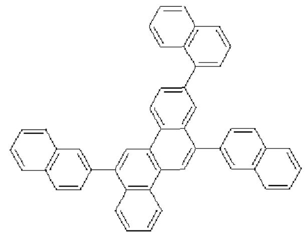

AA20

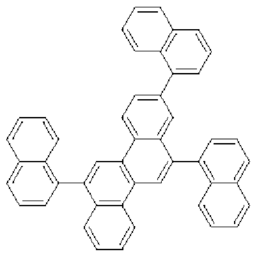

AA21

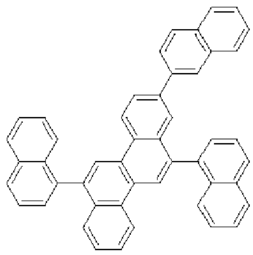

AA22

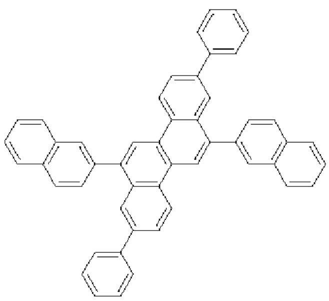

AA23

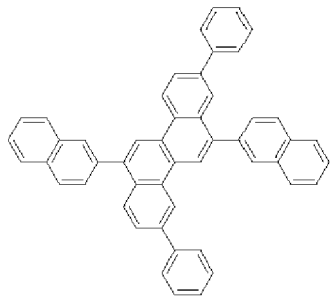

AA24

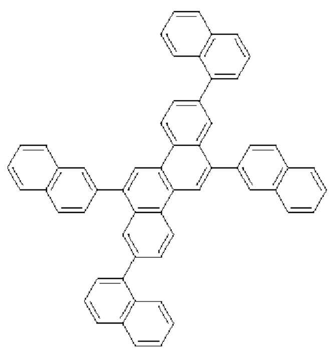

AA25

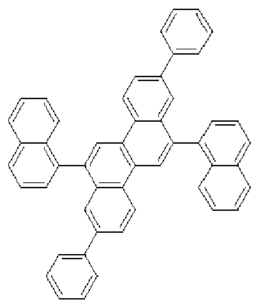

AA26

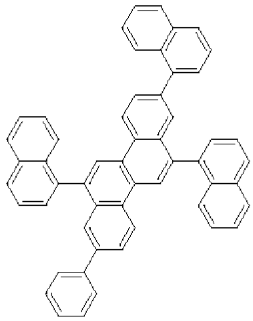

AA27

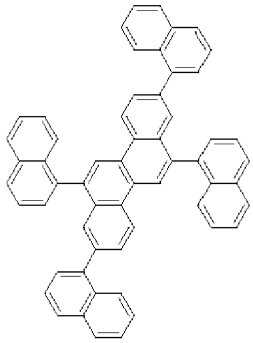

AA28

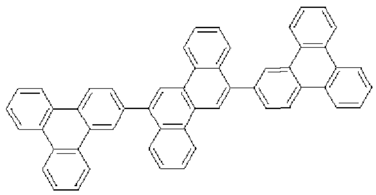

AA29

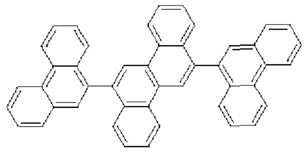

AA30

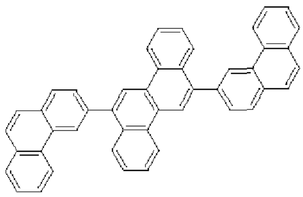

AA31

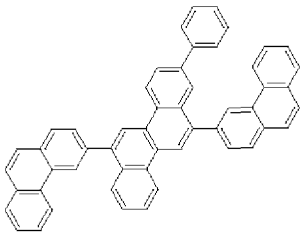

AA32

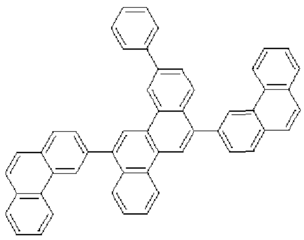

AA33

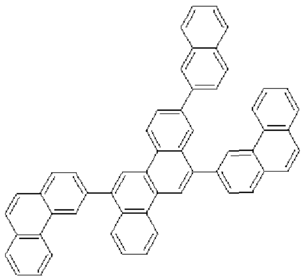

AA34

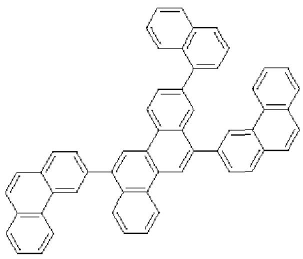

AA35

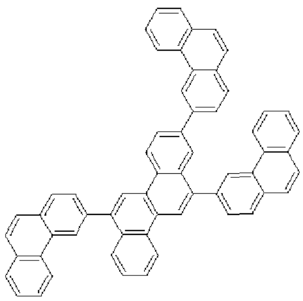

AA36

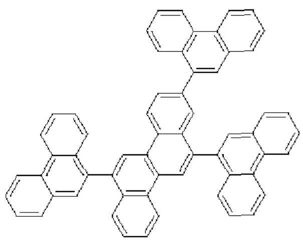

AA37

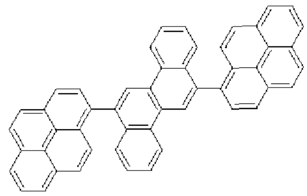

AA38

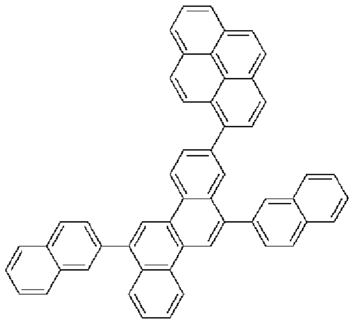

AA39

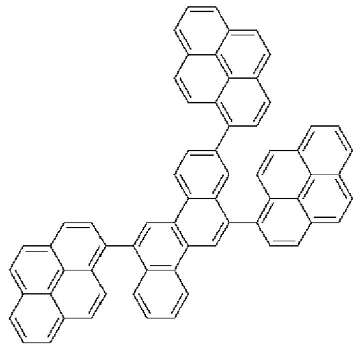

AA40

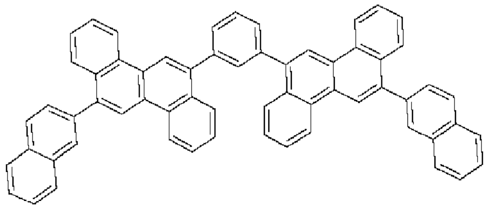

AA41

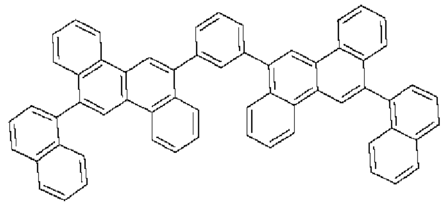

AA42

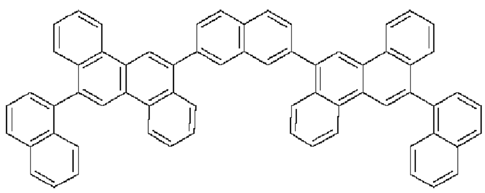

AA43

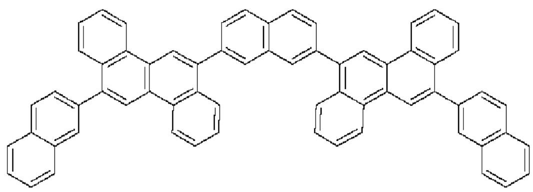

AA44

Among these exemplary compounds, the exemplary compounds belonging to Group AA are fused polycyclic aromatic hydrocarbon compounds with a chrysene skeleton in the molecular structure. Thus, the exemplary compounds belonging to Group AA are a group of compounds with a wide band gap and good charge transport properties.

When the chrysene skeleton has a substituent, this increases the degree of rotational freedom of a bond and provides a bulky compound. This can suppress intermolecular stacking, and among the compounds belonging to Group AA a compound with a substituent is a compound with high sublimability.

Specific examples of an organic compound represented by the general formula [1-3] are described below. However, the present disclosure is not limited to these examples.

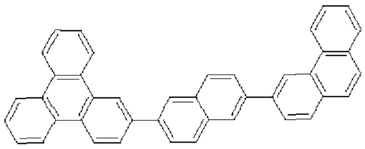

BB1

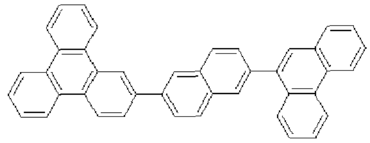

BB2

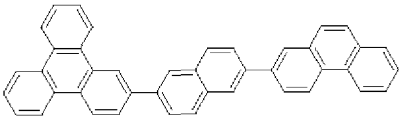

BB3

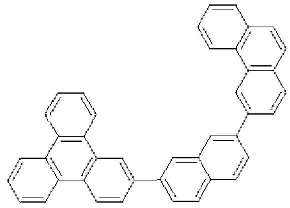

BB4

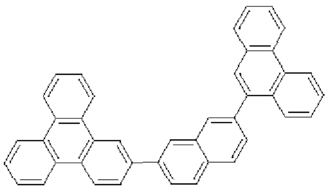

BB5

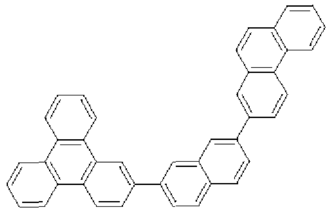

BB6

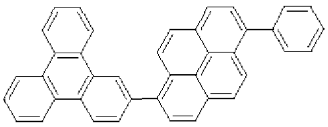

BB7

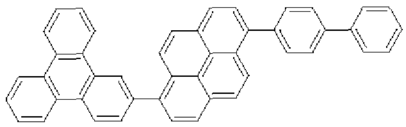

BB8

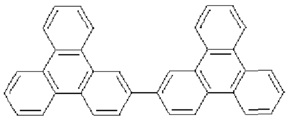

BB9

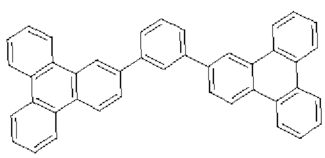

BB10

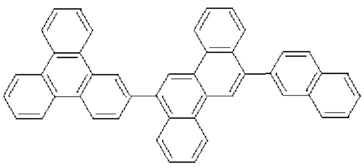

BB11

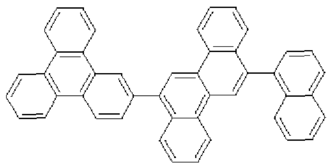

BB12

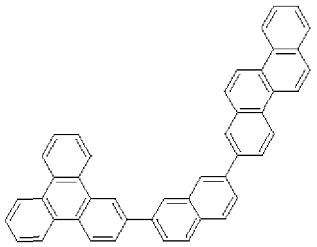

BB13

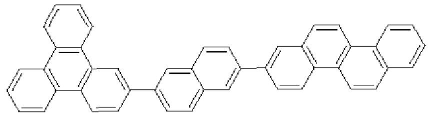

BB14

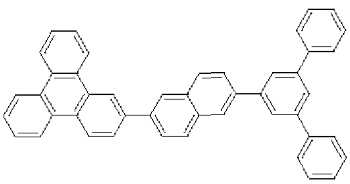

BB15

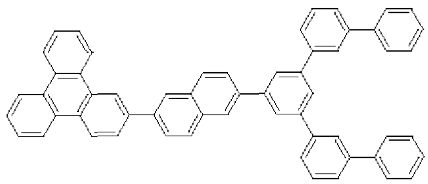

BB16

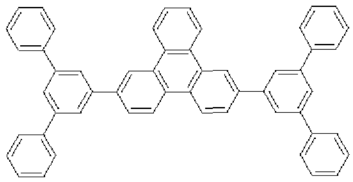

BB17

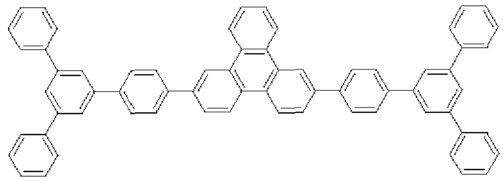

BB18

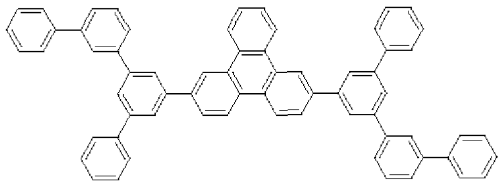

BB19

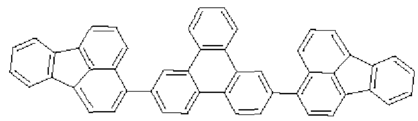

BB20

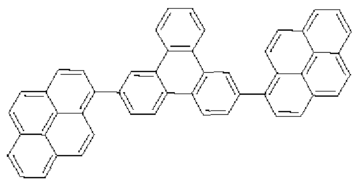

BB21

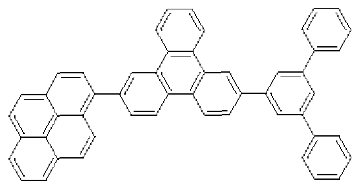

BB22

Among these exemplary compounds, the exemplary compounds belonging to Group BB are fused polycyclic aromatic hydrocarbon compounds with a triphenylene skeleton in the molecular structure. Due to the triphenylene skeleton in the molecular structure, the exemplary compounds belonging to Group BB are compounds with high planarity and easily causing intermolecular stacking. Consequently, the exemplary compounds belonging to Group BB are organic compounds with high charge mobility, and the organic light-emitting element according to the present embodiment has a lower voltage.

Specific examples of an organic compound represented by the general formula [1-4] are described below. However, the present disclosure is not limited to these examples.

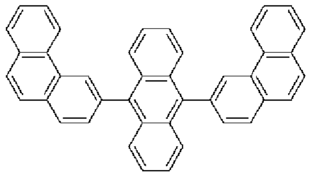

**CC1**

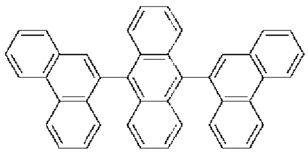

**CC2**

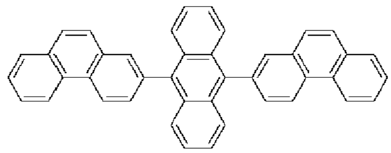

**CC3**

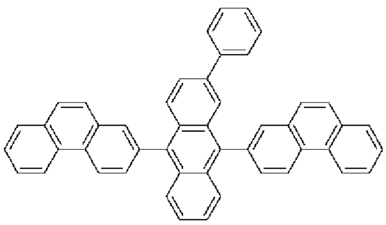

**CC4**

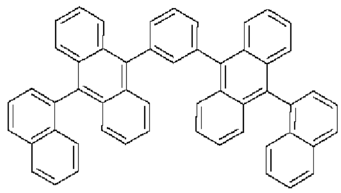

**CC5**

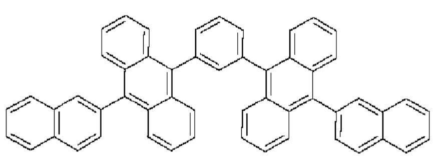

**CC6**

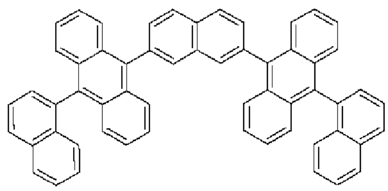

**CC7**

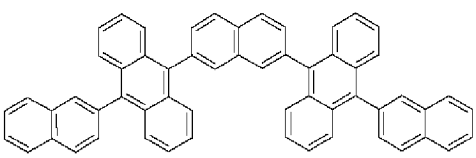

**CC8**

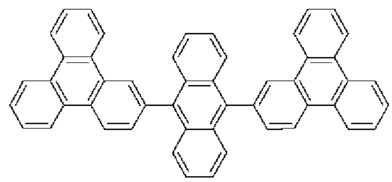

**CC9**

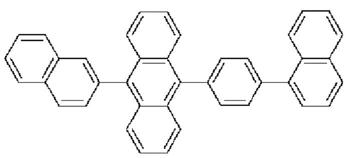

**CC10**

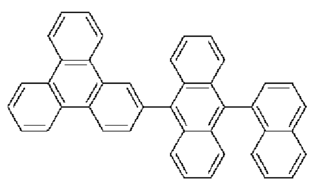

**CC11**

Among these exemplary compounds, the exemplary compounds belonging to Group CC are fused polycyclic aromatic hydrocarbon compounds with an anthracene skeleton in the molecular structure. Due to the anthracene skeleton in the molecular structure, the exemplary compounds belonging to Group CC are a group of compounds with a narrow band gap and a low lowest excited triplet energy. Furthermore, the exemplary compounds belonging to Group CC are a group of compounds with a high HOMO energy level (close to the vacuum level) and are therefore organic compounds with good hole-trapping properties.

Specific examples of an organic compound represented by the general formula [1-5] are described below.

However, the present disclosure is not limited to these examples.

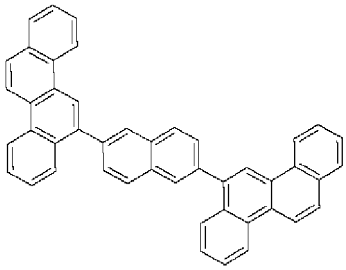

DD1

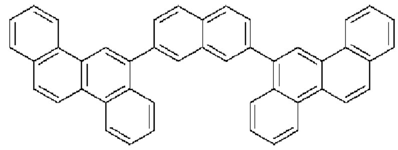

DD2

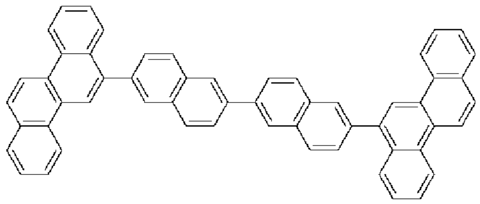

DD3

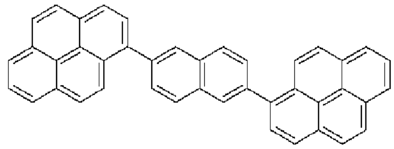

DD4

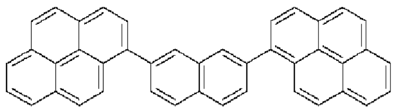

DD5

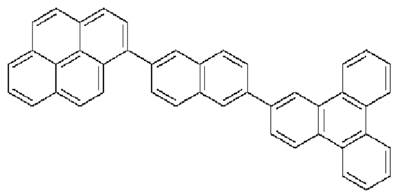

DD6

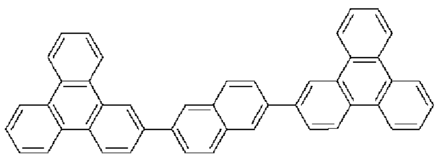

DD7

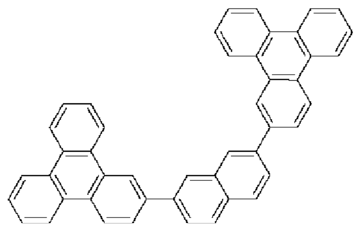

DD8

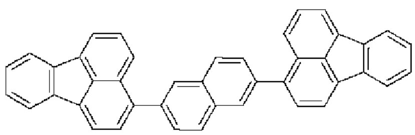

DD9

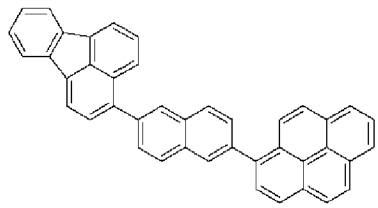

DD10

Among these exemplary compounds, the exemplary compounds belonging to Group DD are fused polycyclic aromatic hydrocarbon compounds with a divalent naphthalene skeleton in the molecular structure. The divalent naphthalene skeleton has a fused polycyclic aromatic hydrocarbon substituent with high planarity, and the organic compounds therefore have high charge mobility. Consequently, the organic light-emitting element according to the present

embodiment has a lower voltage.

Furthermore, introducing a different substituent into the naphthalene skeleton provides an organic compound with asymmetry and planarity. Such an organic compound has a high glass transition temperature and high charge mobility. Thus, the organic light-emitting element according to the present embodiment has high durability and a lower voltage.

Specific examples of an organic compound represented by the general formula [1-6] are described below. However, the present disclosure is not limited to these examples.

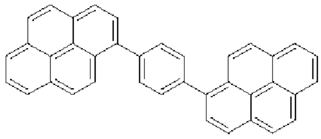

**EE1**

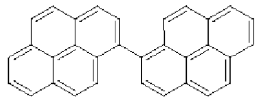

**EE2**

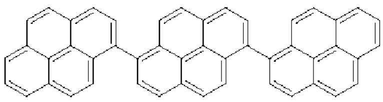

**EE3**

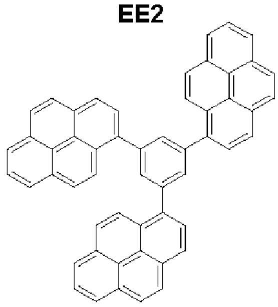

**EE4**

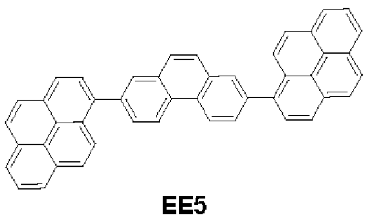

**EE5**

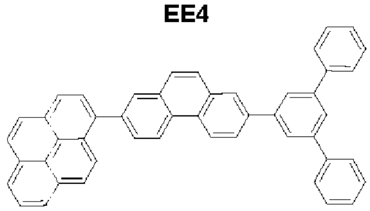

**EE6**

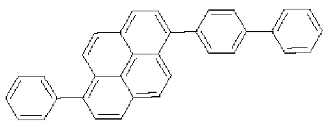

**EE7**

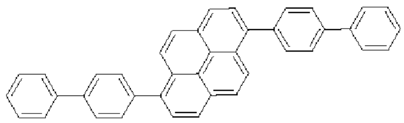

**EE8**

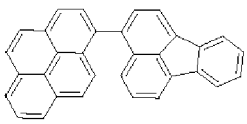

**EE9**

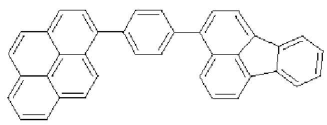

**EE10**

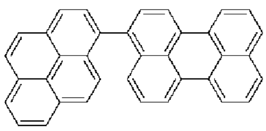

**EE11**

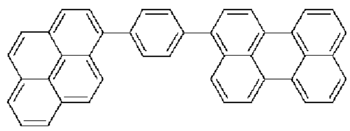

**EE12**

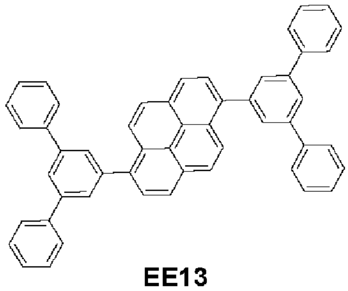

EE13

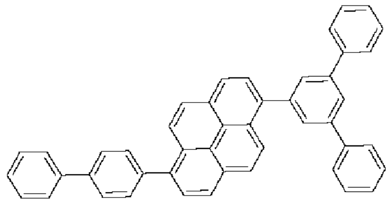

EE14

Among these exemplary compounds, the exemplary compounds belonging to Group EE are fused polycyclic aromatic hydrocarbon compounds with a pyrene skeleton in the molecular structure. Thus, the exemplary compounds belonging to Group EE are a group of compounds with a wide band gap and good charge transport properties.

When the pyrene skeleton has a substituent, this increases the degree of rotational freedom of a bond and provides a bulky compound. This can suppress intermolecular stacking, and among the compounds belonging to Group EE a compound with a substituent is a compound with high sublimability.

Specific examples of an organic compound represented by the general formula [1-7] are described below. However, the present disclosure is not limited to these examples.

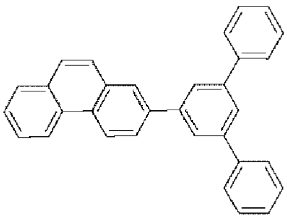

FF1

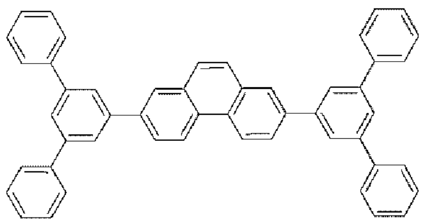

FF2

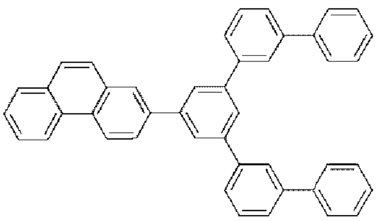

FF3

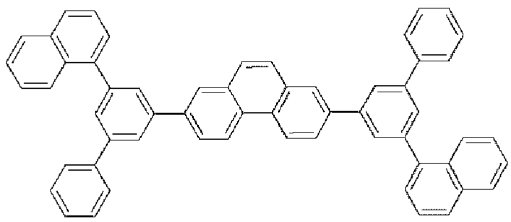

FF4

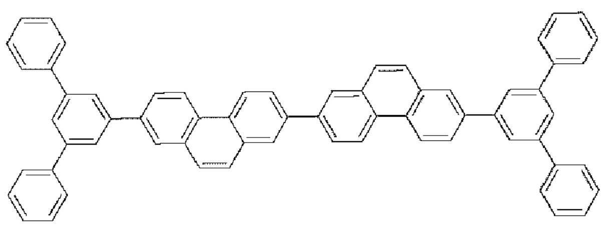

FF5

Among these exemplary compounds, the exemplary compounds belonging to Group FF are fused polycyclic aromatic hydrocarbon compounds with a phenanthrene skeleton in the molecular structure. Thus, the exemplary compounds belonging to Group FF are a group of compounds with a wide band gap and good charge transport properties.

When the phenanthrene skeleton has a substituent, this increases the degree of rotational freedom of a bond and provides a bulky compound. This can suppress intermolecular stacking, and among the compounds belonging to Group

FF a compound with a substituent is a compound with high sublimability.

Specific examples of an organic compound represented by the general formula [1-8] are described below. However, the present disclosure is not limited to these examples.

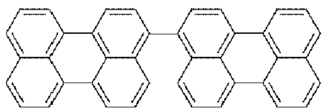

GG1

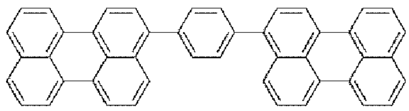

GG2

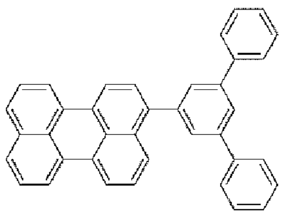

GG3

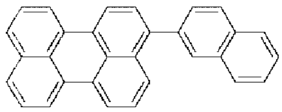

GG4

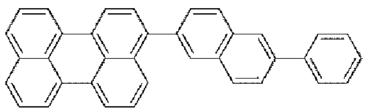

GG5

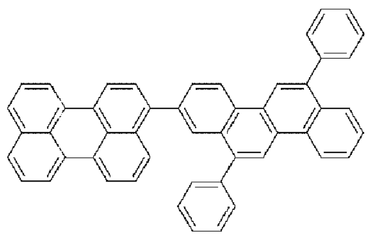

GG6

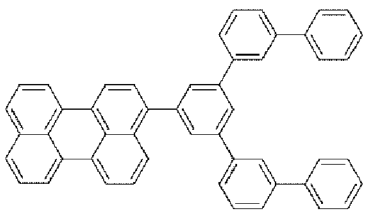

GG7

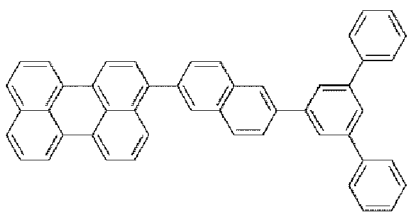

GG8

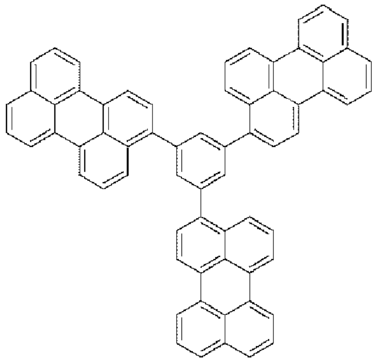

GG9

Among these exemplary compounds, the exemplary compounds belonging to Group GG are fused polycyclic aromatic hydrocarbon compounds with a perylene skeleton in the molecular structure. Thus, the exemplary compounds belonging to Group GG are a group of compounds with a wide band gap and good charge transport properties.

When the perylene skeleton has a substituent, this increases the degree of rotational freedom of a bond and provides a bulky compound. This can suppress intermolecular stacking, and among the compounds belonging to Group GG a compound with a substituent is a compound with high sublimability.

Specific examples of an organic compound represented by the general formula [1-9] are described below. However, the present disclosure is not limited to these examples.

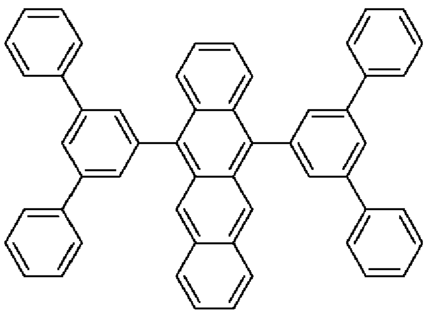

HH1

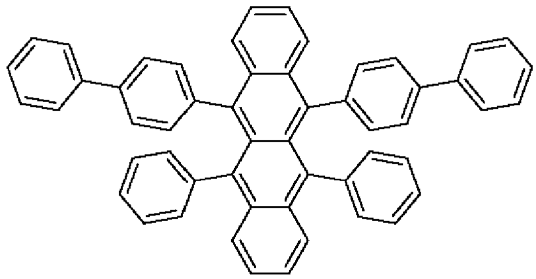

HH2

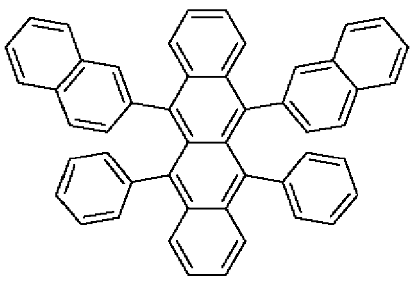

HH3

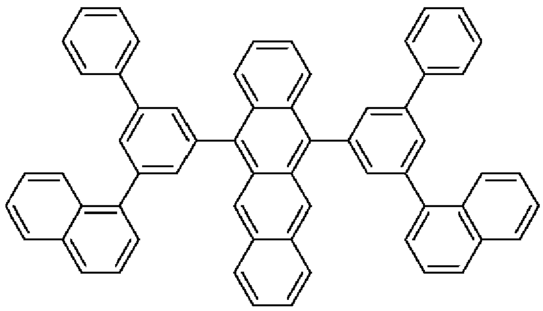

HH4

Among these exemplary compounds, the exemplary compounds belonging to Group HH are fused polycyclic aromatic hydrocarbon compounds with a tetracene skeleton in the molecular structure. Thus, the exemplary compounds belonging to Group HH are a group of compounds with a wide band gap and good charge transport properties.

When the tetracene skeleton has a substituent, this increases the degree of rotational freedom of a bond and provides a bulky compound. This can suppress intermolecular stacking, and among the compounds belonging to Group

HH a compound with a substituent is a compound with high sublimability.

Specific examples of an organic compound represented by the general formula [1-10] are described below. However, the present disclosure is not limited to these examples.

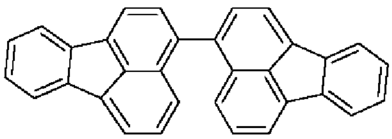

JJ1

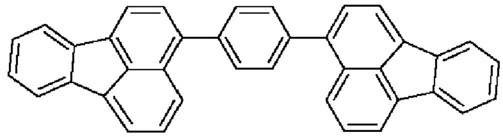

JJ2

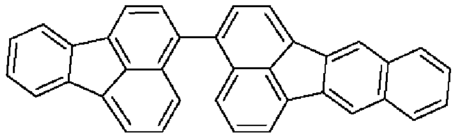

JJ3

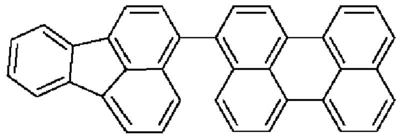

JJ4

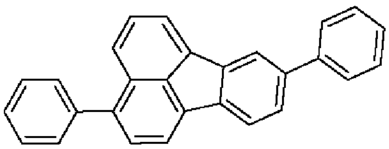

JJ5

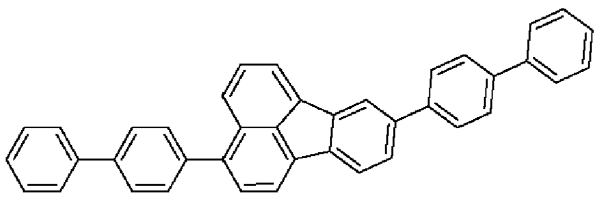

JJ6

Among these exemplary compounds, the exemplary compounds belonging to Group JJ are fused polycyclic aromatic hydrocarbon compounds with a fluoranthene skeleton in the molecular structure. Thus, the exemplary compounds belonging to Group JJ are a group of compounds with a wide band gap and good charge transport properties.

When the fluoranthene skeleton has a substituent, this increases the degree of rotational freedom of a bond and provides a bulky compound. This can suppress intermolecular stacking, and among the compounds belonging to Group JJ a compound with a substituent is a compound with high sublimability.

Furthermore, in the organic light-emitting element according to the present embodiment, the light-emitting layer can have the following features. The light-emitting layer may be the first light-emitting layer or the second light-emitting layer, and the light-emitting layer on the side closer to the positive electrode can have the following features. More specifically, when the first electrode is a positive electrode, the first light-emitting layer can have the following features.

(1-6) When the relationship of the formula [3] is satisfied, the organic light-emitting element has further improved durability.

$$[3]\ \mathrm{LUMO\ (H3) - LUMO\ (D1) > HOMO\ (D1) - HOMO\ (H3)}$$

(1-7) When the relationship of the formula [5] is satisfied, the organic light-emitting element has further improved durability.

$$[5]\ \mathrm{HOMO\ (H4) - HOMO\ (H3)} \geq 0.1\ \mathrm{eV}$$

These features will be described below.

(1-6) When the relationship of the formula [3] is satisfied, the organic light-emitting element has further improved durability.

$$[3]\ \mathrm{LUMO\ (H3) - LUMO\ (D1) > HOMO\ (D1) - HOMO\ (H3)}$$

In the organic light-emitting element according to the present embodiment, the third organic compound and the first light-emitting compound can satisfy the relationship of the formula [3]. When the relationship of the formula [3] is satisfied, the organic light-emitting element according to the present embodiment has higher durability.

Table 4 shows a comparison of the voltage and durability of an organic light-emitting element in which the alkyl metal atom is a lithium atom, the first organic compound is ET1, and the second organic compound is an exemplary compound A6. The voltage and durability are as described above. ΔHOMOand ΔLUMO are as follows:

$$\Delta HOMO = HOMO\ (D1) - HOMO\ (H3)$$

$$\Delta LUMO = LUMO\ (H3) - LUMO\ (D1)$$

Table 4

| | Third organic compound | | First light-emitting material | | | Voltage | Durability |
|---|---|---|---|---|---|---|---|
| | Molecular structure | LUMO/eV HOMO/eV | Molecular structure | LUMO/eV HOMO/eV | ΔLUMO | Ref ratio | Ref ratio |
| Example 6 | 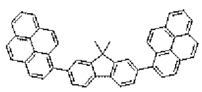 | -3.0 -6.0 | 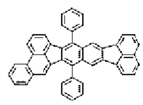 | -3.2 -6.0 | 0.2 | 0.9 | 1.5 |
| Example 8 | 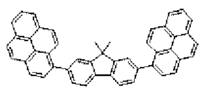 | -3.0 -6.0 | 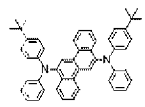 | -2.9 -5.5 | -0.1 | 0.9 | 1.2 |

In Table 4, Example 6, which is the organic light-emitting element according to the present embodiment, has higher durability than Example 8. This is because the organic light-emitting element of Example 8 has a higher ΔHOMOthan the organic light-emitting element of Example 6. The first light-emitting compound can more easily trap a hole and is more likely to be degraded by a hole.

Thus, the organic light-emitting element according to the present embodiment can satisfy the relationship of the formula [3] or the relationship of the formula [4]:

$$[3]\ LUMO\ (H3) - LUMO\ (D1) > HOMO\ (D1) - HOMO\ (H3)$$

$$[4]\ LUMO\ (H3) - LUMO\ (D1) \geq 0.1\ eV$$

(1-7) When the relationship of the formula [5] is satisfied, the organic light-emitting element has further improved durability.

$$[5]\ HOMO\ (H4) - HOMO\ (H3) \geq 0.1\ eV$$

In the organic light-emitting element according to the present embodiment, the third organic compound and the fourth organic compound can satisfy the relationship of the formula [5]. When the relationship of the formula [5] is satisfied, the fourth organic compound can trap a hole, and the organic light-emitting element has further improved durability.

Table 5 shows a comparison of the voltage and durability of an organic light-emitting element in which the alkyl metal atom is a lithium atom, the first organic compound is ET1, and the second organic compound is the exemplary compound A6, and the first light-emitting compound is BD7. The voltage and durability are as described above. ΔHOMO is as follows:

$$\Delta HOMO = HOMO\ (H4) - HOMO\ (H3)$$

Table 5

| | Third organic compound | | Fourth organic compound | | | Voltage | Durability |
|---|---|---|---|---|---|---|---|
| | Molecular structure | LUMO/eV HOMO/eV | Molecular structure | LUMO/eV HOMO/eV | ΔHOMO | Ref ratio | Ref ratio |
| Example 6 | 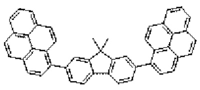 | -3.0 -6.0 | | | - | 0.9 | 1.5 |
| Example 9 | 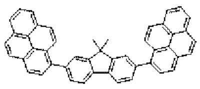 | -3.0 -6.0 | 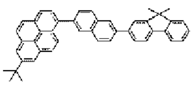 | -2.9 -5.9 | 0.1 | 0.9 | 1.6 |

In Table 5, Example 9, which is the organic light-emitting element according to the present embodiment, has a structure in which the fourth organic compound is added to the structure of the first light-emitting layer of Example 6 satisfying the relationship of the formula [3]. Example 9 is an organic light-emitting element with higher durability than Example 6. This is because Example 9 satisfies the relation of the formula [5], and the fourth organic compound can more easily trap a hole. This can reduce the leakage of a hole to the n-type charge generation layer, and the organic light-emitting element according to the present embodiment therefore has higher durability.

Thus, the organic light-emitting element according to the present embodiment can satisfy the relationship of the formula [5]:

$$[5]\ \mathrm{HOMO\ (H4) - HOMO\ (H3)} \geq 0.1\ \mathrm{eV}$$

(2) Other Materials

If necessary, the organic light-emitting element according to the present embodiment may also include a known low-molecular-weight or high-molecular-weight hole injection compound or hole transport compound, host compound, light-emitting compound, electron injection compound, electron transport compound, or the like. Examples of these compounds are described below.

The hole injection/transport material can be a material with high hole mobility to facilitate the injection of a hole from a positive electrode and to transport the injected hole to a light-emitting layer. Furthermore, a material with a high glass transition temperature can be used to reduce degradation of film quality, such as crystallization, in the organic light-emitting element. Examples of the low-molecular-weight or high-molecular-weight material with hole injection/transport ability include, but are not limited to, a triarylamine derivative, an aryl carbazole derivative, a phenylenediamine derivative, a stilbene derivative, a phthalocyanine derivative, a porphyrin derivative, polyvinylcarbazole, polythiophene, and another electrically conductive polymer. Furthermore, the hole injection/transport material can also be suitable for use in an electron-blocking layer or a p-type charge generation layer. Specific examples of a compound that can be used as a hole injection/transport material include, but are not limited to, the following.

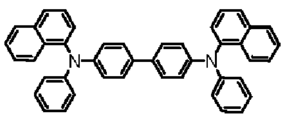

**HT1**

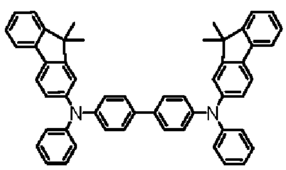

**HT2**

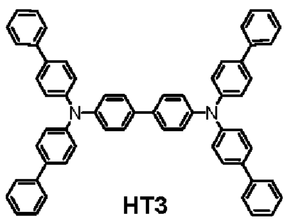

**HT3**

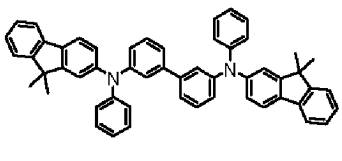

**HT4**

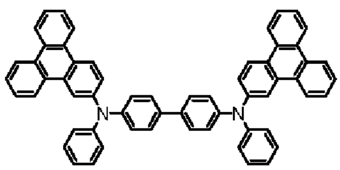

**HT5**

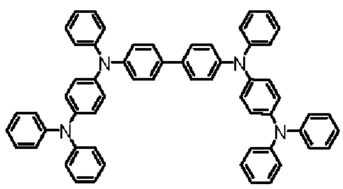

**HT6**

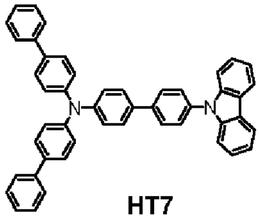
HT7
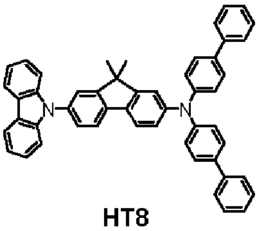
HT8
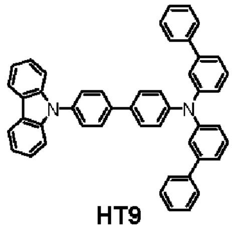
HT9

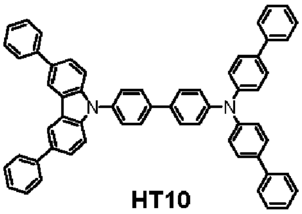
HT10
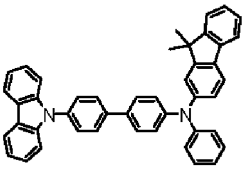
HT11
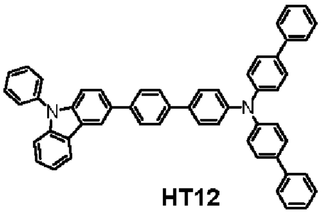
HT12

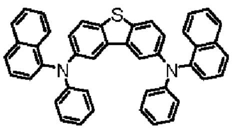
HT13
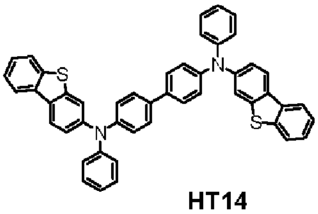
HT14
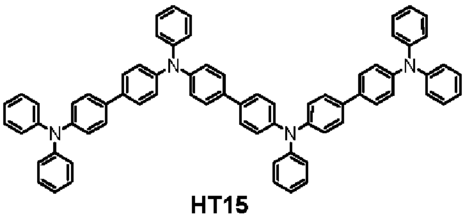
HT15

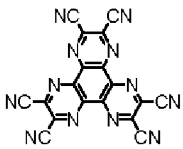
HT16
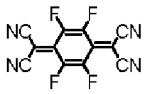
HT17
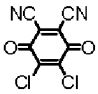
HT18
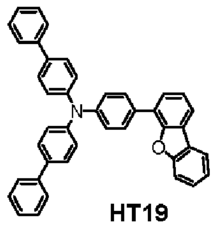
HT19

A light-emitting material mainly related to the light-emitting function may be, in addition to the light-emitting material described above, a fused-ring compound (for example, a fluorene derivative, a naphthalene derivative, a pyrene derivative, a perylene derivative, a tetracene derivative, an anthracene compound, rubrene, or the like), a quinacridone derivative, a coumarin derivative, a stilbene derivative, an organoaluminum complex, such as tris(8-quinolinolato) aluminum, an iridium complex, a platinum complex, a rhenium complex, a copper complex, an europium complex, a ruthenium complex, or a polymer derivative, such as a poly(phenylene vinylene) derivative, a polyfluorene derivative, or a polyphenylene derivative. Specific examples of a compound that can be used as a light-emitting material include, but are not limited to, the following.

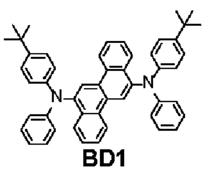
BD1
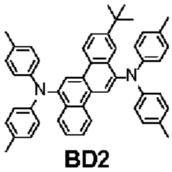
BD2
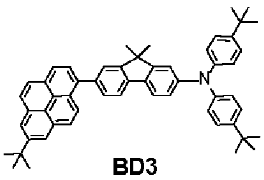
BD3
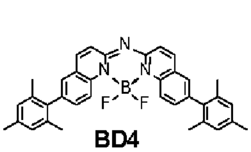
BD4

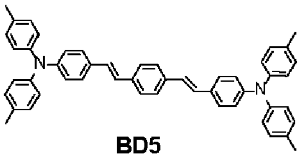
BD5
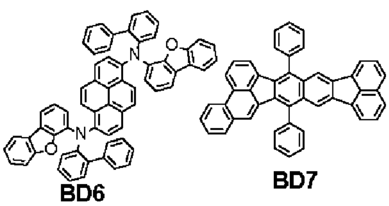
BD6
BD7
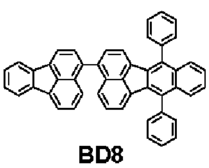
BD8

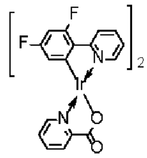
BD9

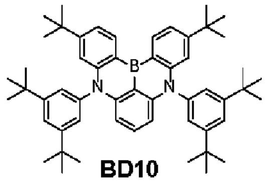
BD10

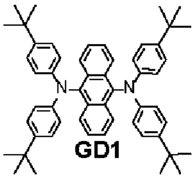
GD1

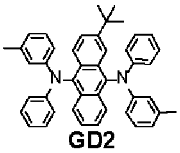
GD2

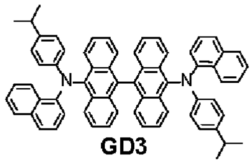
GD3

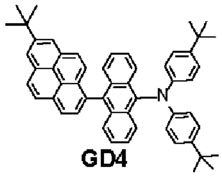
GD4

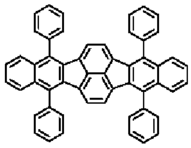
GD5

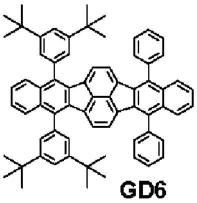
GD6

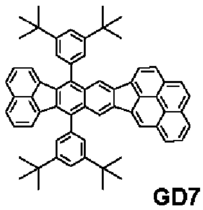
GD7

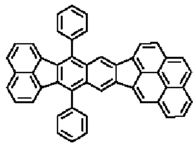
GD8

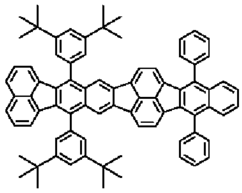
GD9

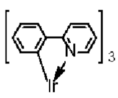
GD10

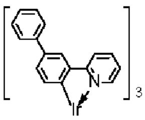
GD11

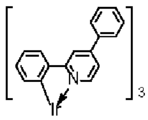
GD12

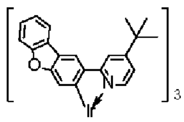
GD13

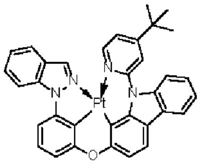
GD14

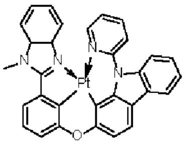
GD15

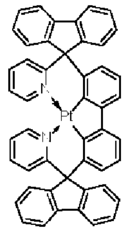
GD16

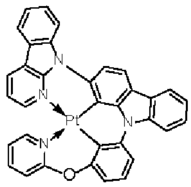
GD17

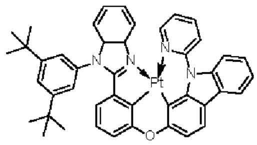
GD18

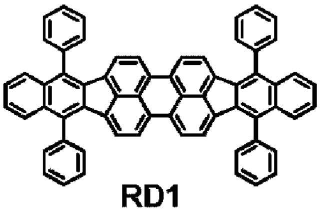
RD1

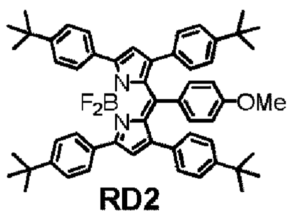
RD2

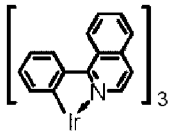
RD3

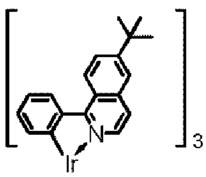
RD4

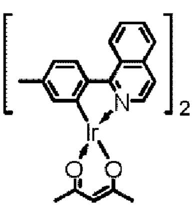
RD5
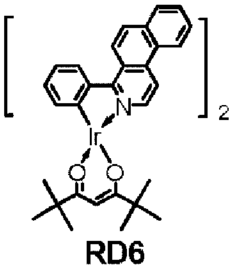
RD6
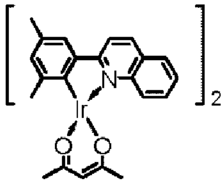
RD7
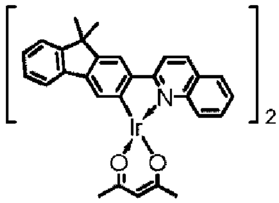
RD8

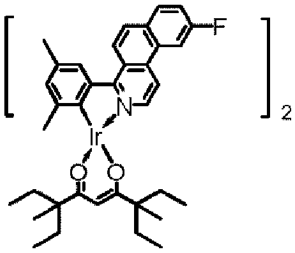
RD9
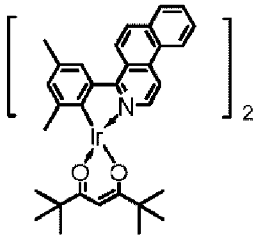
RD10

A compound other than the third organic compound and the fourth organic compound may be contained as a host or an assist in the light-emitting layer. Examples thereof include, but are not limited to, an aromatic hydrocarbon compound or a derivative thereof, a carbazole derivative, an azine derivative, a xanthone derivative, a dibenzofuran derivative, a dibenzothiophene derivative, an organoaluminum complex, such as tris(8-quinolinolato)aluminum, and an organoberyllium complex. Specific examples are as follows:

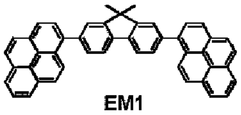
EM1
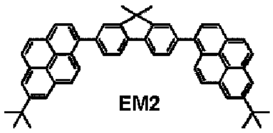
EM2
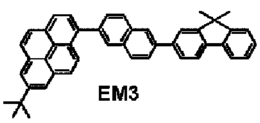
EM3
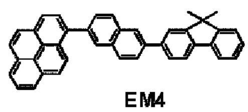
EM4

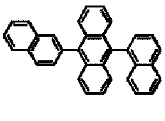
EM5
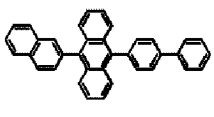
EM6
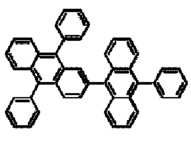
EM7
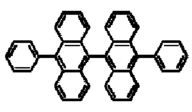
EM8
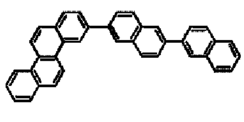
EM9

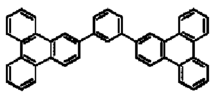
EM10
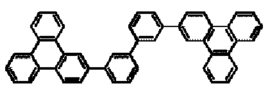
EM11
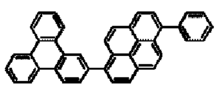
EM12
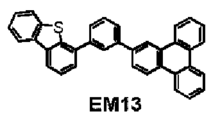
EM13

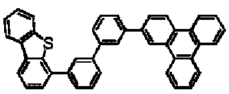
EM14
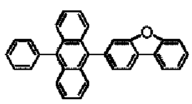
EM15
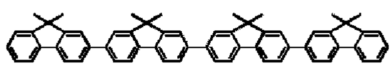
EM16

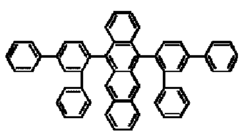
EM17
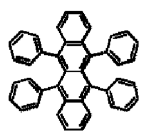
EM18
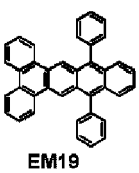
EM19
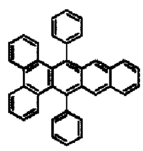
EM20
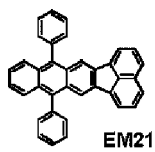
EM21

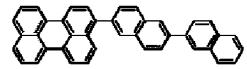
EM22
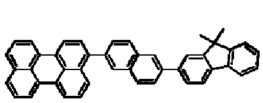
EM23
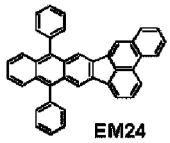
EM24
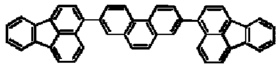
EM25

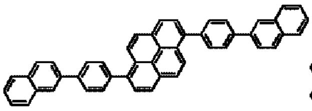
EM26
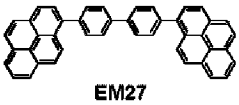
EM27
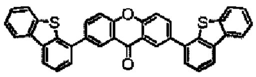
EM28
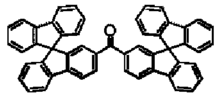
EM29

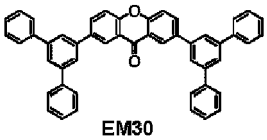
EM30
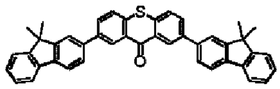
EM31
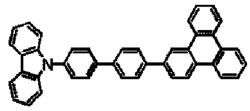
EM32
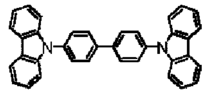
EM33

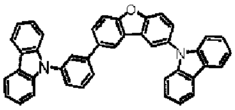
EM34
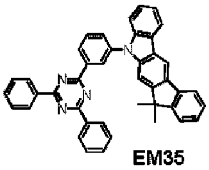
EM35
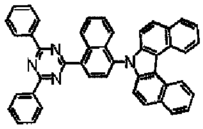
EM36
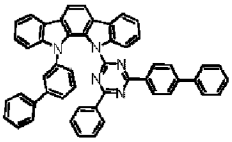
EM37

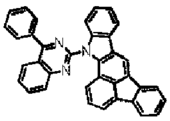
EM38
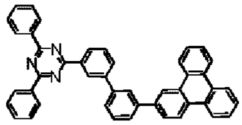
EM39
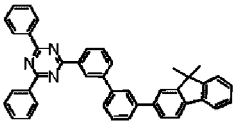
EM40

An electron transport material can be selected from materials that can transport an electron injected from the negative electrode to the light-emitting layer and is selected in consideration of the balance with the hole mobility of a hole transport material and the like. Examples of materials with electron transport ability include, but are not limited to, an oxadiazole derivative, an oxazole derivative, a pyrazine derivative, a triazole derivative, a triazine derivative, a quinoline derivative, a quinoxaline derivative, a phenanthroline derivative, an organoaluminum complex, and a fused-ring compound (for example, a fluorene derivative, a naphthalene derivative, a chrysene derivative, an anthracene derivative, or the like). Furthermore, the electron transport material is also suitable for use in a hole-blocking layer. Specific examples of a compound that can be used as an electron transport material include, but are not limited to, the following. Specific examples are as follows:

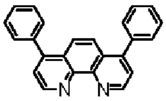
ET1
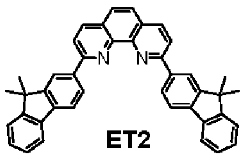
ET2
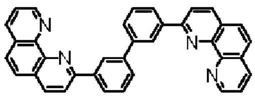
ET3
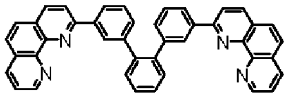
ET4

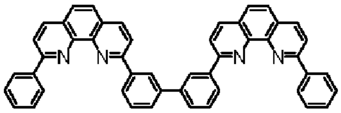
ET5
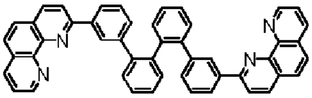
ET6
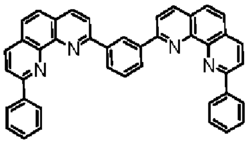
ET7

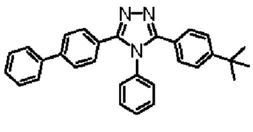
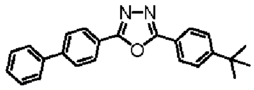
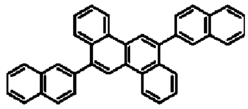
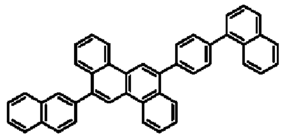

ET8 ET9 ET10 ET11

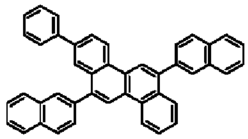
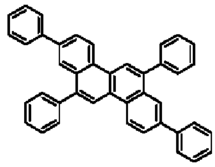
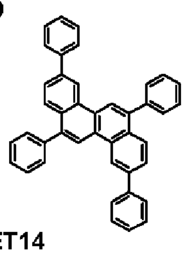
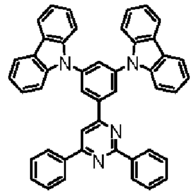

ET12 ET13 ET14 ET15

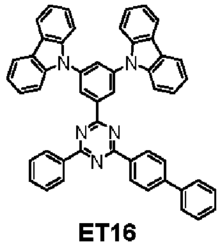
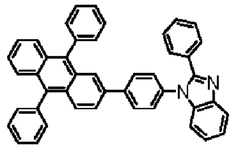
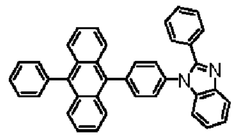
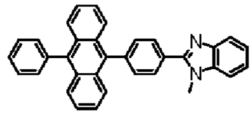

ET16 ET17 ET18 ET19

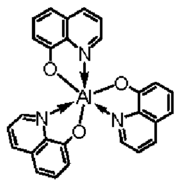
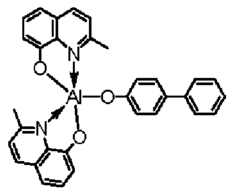
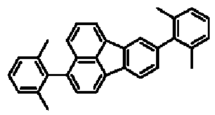
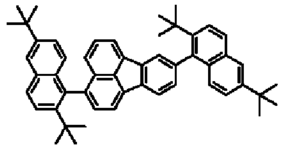

ET20 ET21 ET22 ET23

Among the exemplary compounds, compounds that can be suitably used as the host material of the n-type charge generation layer are ET1 to 9, ET14 to 21, and ET25 to 27.

The electron injection material can be selected from materials that can easily inject an electron from the negative electrode and is selected in consideration of the balance with the hole injection properties and the like. The organic compound may be an n-type dopant or a reducing dopant. Examples thereof include a compound containing an alkali metal, such as lithium fluoride, a lithium complex, such as lithium quinolinol, a benzimidazolidene derivative, an imidazolidene derivative, a fulvalene derivative, and an acridine derivative. It can also be used in combination with the electron transport material.

<Structure of Organic Light-Emitting Element>

Constituent members constituting the organic light-emitting element according to the present embodiment will be described below.

The organic light-emitting element may include an insulating layer, a first electrode, an organic compound layer, and a second electrode on a substrate. A protective layer, a color filter, a microlens, or the like may be provided on the second electrode. When a color filter is provided, a planarization layer may be provided between the color filter and a protective layer. The planarization layer may be composed of an acrylic resin or the like. The same applies to a planarization layer provided between a color filter and a microlens.

[Substrate]

The substrate may be formed of quartz, glass, a silicon wafer, resin, metal, or the like. The substrate may have a switching element, such as a transistor, and wiring, on which an insulating layer may be provided. The insulating layer may be any material that allows the formation of a contact hole for wiring between the first electrode and the substrate and that can ensure insulation from wiring not to be connected. For example, the insulating layer may be formed of a resin, such as polyimide, silicon oxide, or silicon nitride.

[Electrode]

The first electrode and the second electrode can be used as electrodes. The first electrode and the second electrode may be a positive electrode and a negative electrode. When an electric field is applied in a direction in which the organic light-emitting element emits light, an electrode with a high electric potential is a positive electrode, and the other electrode is a negative electrode. In other words, the electrode that supplies a hole to the light-emitting layer is a positive electrode, and the electrode that supplies an electron to the light-emitting layer is a negative electrode.

A constituent material of the positive electrode can have as large a work function as possible. Examples thereof include a metal element, such as gold, platinum, silver, copper, nickel, palladium, cobalt, selenium, vanadium, or tungsten, a mixture thereof, an alloy thereof, or a metal oxide, such as tin oxide, zinc oxide, indium oxide, indium tin oxide (ITO), or indium zinc oxide. An electrically conductive polymer, such as polyaniline, polypyrrole, or polythiophene, may also be used.

These electrode materials may be used alone or in combination. The positive electrode may be composed of a single layer or a plurality of layers.

When used as a reflective electrode, for example, chromium, aluminum, silver, titanium, tungsten, molybdenum, an alloy thereof, or a laminate thereof can be used. These materials can also function as a reflective film that does not have a role as an electrode. When used as a transparent electrode, an oxide transparent electroconductive layer, such as indium tin oxide (ITO) or indium zinc oxide, can be used. However, the present disclosure is not limited thereto. The electrodes may be formed by photolithography.

On the other hand, a constituent material of the negative electrode can be a material with a small work function. For example, an alkali metal, such as lithium, an alkaline-earth metal, such as calcium, a metal element, such as aluminum, titanium, manganese, silver, lead, or chromium, or a mixture thereof may be used. An alloy of these metal elements may also be used. For example, magnesium-silver, aluminum-lithium, aluminum-magnesium, silver-copper, or zinc-silver may be used. A metal oxide, such as indium tin oxide (ITO), may also be used. These electrode materials may be used alone or in combination. The negative electrode may be composed of a single layer or a plurality of layers. In particular, silver can be used, and a silver alloy can be used to reduce the aggregation of silver. As long as the aggregation of silver can be reduced, the alloy may have any ratio. For example, the ratio of silver to another metal may be 1: 1, 3: 1, or the like.

The negative electrode may be, but is not limited to, an oxide electroconductive layer, such as ITO, for a top emission element or a reflective electrode, such as aluminum (Al), for a bottom emission element. The negative electrode may be formed by any method. A direct-current or alternating-current sputtering method can achieve good film coverage and easily decrease resistance.

[Organic Compound Layer]

The organic compound layer may be formed of a single layer or a plurality of layers. The organic compound layer includes at least a light-emitting layer and, in addition to the light-emitting layer, may include a hole injection layer, a hole transport layer, and/or an electron-blocking layer on the positive electrode side, and a hole-blocking layer, an electron transport layer, an electron injection layer, a charge generation portion, and/or the like on the negative electrode side, which are appropriately selected as required. The organic compound layer is composed mainly of an organic compound and may contain an inorganic atom or an inorganic compound. For example, copper, lithium, magnesium, aluminum, iridium, platinum, molybdenum, zinc, or the like may be contained.

The organic compound layer constituting the organic light-emitting element according to the present embodiment can be formed by a dry process, such as a vacuum evaporation method, an ionized deposition method, sputtering, or plasma. Instead of the dry process, a wet process may also be employed in which a layer is formed by a known coating method (for example, spin coating, dipping, a casting method, an LB method, an ink jet method, or the like) using an appropriate solvent.

A layer formed by a vacuum evaporation method, a solution coating method, or the like undergoes little crystallization or the like and has high temporal stability. When a film is formed by a coating method, the film may also be formed in combination with an appropriate binder resin.

The binder resin may be, but is not limited to, a polyvinylcarbazole resin, a polycarbonate resin, a polyester resin, an ABS resin, an acrylic resin, a polyimide resin, a phenolic resin, an epoxy resin, a silicone resin, or a urea resin.

These binder resins may be used alone or in combination as a homopolymer or a copolymer. If necessary, an additive agent, such as a known plasticizer, oxidation inhibitor, and/or ultraviolet absorbent, may also be used.

[Protective Layer]

A protective layer may be provided on the second electrode. For example, a glass sheet with a moisture absorbent can be bonded to the second electrode to reduce water infiltration or the like into the organic compound layer

and to reduce the occurrence of a display defect. In another embodiment, a passivation film of silicon nitride or the like may be provided on the second electrode to reduce water infiltration or the like into the organic compound layer. For example, after the second electrode is formed, the element may be transported to another chamber without breaking the vacuum, and a silicon nitride film with a thickness of 2 μm may be formed by a CVD method as a protective layer. The film formation by the CVD method may be followed by the formation of a protective layer by an atomic layer deposition (ALD) method. A film formed by the ALD method may be formed of any material, such as silicon nitride, silicon oxide, or aluminum oxide. Silicon nitride may be further formed by the CVD method on the film formed by the ALD method. The film formed by the ALD method may have a smaller thickness than the film formed by the CVD method. More specifically, the thickness may be 50% or less or even 10% or less.

[Color Filter]

A color filter may be provided on the protective layer. For example, a color filter that matches the size of the organic light-emitting element may be provided on another substrate and may be bonded to the substrate on which the organic light-emitting element is provided, or a color filter may be patterned on the protective layer by photolithography. The color filter may be composed of a polymer.

[Planarization Layer]

A planarization layer may be provided between the color filter and the protective layer. The planarization layer is provided to reduce the roughness of the underlayer. The planarization layer is sometimes referred to as a material resin layer with any purpose. The planarization layer may be composed of an organic compound and can be composed of a high-molecular-weight compound, though it may be composed of a low-molecular-weight compound.

The planarization layer may be provided above and below the color filter, and the constituent materials thereof may be the same or different. Specific examples include a polyvinylcarbazole resin, a polycarbonate resin, a polyester resin, an ABS resin, an acrylic resin, a polyimide resin, a phenolic resin, an epoxy resin, a silicone resin, and a urea resin.

[Microlens]

The organic light-emitting element according to the present embodiment may have an optical member, such as a microlens, on the light-emitting side. The microlens may be composed of an acrylic resin, an epoxy resin, or the like. The microlens may be used to increase the amount of light extracted from the organic light-emitting element and to control the direction of the extracted light. The microlens may have a hemispherical shape. For a hemispherical microlens, the vertex of the microlens is a contact point between the hemisphere and a tangent line parallel to the insulating layer among the tangent lines in contact with the hemisphere. The vertex of the microlens in any cross-sectional view can be determined in the same manner. More specifically, the vertex of the microlens in a cross-sectional view is a contact point between the semicircle of the microlens and a tangent line parallel to the insulating layer among the tangent lines in contact with the semicircle.

The midpoint of the microlens can also be defined. In a cross section of the microlens, a midpoint of a line segment from one end point to the other end point of the arc can be referred to as a midpoint of the microlens. A cross section in which the vertex and the midpoint are determined may be perpendicular to the insulating layer.

[Opposite Substrate]

An opposite substrate may be provided on the planarization layer. The opposite substrate is so called because it faces the substrate. The opposite substrate may be composed of the same material as the substrate. When the substrate is a first substrate, the opposite substrate may be a second substrate.

[Pixel Circuit]

A light-emitting apparatus may include a pixel circuit coupled to the organic light-emitting element according to the present embodiment. The pixel circuit may be of an active matrix type, which independently controls the light emission of a plurality of organic light-emitting elements. The active-matrix circuit may be voltage programmed or current programmed. The drive circuit has a pixel circuit for each pixel. The pixel circuit may include an organic light-emitting element, a transistor for controlling the luminous brightness of the organic light-emitting element, a transistor for controlling light emission timing, a capacitor for holding the gate voltage of the transistor for controlling the luminous brightness, and a transistor for GND connection without through the light-emitting element.

A light-emitting apparatus includes a display region and a peripheral region around the display region. The

display region includes the pixel circuit, and the peripheral region includes a display control circuit. The mobility of a transistor constituting the pixel circuit may be smaller than the mobility of a transistor constituting the display control circuit. The gradient of the current-voltage characteristics of a transistor constituting the pixel circuit may be smaller than the gradient of the current-voltage characteristics of a transistor constituting the display control circuit. The gradient of the current-voltage characteristics can be determined by so-called Vg-Ig characteristics. A transistor constituting the pixel circuit is a transistor coupled to an organic light-emitting element.

[Pixel]

A light-emitting apparatus including the organic light-emitting element according to the present embodiment may have a plurality of pixels. Each pixel has subpixels that emit light of different colors. For example, the subpixels may have RGB emission colors.
In each pixel, a region also referred to as a pixel aperture emits light. This region is the same as the first region. The pixel aperture may be 15 μm or less or 5 μm or more. More specifically, the pixel aperture may be 11 μm, 9.5 μm, 7.4 μm, or 6.4 μm. The distance between the subpixels may be 10 μm or less, more specifically, 8 μm, 7.4 μm, or 6.4 μm.
The pixels may be arranged in a known form in a plan view. Examples include a stripe arrangement, a delta arrangement, a PenTile arrangement, and a Bayer arrangement. Each subpixel may have any known shape in a plan view. Examples include quadrangles, such as a rectangle and a rhombus, and a hexagon. As a matter of course, the rectangle also includes a figure that is not strictly rectangular but is close to rectangular. The shape of each subpixel and the pixel array can be used in combination.

<Applications of Organic Light-Emitting Element>

The organic light-emitting element according to the present embodiment can be used as a constituent of a display apparatus or a lighting apparatus. Other applications include an exposure light source for an electrophotographic image-forming apparatus, a backlight for a liquid crystal display, and a light-emitting apparatus with a color filter in a white light source.
The display apparatus may be an image-information-processing apparatus that includes an image input unit for inputting image information from an area CCD, a linear CCD, a memory card, or the like, includes an information processing unit for processing the input information, and displays an input image on a display unit. The display apparatus may have a plurality of pixels, and at least one of the pixels may include the organic light-emitting element according to the present embodiment and a transistor coupled to the organic light-emitting element.
A display unit of an imaging apparatus or an ink jet printer may have a touch panel function. A driving system of the touch panel function may be, but is not limited to, an infrared radiation system, an electrostatic capacitance system, a resistive film system, or an electromagnetic induction system. The display apparatus may be used for a display unit of a multifunction printer.
Next, a display apparatus according to the present embodiment will be described with reference to the accompanying drawings.
Fig. 2A is a schematic cross-sectional view of an example of a display apparatus that includes the organic light-emitting element according to the present embodiment and a transistor coupled to the organic light-emitting element. The transistor is an example of an active element. The transistor may be a thin-film transistor (TFT). The subpixels are 10R, 10G, and 10B with different emission colors. The emission colors may be distinguished by the wavelength of light emitted from the light-emitting layer, or light emitted from each subpixel may be selectively transmitted or color-converted with a color filter or the like. Each of the subpixels 10 includes a reflective electrode serving as a first electrode 2, an insulating layer 3 covering an end of the first electrode 2, organic compound layers 4 covering the first electrode 2 and the insulating layer 3, a transparent electrode serving as a second electrode 5, a protective layer 6, and a color filter 7 on an interlayer insulating layer 1. Reference numeral 8 denotes an organic light-emitting element.
A transistor and/or a capacitor element may be provided under or inside the interlayer insulating layer 1. The transistor and the first electrode 2 may be electrically connected via a contact hole (not shown) or the like.
The insulating layer 3 is also referred to as a bank or a pixel separation film. It covers an end of the first electrode 2 and is arranged around the first electrode 2. A portion not covered with the insulating layer 3 is in contact with the organic compound layers 4 and serves as a light-emitting region.
The second electrode 5 may be a transparent electrode, a reflective electrode, or a semitransparent electrode.
The protective layer 6 reduces the penetration of moisture into the organic compound layers 4. The protective layer 6 is illustrated as a single layer but may be a plurality of layers. The protective layer 6 may include an inorganic compound layer and an organic compound layer.
The color filter 7 is divided into 7R, 7G, and 7B according to the color. The color filter 7 may be formed on a planarization film (not shown). Furthermore, a resin protective layer (not shown) may be provided on the color filter 7. The

color filter 7 may be formed on the protective layer 6. Alternatively, the color filter 7 may be bonded after being provided on an opposite substrate, such as a glass substrate.

Fig. 2B is a schematic cross-sectional view of an example of a display apparatus that includes an organic light-emitting element and a transistor coupled to the organic light-emitting element. The display apparatus includes an organic light-emitting element 26 and a thin-film transistor (TFT) 18 as an example of a transistor. The display apparatus includes a substrate 11 made of glass, silicon, or the like and an insulating layer 12 on the substrate 11. An active element, such as the TFT 18, and a gate electrode 13, a gate-insulating film 14, and a semiconductor layer 15 of the active element are disposed on the insulating layer 12. The TFT 18 is also composed of a drain electrode 16 and a source electrode 17. The TFT 18 is covered with an insulating film 19. A positive electrode 21 of the organic light-emitting element 26 is coupled to the source electrode 17 through a contact hole 20 formed in the insulating film 19.

Electrical connection between the electrodes of the organic light-emitting element 26 (the positive electrode 21 and a negative electrode 23) and the electrodes of the TFT 18 (the source electrode 17 and the drain electrode 16) is not limited to that illustrated in Fig. 2B. More specifically, it is only necessary to electrically connect either the positive electrode 21 or the negative electrode 23 to either the source electrode 17 or the drain electrode 16 of the TFT 18.

Although an organic compound layer 22 is a single layer in the display apparatus illustrated in Fig. 2B, the organic compound layer 22 may be composed of a plurality of layers. The negative electrode 23 is covered with a first protective layer 24 and a second protective layer 25 for reducing degradation of the organic light-emitting element 26.

The transistor used in the display apparatus in Fig. 2B is not limited to a transistor including a single crystal silicon wafer and may also be a thin-film transistor including an active layer on an insulating surface of a substrate. The active layer may be single-crystal silicon, non-single-crystal silicon, such as amorphous silicon or microcrystalline silicon, or a non-single-crystal oxide semiconductor, such as indium zinc oxide or indium gallium zinc oxide.

The transistor in the display apparatus of Fig. 2B may be formed within a substrate, such as a Si substrate. The phrase "formed within a substrate" means that the substrate, such as a Si substrate, itself is processed to form the transistor. Thus, the transistor within the substrate can be considered that the substrate and the transistor are integrally formed.

The luminous brightness of the organic light-emitting element 26 according to the present embodiment can be controlled by a TFT, which is an example of a switching element, and the organic light-emitting element 26 can be provided in a plurality of planes to display an image with their respective luminous brightness values. The switching element according to the present embodiment is not limited to the TFT and may be a transistor formed of low-temperature polysilicon or an active-matrix driver formed on a substrate, such as a Si substrate. The phrase "on a substrate" may also be referred to as "within a substrate". Whether a transistor is provided within a substrate or a TFT is used depends on the size of a display unit. For example, for an approximately 0.5-inch display unit, an organic light-emitting element can be provided on a Si substrate.

Fig. 3 is a schematic view of an example of a display apparatus according to the present embodiment. A display apparatus 1000 includes a touch panel 1003, a display panel 1005, a frame 1006, a circuit substrate 1007, and a battery 1008 between an upper cover 1001 and a lower cover 1009. The touch panel 1003 and the display panel are coupled to flexible print circuits FPC 1002 and 1004, respectively. Transistors are printed on the circuit substrate 1007. The battery 1008 is not necessarily provided when the display apparatus is not a mobile device, or may be provided at another position even when the display apparatus is a mobile device.

The display apparatus according to the present embodiment may include color filters of red, green, and blue colors. In the color filters, the red, green, and blue colors may be arranged in a delta arrangement.

The display apparatus according to the present embodiment may be used for a display unit of a mobile terminal. Such a display apparatus may have both a display function and an operation function. Examples of the mobile terminal include mobile phones, such as smartphones, tablets, and head-mounted displays.

The display apparatus according to the present embodiment may be used for a display unit of an imaging apparatus that includes an optical unit with a plurality of lenses and an imaging element for receiving light passing through the optical unit. The imaging apparatus may include a display unit for displaying information acquired by the imaging element. The display unit may be a display unit exposed outside from the imaging apparatus or a display unit located in a finder. The imaging apparatus may be a digital camera or a digital video camera.

Fig. 4A is a schematic view of an example of an imaging apparatus according to the present embodiment. An imaging apparatus 1100 may include a viewfinder 1101, a rear display 1102, an operating unit 1103, and a housing 1104. The viewfinder 1101 and the rear display 1102 may include the organic light-emitting element according to the present embodiment. In such a case, the viewfinder 1101 and the rear display 1102 may display environmental information, imaging instructions, and the like as well as an image to be captured. The environmental information may include the intensity of external light, the direction of external light, the travel speed of the photographic subject, the possibility that the photographic subject is shielded by a shielding material, and the like.

Because the appropriate timing for imaging is a short time, it is better to display information as early as possible. Thus, a display apparatus including the organic light-emitting element according to the present embodiment can be used.

This is because the organic light-emitting element has a high response speed. A display apparatus including the organic light-emitting element can be more suitably used than these apparatuses and liquid crystal displays that require a high display speed.

The imaging apparatus 1100 may further include an optical unit (not shown). The optical unit may have one or more lenses, and an image is formed on the imaging element in the housing 1104. The focus of the lenses can be adjusted by adjusting their relative positions. This operation can also be automatically performed. The imaging apparatus may also be referred to as a photoelectric conversion apparatus. The photoelectric conversion apparatus can have, as an imaging method, a method of detecting a difference from a previous image, a method of cutting out a permanently recorded image, or the like, instead of taking an image one after another.

Fig. 4B is a schematic view of an example of electronic equipment according to the present embodiment. Electronic equipment 1200 includes a display unit 1201, an operating unit 1202, and a housing 1203. The display unit 1201 may include the organic light-emitting element according to the present embodiment. The housing 1203 may include a circuit, a printed circuit board including the circuit, a battery, and a communication unit. The operating unit 1202 may be a button or a touch panel response unit. The operating unit 1202 may be a biometric recognition unit that recognizes a fingerprint and releases the lock. Electronic equipment with a communication unit may also be referred to as communication equipment. The electronic equipment 1200 may have a lens and an imaging element and thereby further have a camera function. An image captured by the camera function is displayed on the display unit 1201. The electronic equipment 1200 may be a smartphone, a notebook computer, or the like.

Figs. 5A and 5B are schematic views of an example of a display apparatus according to the present embodiment. Fig. 5A illustrates a display apparatus, such as a television monitor or a PC monitor. A display apparatus 1300 includes a frame 1301 and a display unit 1302. The organic light-emitting element according to the present embodiment may be used for the display unit 1302.

If necessary, the display apparatus 1300 may include a base 1303 that supports the display unit 1302. The base 1303 is not limited to the structure illustrated in Fig. 5A. The lower side of the frame 1301 may also serve as the base. The frame 1301 and the display unit 1302 may be bent. The radius of curvature thereof may be 5000 mm or more and 6000 mm or less.

Fig. 5B is a schematic view of another example of the display apparatus according to the present embodiment. A display apparatus 1310 in Fig. 5B is configured to be foldable and is a so-called foldable display apparatus. The display apparatus 1310 includes a first display unit 1311, a second display unit 1312, a housing 1313, and a folding point 1314. The first display unit 1311 and the second display unit 1312 may include the organic light-emitting element according to the present embodiment. The first display unit 1311 and the second display unit 1312 may be a single display apparatus without a joint. The first display unit 1311 and the second display unit 1312 can be divided by the folding point. The first display unit 1311 and the second display unit 1312 may display different images or one image.

Fig. 6A is a schematic view of an example of a lighting apparatus according to the present embodiment. A lighting apparatus 1400 includes a housing 1401, a light source 1402, and a circuit substrate 1403. The lighting apparatus 1400 may further include an optical filter 1404 that transmits light emitted by the light source 1402, and a light-diffusing unit 1405. The light source 1402 includes the organic light-emitting element according to the present embodiment. The optical filter 1404 may be a filter that improves the color rendering properties of the light source. The light-diffusing unit 1405 can effectively diffuse light from the light source and widely spread light as in illumination. The optical filter 1404 and the light-diffusing unit 1405 may be provided on the light output side of the lighting apparatus. If necessary, a cover may be provided on the outermost side.

For example, the lighting apparatus is an interior lighting apparatus. The lighting apparatus may emit white light, neutral white light, or light of any color from blue to red. The lighting apparatus may have a light control circuit for controlling such light. The lighting apparatus may include the organic light-emitting element according to the present embodiment and a power supply circuit coupled to the organic light-emitting element. The power supply circuit is a circuit that converts an AC voltage to a DC voltage. White has a color temperature of 4200 K, and neutral white has a color temperature of 5000 K. The lighting apparatus may have a color filter.

The lighting apparatus according to the present embodiment may include a heat dissipation unit. The heat dissipation unit releases heat from the apparatus to the outside and may be a metal, ceramic, or the like with high thermal conductivity.

Fig. 6B is a schematic view of an automobile as an example of a moving body according to the present embodiment. The automobile has a taillight as an example of a lamp. An automobile 1500 may have a taillight 1501, which comes on when a brake operation or the like is performed.

The taillight 1501 may include the organic light-emitting element according to the present embodiment. The taillight 1501 may include a protective member for protecting the organic light-emitting element. The protective member may be formed of any transparent material with moderately high strength and can be formed of polycarbonate or the like. The polycarbonate may be mixed with a furan dicarboxylic acid derivative, an acrylonitrile derivative, or the like.

The automobile 1500 may have a body 1503 and a window 1502 on the body 1503. The window 1502 may be a

transparent display as long as it is not a window for checking the front and rear of the automobile. The transparent display may include the organic light-emitting element according to the present embodiment. In such a case, constituent materials, such as electrodes, of the organic light-emitting element are transparent materials.

The moving body according to the present embodiment includes one or both of a driving force generator that generates a driving force mainly used for the movement of the moving body and a rotating body mainly used for the movement of the moving body. The driving force generator may be an engine, a motor, or the like. The rotating body may be a tire, a wheel, a screw of a ship, a propeller of a flight vehicle, or the like. More specifically, the moving body may be a bicycle, an automobile, a train, a ship, an aircraft, a drone, or the like. The moving body may include a body and a lamp provided on the body. The lamp may emit light to indicate the position of the body. The lamp includes the organic light-emitting element according to the present embodiment.

The electronic equipment or display apparatus can be applied to a system that can be worn as a wearable device, such as smart glasses, a head-mounted display (HMD), or smart contact lenses. An imaging and displaying apparatus used in such an application example includes an imaging apparatus that can photoelectrically convert visible light and a display apparatus that can emit visible light.

Fig. 7A is a schematic view of an example of a wearable device according to the present embodiment. Glasses 1600 (smart glasses) according to one application example will be described below with reference to Fig. 7A. The glasses 1600 include a display unit on the back side of a lens 1601. The display unit may include an organic light-emitting element according to the present disclosure. Furthermore, an imaging apparatus 1602, such as a complementary metal-oxide semiconductor (CMOS) sensor or a single-photon avalanche photodiode (SPAD), may be provided on the front side of the lens 1601 of the glasses 1600.

The glasses 1600 further include a controller 1603. The controller 1603 functions as a power supply for supplying power to the imaging apparatus 1602 and the display unit. The controller 1603 controls the operation of the imaging apparatus 1602 and the display unit. The lens 1601 has an optical system for collecting light of the imaging apparatus 1602 or the display unit.

Fig. 7B is a schematic view of another example of a wearable device according to the present embodiment. Glasses 1610 (smart glasses) according to one application example will be described below with reference to Fig. 7B. The glasses 1610 have a controller 1612, and the controller 1612 is provided with a display apparatus including an organic light-emitting element according to the present disclosure. The controller 1612 may further include an imaging apparatus corresponding to the imaging apparatus 1602. A lens 1611 has an optical system for projecting light emitted from the controller 1612, and an image is projected on the lens 1611.

The controller 1612 functions as a power supply for supplying power to the imaging apparatus and the display apparatus and controls the operation of the imaging apparatus and the display apparatus. The controller may include a line-of-sight detection unit for detecting the line of sight of the wearer. Infrared radiation may be used to detect the line of sight. An infrared radiation unit emits infrared light to an eyeball of a user who is gazing at a display image. Among emitted infrared light, reflected light from the eyeball is detected by an imaging unit including a light-receiving element to capture an image of the eyeball. A reduction unit for reducing light from the infrared radiation unit to a display unit in a plan view is provided to reduce degradation in image quality.

The controller 1612 detects the line of sight of the user gazing at a display image from a captured image of the eyeball obtained using infrared light. Any known technique can be applied to line-of-sight detection using the captured image of the eyeball. For example, it is possible to use a line-of-sight detection method based on a Purkinje image obtained by the reflection of irradiation light by the cornea. More specifically, a line-of-sight detection process based on a pupil-corneal reflection method is performed. The line of sight of the user is detected by calculating a line-of-sight vector representing the direction (rotation angle) of an eyeball on the basis of an image of a pupil and a Purkinje image included in a captured image of the eyeball using the pupil-corneal reflection method.

A display apparatus according to an embodiment of the present disclosure may include an imaging apparatus including a light-receiving element and may control a display image on the basis of line-of-sight information of a user from the imaging apparatus. More specifically, on the basis of the line-of-sight information, the display apparatus determines a first visibility region at which the user gazes and a second visibility region other than the first visibility region. The first visibility region and the second visibility region may be determined by the controller of the display apparatus or may be received from an external controller. In the display region of the display apparatus, the first visibility region may be controlled to have higher display resolution than the second visibility region. In other words, the second visibility region may have lower resolution than the first visibility region.

The display region has a first display region and a second display region different from the first display region, and the priority of the first display region and the second display region depends on the line-of-sight information. The first visibility region and the second visibility region may be determined by the controller of the display apparatus or may be received from an external controller. A region with a higher priority may be controlled to have higher resolution than another region. In other words, a region with a lower priority may have lower resolution.

The first display region or a region with a higher priority may be determined by artificial intelligence (AI). The AI

may be a model configured to estimate the angle of the line of sight and the distance to a target ahead of the line of sight from an image of an eyeball using the image of the eyeball and the direction in which the eyeball actually viewed in the image as teaching data. The AI program may be stored in the display apparatus, the imaging apparatus, or an external device. The AI program stored in an external device is transmitted to the display apparatus via communication.

For display control based on visual recognition detection, the present disclosure can be applied to smart glasses further having an imaging apparatus for imaging the outside. Smart glasses can display captured external information in real time.

Fig. 8A is a schematic view of an example of an image-forming apparatus according to the present embodiment. An image-forming apparatus 40 is an electrophotographic image-forming apparatus and includes a photosensitive member 27, an exposure light source 28, a charging unit 30, a developing unit 31, a transfer unit 32, a conveying roller 33, and a fixing unit 35. The exposure light source 28 emits light 29, and an electrostatic latent image is formed on the surface of the photosensitive member 27. The exposure light source 28 includes the organic light-emitting element according to the present embodiment. The developing unit 31 contains toner and the like. The charging unit 30 electrifies the photosensitive member 27. The transfer unit 32 transfers a developed image onto a recording medium 34. The conveying roller 33 conveys the recording medium 34. The recording medium 34 is paper, for example. The fixing unit 35 fixes an image on the recording medium 34.

Figs. 8B and 8C are schematic views of the exposure light source 28, wherein a plurality of light-emitting portions 36 are arranged on a long substrate. An arrow 37 indicates a column direction in which the light-emitting portions 36 including an organic light-emitting element are arranged. This column direction is the same as the direction of the rotation axis of the photosensitive member 27. This direction can also be referred to as the major-axis direction of the photosensitive member 27. In Fig. 8B, the light-emitting portions 36 are arranged in the major-axis direction of the photosensitive member 27. In Fig. 8C, unlike Fig. 8B, the light-emitting portions 36 are alternately arranged in the column direction in the first and second columns. The first and second columns are arranged at different positions in the row direction. In the first column, the light-emitting portions 36 are arranged at intervals. In the second column, the light-emitting portions 36 are arranged at positions corresponding to the spaces between the light-emitting portions 36 of the first column. Thus, the light-emitting portions 36 are also arranged at intervals in the row direction. The arrangement in Fig. 8C can also be referred to as a grid-like pattern, a staggered pattern, or a checkered pattern, for example.

As described above, an apparatus including the organic light-emitting element according to the present embodiment can be used to stably display a high-quality image for extended periods.

EXAMPLES

Although exemplary embodiments are described below, the present disclosure is not limited to these exemplary embodiments.

[Exemplary Embodiment 1]

In the present exemplary embodiment, a top emission multilayer organic light-emitting element was produced in which a positive electrode, a light-emitting unit 1, a charge generation portion, a light-emitting unit 2, and a negative electrode were sequentially formed on a substrate. A blue-light-emitting layer in the light-emitting unit 1 and a yellow-light-emitting layer in the light-emitting unit 2 were sequentially formed to produce an organic EL element with a double-sided emission structure.

First, an ITO film was formed on a glass substrate and was subjected to desired patterning to form an ITO electrode (positive electrode). The ITO electrode had a thickness of 100 nm. The substrate on which the ITO electrode was formed was used as an ITO substrate in the following process. The light-emitting unit 1, the charge generation portion, and the light-emitting unit 2 shown in Table 2 below were formed in this order by vacuum evaporation using resistance heating in a vacuum chamber. The counter electrode (a metal electrode layer, a negative electrode) had an electrode area of 3 $mm^2$. After the films up to the negative electrode were formed, the substrate was transferred to a glove box and was sealed with a glass cap containing a drying agent in a nitrogen atmosphere to produce a multilayer organic EL element.

Table 6

<table>
<tr><th>Unit</th><th>Name of organic layer</th><th colspan="2">Material</th><th>Thickness (nm)</th></tr>
<tr><td rowspan="2">Negative electrode</td><td rowspan="2">Negative electrode</td><td>Mg</td><td rowspan="2">Waight ratio Mg : Ag = 50 : 50</td><td rowspan="2">10</td></tr>
<tr><td>Ag</td></tr>
</table>

(continued)

<table>
<tr><th>Unit</th><th>Name of organic layer</th><th colspan="2">Material</th><th>Thickness (nm)</th></tr>
<tr><td rowspan="7">Light-emitting unit 2</td><td>Electron injection layer 2</td><td colspan="2">LiF</td><td>1</td></tr>
<tr><td>Electron transport layer 2</td><td colspan="2">ET1</td><td>20</td></tr>
<tr><td>Hole-blocking layer 2</td><td colspan="2">ET12</td><td>26</td></tr>
<tr><td rowspan="3">Second light-emitting layer</td><td>EM1</td><td rowspan="3">Waight ratio EM1 : GD6 : RD1 = 97.6 : 2 : 0.4</td><td rowspan="3">20</td></tr>
<tr><td>GD6</td></tr>
<tr><td>RD1</td></tr>
<tr><td>Electron-blocking layer 2</td><td colspan="2">HT7</td><td>10</td></tr>
<tr><td rowspan="6">Charge generation portion</td><td>Hole transport layer 2</td><td colspan="2">HT2</td><td>25</td></tr>
<tr><td>Hole injection layer 2</td><td colspan="2">HT16</td><td>8</td></tr>
<tr><td rowspan="3">Electron injection layer 1 [n-type charge generation layer]</td><td>ET1</td><td rowspan="3">Waight ratio ET1 : A3 : $Cs_2CO_3$ = 70 : 29 : 1</td><td rowspan="3">10</td></tr>
<tr><td>A3</td></tr>
<tr><td>$Cs_2CO_3$</td></tr>
<tr><td>Electron transport layer 1</td><td colspan="2">ET1</td><td>20</td></tr>
<tr><td rowspan="6">Light-emitting unit 1</td><td>Hole-blocking layer 1</td><td colspan="2">ET12</td><td>33</td></tr>
<tr><td rowspan="2">First light-emitting layer</td><td>EM1</td><td rowspan="2">Waight ratio EM1 : BD7 = 99 : 1</td><td rowspan="2">20</td></tr>
<tr><td>BD7</td></tr>
<tr><td>Electron-blocking layer 1</td><td colspan="2">HT7</td><td>10</td></tr>
<tr><td>Hole transport layer 1</td><td colspan="2">HT2</td><td>25</td></tr>
<tr><td>Hole injection layer 1</td><td colspan="2">HT16</td><td>7</td></tr>
</table>

[Exemplary Embodiments 2 to 26 and Comparative Example 1]

An organic light-emitting element was produced in the same manner as in Exemplary Embodiment 1 except that the second organic compound and the alkali metal were changed to the compounds shown in Table 7.

The voltage-current characteristics were measured with a microammeter 4140B manufactured by Hewlett-Packard Co., and an emission spectrum was obtained with "SR-3" manufactured by Topcon Corporation. The organic light-emitting element of Exemplary Embodiment 1 had good white-light emission.

The operation test of the produced organic light-emitting element was performed at a constant current of 50 $mA/cm^2$ to measure LT80 at which the luminance was decreased by 20% from the initial luminance and the drive voltage. Table 7 shows the results. The voltage ratio and the durability ratio are values relative to the voltage and LT80 of Comparative Example 1, which are assumed to be 1.0.

Table 7

| Exemplary embodiment | First organic compound | Second organic compound | Alkali metal atom | Voltage ratio | Durability ratio |
|---|---|---|---|---|---|
| Exemplary embodiment 1 | ET1 | A3 | Cs | 0.8 | 1.5 |
| Exemplary embodiment 2 | ET1 | A6 | Cs | 0.9 | 1.5 |
| Exemplary embodiment 3 | ET1 | A7 | Cs | 1.0 | 1.3 |
| Exemplary embodiment 4 | ET1 | A5 | Cs | 0.9 | 1.5 |
| Exemplary embodiment 5 | ET1 | B3 | Cs | 0.9 | 1.3 |
| Exemplary embodiment 6 | ET1 | A6 | Li | 0.9 | 1.5 |
| Exemplary embodiment 7 | ET1 | A5 | Li | 0.9 | 1.5 |

(continued)

| Exemplary embodiment | First organic compound | Second organic compound | Alkali metal atom | Voltage ratio | Durability ratio |
|---|---|---|---|---|---|
| Exemplary embodiment 8 | ET1 | AA22 | Cs | 0.9 | 1.4 |
| Exemplary embodiment 9 | ET1 | AA39 | Cs | 0.8 | 1.4 |
| Exemplary embodiment 10 | ET1 | BB8 | Cs | 0.7 | 1.4 |
| Exemplary embodiment 11 | ET1 | CC10 | Cs | 0.8 | 1.3 |
| Exemplary embodiment 12 | ET1 | AA22 | Li | 0.9 | 1.4 |
| Exemplary embodiment 13 | ET1 | AA39 | Li | 0.8 | 1.4 |
| Exemplary embodiment 14 | ET1 | EE1 | Cs | 0.9 | 1.4 |
| Exemplary embodiment 15 | ET1 | EE4 | Cs | 0.9 | 1.5 |
| Exemplary embodiment 16 | ET1 | EM27 | Cs | 0.8 | 1.3 |
| Exemplary embodiment 17 | ET2 | FF2 | Cs | 0.9 | 1.4 |
| Exemplary embodiment 18 | ET1 | FF3 | Li | 0.9 | 1.5 |
| Exemplary embodiment 19 | ET2 | GG1 | Li | 0.8 | 1.4 |
| Exemplary embodiment 20 | ET1 | GG7 | Cs | 0.8 | 1.3 |
| Exemplary embodiment 21 | ET2 | HH2 | Cs | 0.8 | 1.4 |
| Exemplary embodiment 22 | ET1 | EM17 | Li | 0.9 | 1.5 |
| Exemplary embodiment 23 | ET2 | JJ3 | Cs | 0.9 | 1.3 |
| Exemplary embodiment 24 | ET1 | JJ6 | Cs | 0.9 | 1.3 |
| Exemplary embodiment 25 | HT1 | A3 | Cs | 1.1 | 1.1 |
| Exemplary embodiment 26 | HT2 | A3 | Cs | 1.0 | 1.1 |
| Comparative example 1 | ET1 | 1-a | Cs | 1.0 | 1.0 |
| Comparative example 2 | HT1 | 1-a | Cs | 1.3 | 0.8 |
| Comparative example 3 | HT2 | 1-a | Cs | 1.2 | 0.8 |

Table 7 shows that the second organic compound with a fused polycyclic hydrocarbon skeleton mixed in the n-type charge generation layer as in Exemplary Embodiments 1 to 26 suppresses alkali metal diffusion and improves stability to holes. This could reduce the degradation of the electron injection properties of the n-type charge generation layer and improved the durability. Furthermore, even when the second organic compound was a hydrocarbon compound with a fused polycyclic hydrocarbon skeleton, the durability was similarly improved.

The organic light-emitting elements of Exemplary Embodiments 1 to 7 have particularly high durability because the second organic compound is an organic compound represented by the general formula [1-1]. Furthermore, the organic light-emitting elements of Exemplary Embodiments 8 to 24 have a particularly low voltage because the second organic compound is an organic compound represented by any one of the general formulae [1-2] to [1-10].

Furthermore, the organic light-emitting elements of Exemplary Embodiments 1 to 24, in which the first organic compound was an organic compound with a phenanthroline skeleton, had a particularly lower voltage ratio and a particularly higher durability ratio than Exemplary Embodiments 25 and 26 in which the first organic compound did not have a phenanthroline skeleton. Thus, in an organic light-emitting element according to the present disclosure, the first organic compound can have a phenanthroline skeleton.

In contrast, in Comparative Examples 1 to 3, the second organic compound to be mixed is not a fused polycyclic hydrocarbon compound, thus resulting in a small effect of suppressing alkali metal diffusion and low stability to holes. Thus, the organic light-emitting elements of Comparative Examples 1 to 3 have a high voltage and low durability.

As described above, an organic light-emitting element according to the present disclosure has a lower voltage and high durability.

The present disclosure is as defined in the independent claims. Further beneficial embodiments are defined in the dependent claims.

## Claims

1. An organic light-emitting element comprising:

a first electrode (200);
a first light-emitting unit (300);
a charge generation portion (400);
a second light-emitting unit (500); and
a second electrode (600) in this order,
wherein the charge generation portion includes at least one n-type charge generation layer, and
the n-type charge generation layer contains at least a first organic compound and a second organic compound;

**characterized in that**

the second organic compound is represented by any one of formulae [1-1] to [1-10]:

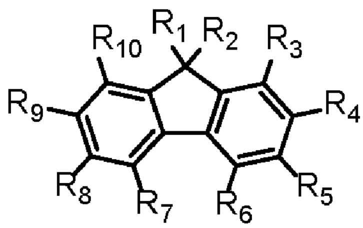

[1-1]

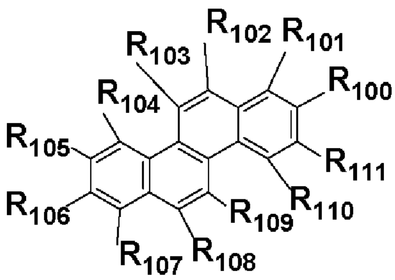

[1-2]

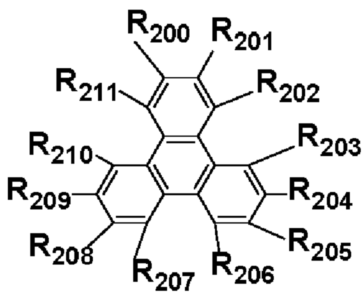

[1-3]

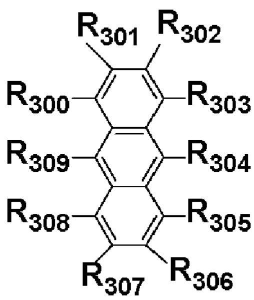

[1-4]

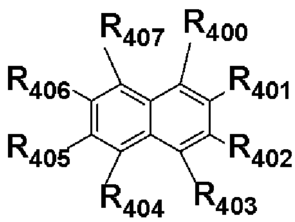

[1-5]

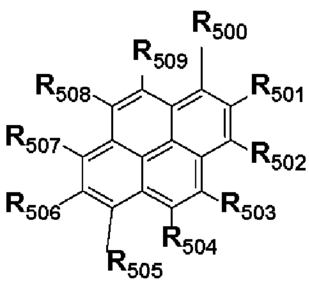

[1-6]

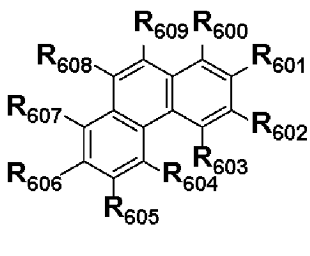

[1-7]

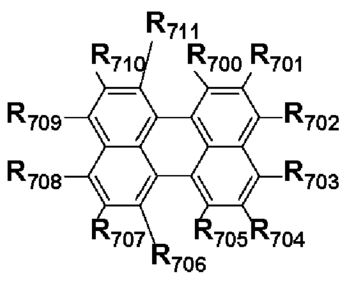

[1-8]

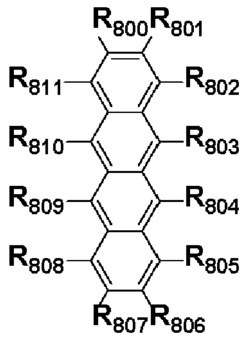

[1 − 9]

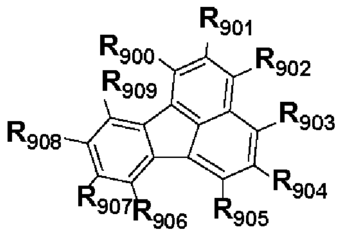

[1 − 1 0]

wherein $R_1$ to $R_{909}$ are each independently selected from the group consisting of a hydrogen atom, a deuterium atom, a halogen atom, a substituted or unsubstituted alkyl group, a substituted or unsubstituted alkoxy group, a substituted or unsubstituted aryl group, and a substituted or unsubstituted silyl group.

**2.** The organic light-emitting element according to Claim 1, wherein the second organic compound is represented by any one of the formulae [1-1] to [1-5].

**3.** The organic light-emitting element according to Claim 1, wherein the second organic compound is represented by the formula [1-1].

**4.** The organic light-emitting element according to Claim 1, wherein the second organic compound is represented by the formula [1-2].

**5.** The organic light-emitting element according to Claim 1, wherein the second organic compound is represented by the formula [1-3].

**6.** The organic light-emitting element according to Claim 1, wherein the second organic compound is represented by the formula [1-4].

**7.** The organic light-emitting element according to Claim 1, wherein the second organic compound is represented by the formula [1-5].

**8.** The organic light-emitting element according to Claim 1, wherein the second organic compound is represented by the formula [1-6].

**9.** The organic light-emitting element according to Claim 1, wherein the second organic compound is represented by the formula [1-7].

**10.** The organic light-emitting element according to Claim 1, wherein the second organic compound is represented by the formula [1-8].

**11.** The organic light-emitting element according to Claim 1, wherein the second organic compound is represented by the formula [1-9].

**12.** The organic light-emitting element according to Claim 1, wherein the second organic compound is represented by the formula [1-10].

**13.** An organic light-emitting element comprising:

a first electrode (200);
a first light-emitting unit (300);
a charge generation portion (400);
a second light-emitting unit (500); and
a second electrode (600) in this order,
wherein the charge generation portion includes at least one n-type charge generation layer, and

the n-type charge generation layer contains at least a first organic compound and a second organic compound;

**characterized in that**
the second organic compound is a hydrocarbon compound with a fused polycyclic hydrocarbon skeleton.

**14.** The organic light-emitting element according to Claim 13, wherein the second organic compound is represented by any one of formulae [1-1] to [1-10]:

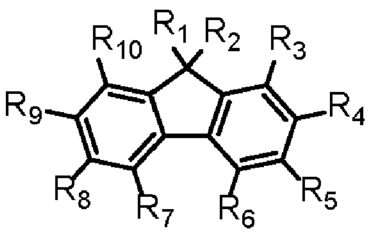

[1 − 1]

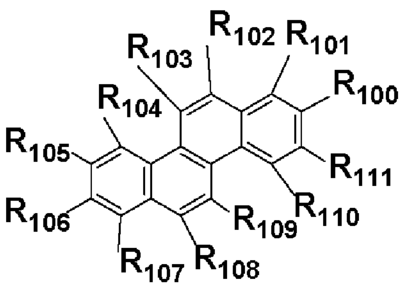

[1 − 2]

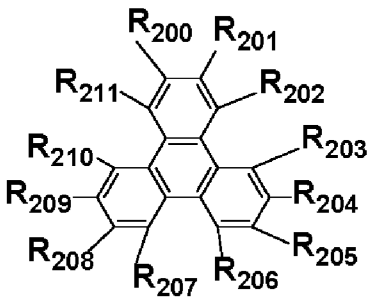

[1 − 3]

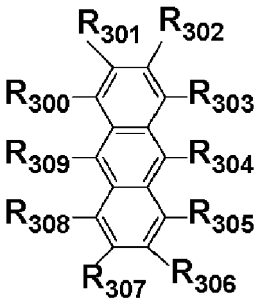

[1 − 4]

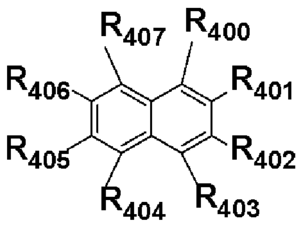

[1 − 5]

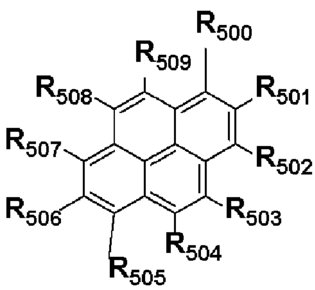

[1 − 6]

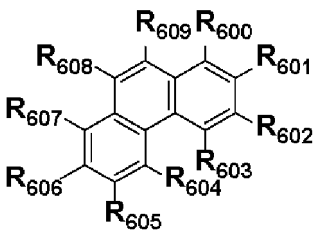

[1 − 7]

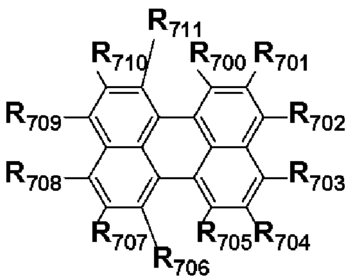

[1 − 8]

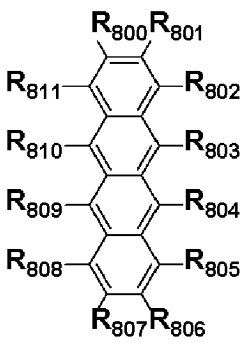

[1 − 9]

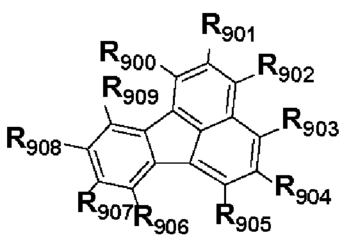

[1 − 1 0]

wherein $R_1$ to $R_{909}$ are each independently selected from the group consisting of a hydrogen atom, a deuterium atom, a substituted or unsubstituted alkyl group, and a substituted or unsubstituted aryl group.

**15.** The organic light-emitting element according to any one of Claims 1 to 12, wherein $R_1$ to $R_{909}$ in the formulae [1-1] to [1-10] are each independently selected from the group consisting of a hydrogen atom, a deuterium atom, a substituted or unsubstituted alkyl group, and a substituted or unsubstituted aryl group.

**16.** The organic light-emitting element according to any one of Claims 1 to 15, wherein the n-type charge generation layer further has an alkali metal atom or an alkaline-earth metal atom.

**17.** A display apparatus comprising a plurality of pixels, wherein at least one of the plurality of pixels includes the organic light-emitting element according to any one of Claims 1 to 16 and a transistor coupled to the organic light-emitting element.

**18.** A display apparatus comprising:

a display unit (1302) including the organic light-emitting element according to any one of Claims 1 to 16; and
a housing (1313) configured to be provided with the display unit.

**19.** A photoelectric conversion apparatus comprising:

an imaging element configured to receive light; and
a display unit configured to display an image taken by the imaging element,
wherein the display unit includes the organic light-emitting element according to any one of Claims 1 to 16.

**20.** Electronic equipment comprising:

a display unit (1201) including the organic light-emitting element according to any one of Claims 1 to 16;
a housing (1203) configured to be provided with the display unit; and
a communication unit provided in the housing and configured to communicate with an outside.

**21.** A wearable device comprising:

a display unit including the organic light-emitting element according to any one of Claims 1 to 16;
an optical system configured to collect light of the display unit; and
a controller configured to control display of the display unit.

**22.** A lighting apparatus comprising:

a light source (1402) including the organic light-emitting element according to any one of Claims 1 to 16; and
a housing (1401) configured to be provided with the light source.

**23.** A moving body comprising:

a lamp (1501) including the organic light-emitting element according to any one of Claims 1 to 16; and
a body (1503) configured to be provided with the lamp.

**24.** An image-forming apparatus comprising:

a photosensitive member (27); and
an exposure light source (28) configured to expose the photosensitive member,
wherein the exposure light source includes the organic light-emitting element according to any one of Claims 1 to 16.

**Patentansprüche**

**1.** Organisches lichtemittierendes Element, umfassend:

eine erste Elektrode (200);
eine erste lichtemittierende Einheit (300);
einen ladungserzeugenden Abschnitt (400);
eine zweite lichtemittierende Einheit (500); und
eine zweite Elektrode (600) in dieser Reihenfolge,
wobei der ladungserzeugende Abschnitt mindestens eine ladungserzeugende Schicht vom n-Typ beinhaltet, und
die ladungserzeugende Schicht vom n-Typ mindestens eine erste organische Verbindung und eine zweite organische Verbindung enthält;

**dadurch gekennzeichnet, dass**

die zweite organische Verbindung durch eine der Formeln [1-1] bis [1-10] dargestellt ist:

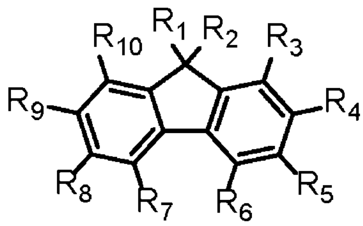
[1 - 1]

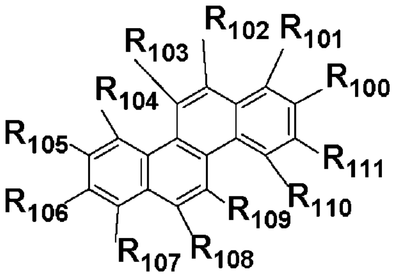
[1 - 2]

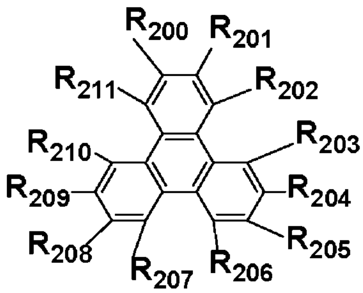
[1 - 3]

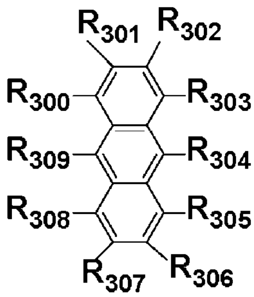
[1 - 4]

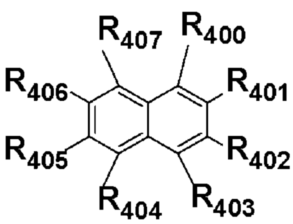
[1 - 5]

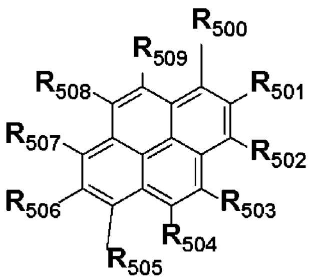
[1 - 6]

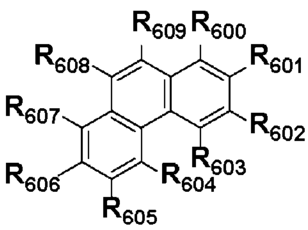
[1 - 7]

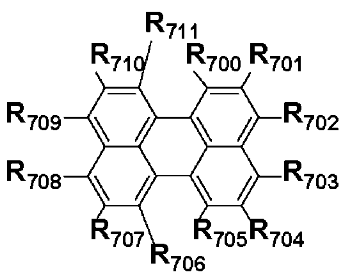
[1 - 8]

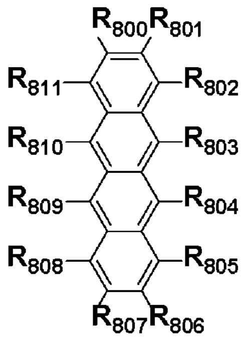

[1-9]

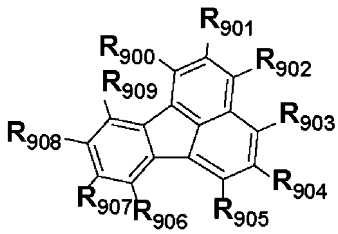

[1-10]

wobei $R_1$ bis $R_{909}$ jeweils unabhängig aus der Gruppe bestehend aus einem Wasserstoffatom, einem Deuteriumatom, einem Halogenatom, einer substituierten oder unsubstituierten Alkylgruppe, einer substituierten oder unsubstituierten Alkoxygruppe, einer substituierten oder unsubstituierten Arylgruppe und einer substituierten oder unsubstituierten Silylgruppe, ausgewählt sind.

2. Organisches lichtemittierendes Element nach Anspruch 1, wobei die zweite organische Verbindung durch eine der Formeln [1-1] bis [1-5] dargestellt ist.

3. Organisches lichtemittierendes Element nach Anspruch 1, wobei die zweite organische Verbindung durch die Formel [1-1] dargestellt ist.

4. Organisches lichtemittierendes Element nach Anspruch 1, wobei die zweite organische Verbindung durch die Formel [1-2] dargestellt ist.

5. Organisches lichtemittierendes Element nach Anspruch 1, wobei die zweite organische Verbindung durch die Formel [1-3] dargestellt ist.

6. Organisches lichtemittierendes Element nach Anspruch 1, wobei die zweite organische Verbindung durch die Formel [1-4] dargestellt ist.

7. Organisches lichtemittierendes Element nach Anspruch 1, wobei die zweite organische Verbindung durch die Formel [1-5] dargestellt ist.

8. Organisches lichtemittierendes Element nach Anspruch 1, wobei die zweite organische Verbindung durch die Formel [1-6] dargestellt ist.

9. Organisches lichtemittierendes Element nach Anspruch 1, wobei die zweite organische Verbindung durch die Formel [1-7] dargestellt ist.

10. Organisches lichtemittierendes Element nach Anspruch 1, wobei die zweite organische Verbindung durch die Formel [1-8] dargestellt ist.

11. Organisches lichtemittierendes Element nach Anspruch 1, wobei die zweite organische Verbindung durch die Formel [1-9] dargestellt ist.

12. Organisches lichtemittierendes Element nach Anspruch 1, wobei die zweite organische Verbindung durch die Formel [1-10] dargestellt ist.

13. Organisches lichtemittierendes Element, umfassend:

eine erste Elektrode (200);
eine erste lichtemittierende Einheit (300);
einen ladungserzeugenden Abschnitt (400);
eine zweite lichtemittierende Einheit (500); und
eine zweite Elektrode (600) in dieser Reihenfolge,

wobei der ladungserzeugende Abschnitt mindestens eine ladungserzeugende Schicht vom n-Typ beinhaltet, und

die ladungserzeugende Schicht vom n-Typ mindestens eine erste organische Verbindung und eine zweite organische Verbindung enthält;

**dadurch gekennzeichnet, dass**

die zweite organische Verbindung eine Kohlenwasserstoffverbindung mit einem kondensierten polyzyklischen Kohlenwasserstoffgerüst ist.

**14.** Organisches lichtemittierendes Element nach Anspruch 13, wobei die zweite organische Verbindung durch eine der Formeln [1-1] bis [1-10] dargestellt ist:

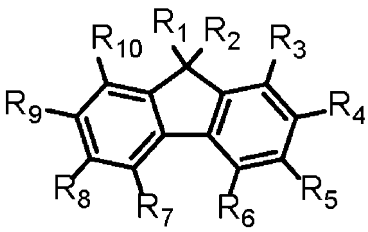

[1 − 1]

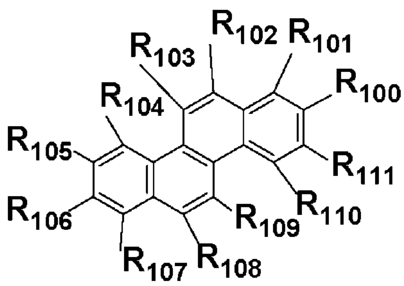

[1 − 2]

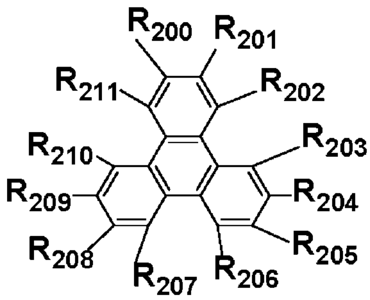

[1 − 3]

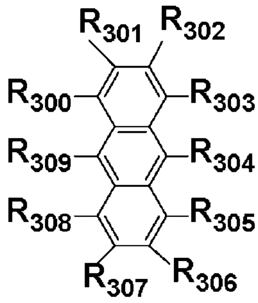

[1 − 4]

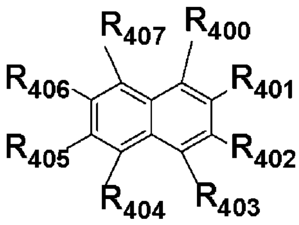

[1 − 5]

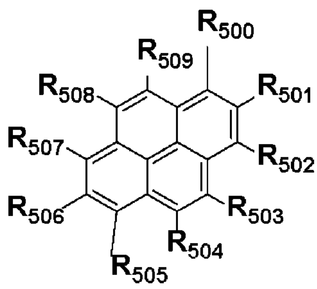

[1 − 6]

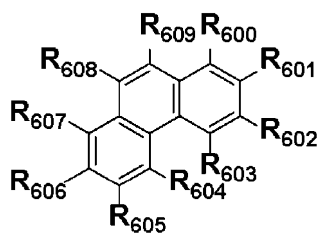

[1 − 7]

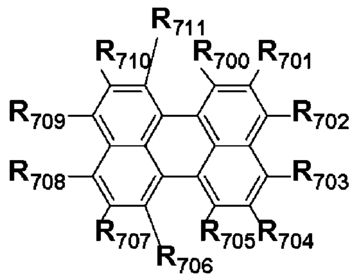

[1 − 8]

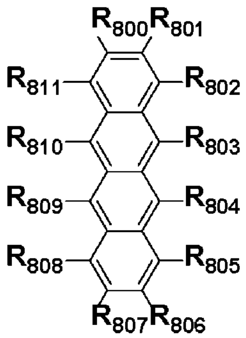

[1 − 9]

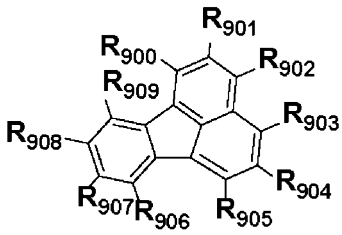

[1 − 1 0]

wobei $R_1$ bis $R_{909}$ jeweils unabhängig aus der Gruppe bestehend aus einem Wasserstoffatom, einem Deuteriumatom, einer substituierten oder unsubstituierten Alkylgruppe und einer substituierten oder unsubstituierten Arylgruppe ausgewählt sind.

**15.** Organisches lichtemittierendes Element nach einem der Ansprüche 1 bis 12, wobei $R_1$ bis $R_{909}$ in den Formeln [1-1] bis [1-10] jeweils unabhängig aus der Gruppe bestehend aus einem Wasserstoffatom, einem Deuteriumatom, einer substituierten oder unsubstituierten Alkylgruppe und einer substituierten oder unsubstituierten Arylgruppe ausgewählt sind.

**16.** Organisches lichtemittierendes Element nach einem der Ansprüche 1 bis 15, wobei die ladungserzeugende Schicht vom n-Typ ferner ein Alkalimetallatom oder ein Erdalkalimetallatom aufweist.

**17.** Anzeigevorrichtung, die eine Vielzahl von Pixeln umfasst, wobei mindestens eines der Vielzahl von Pixeln das organische lichtemittierende Element nach einem der Ansprüche 1 bis 16 und einen mit dem organischen lichtemittierenden Element gekoppelten Transistor beinhaltet.

**18.** Anzeigevorrichtung, umfassend:

eine Anzeigeeinheit (1302), die das organische lichtemittierende Element nach einem der Ansprüche 1 bis 16 beinhaltet; und
ein Gehäuse (1313), das konfiguriert ist mit der Anzeigeeinheit versehen werden zu können.

**19.** Fotoelektrische Umwandlungsvorrichtung, umfassend:

ein Bildgebungselement, das konfiguriert ist Licht zu empfangen; und
eine Anzeigeeinheit, die konfiguriert ist ein vom Bildgebungselement aufgenommenes Bild anzuzeigen,
wobei die Anzeigeeinheit das organische lichtemittierendes Element nach einem der Ansprüche 1 bis 16 beinhaltet.

**20.** Elektronische Ausrüstung, umfassend:

eine Anzeigeeinheit (1201), die das organische lichtemittierende Element nach einem der Ansprüche 1 bis 16 beinhaltet;
ein Gehäuse (1203), das konfiguriert ist mit der Anzeigeeinheit versehen werden zu können; und
eine Kommunikationseinheit, die im Gehäuse bereitgestellt ist und konfiguriert ist mit einer Außenwelt zu kommunizieren.

**21.** Tragbares Gerät, umfassend:

eine Anzeigeeinheit, die das organische lichtemittierende Element nach einem der Ansprüche 1 bis 16 beinhaltet;
ein optisches System, das konfiguriert ist Licht der Anzeigeeinheit zu sammeln; und
eine Steuereinheit, die konfiguriert ist die Anzeige der Anzeigeeinheit zu steuern.

**22.** Beleuchtungsvorrichtung, umfassend:

eine Lichtquelle (1402), die das organische lichtemittierende Element nach einem der Ansprüche 1 bis 16 beinhaltet; und
ein Gehäuse (1401), das konfiguriert ist mit der Lichtquelle versehen werden zu können.

**23.** Beweglicher Körper, umfassend:

eine Lampe (1501), die das organische lichtemittierende Element nach einem der Ansprüche 1 bis 16 beinhaltet; und
einen Körper (1503), der konfiguriert ist mit der Lampe versehen werden zu können.

**24.** Bilderzeugende Vorrichtung, umfassend:

ein lichtempfindliches Element (27); und
eine Belichtungslichtquelle (28), die konfiguriert ist das lichtempfindliche Element zu belichten,
wobei die Belichtungslichtquelle das organische lichtemittierende Element nach einem der Ansprüche 1 bis 16 beinhaltet.

## Revendications

**1.** Élément organique émetteur de lumière comprenant :

une première électrode (200) ;
une première unité émettrice de lumière (300) ;
une partie génération de charge (400) ;
une seconde unité émettrice de lumière (500) ; et
une seconde électrode (600) dans cet ordre,
dans lequel la partie génération de charge comprend au moins une couche de génération de charge de type n, et la couche de génération de charge de type n contient au moins un premier composé organique et un second composé organique ;
**caractérisé en ce que**
le second composé organique est représenté par l'une quelconque des formules [1-1] à [1-10] :

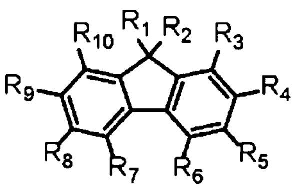

[1-1]

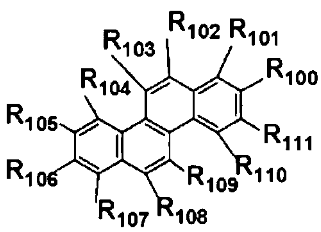

[1-2]

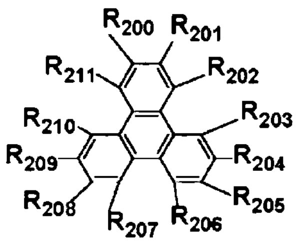

[1-3]

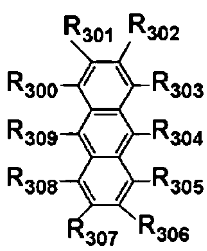

[1-4]

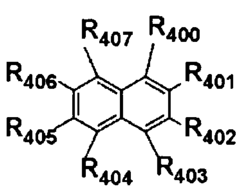

[1-5]

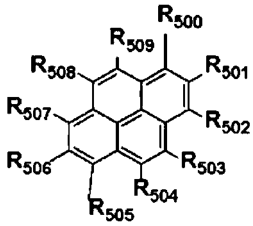

[1 - 6]

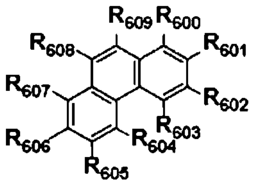

[1 - 7]

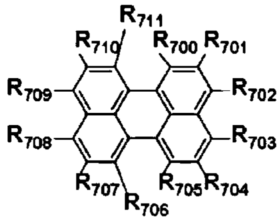

[1 - 8]

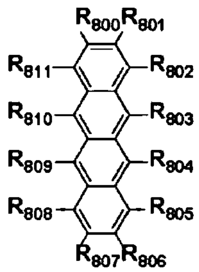

[1 - 9]

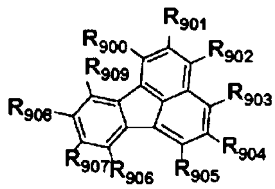

[1 - 10]

dans lequel $R_1$ à $R_{909}$ sont sélectionnés chacun indépendamment dans le groupe consistant en un atome d'hydrogène, un atome de deutérium, un atome halogène, un groupe alkyle substitué ou non substitué, un groupe alcoxy substitué ou non substitué, un groupe aryle substitué ou non substitué, et un groupe silyle substitué ou non substitué.

**2.** Élément organique émetteur de lumière selon la revendication 1, dans lequel le second composé organique est représenté par l'une quelconque des formules [1-1] à [1-5].

**3.** Élément organique émetteur de lumière selon la revendication 1, dans lequel le second composé organique est représenté par la formule [1-1].

**4.** Élément organique émetteur de lumière selon la revendication 1, dans lequel le second composé organique est représenté par la formule [1-2].

**5.** Élément organique émetteur de lumière selon la revendication 1, dans lequel le second composé organique est représenté par la formule [1-3].

**6.** Élément organique émetteur de lumière selon la revendication 1, dans lequel le second composé organique est représenté par la formule [1-4].

**7.** Élément organique émetteur de lumière selon la revendication 1, dans lequel le second composé organique est représenté par la formule [1-5].

**8.** Élément organique émetteur de lumière selon la revendication 1, dans lequel le second composé organique est représenté par la formule [1-6].

**9.** Élément organique émetteur de lumière selon la revendication 1, dans lequel le second composé organique est représenté par la formule [1-7].

**10.** Élément organique émetteur de lumière selon la revendication 1, dans lequel le second composé organique est représenté par la formule [1-8].

**11.** Élément organique émetteur de lumière selon la revendication 1, dans lequel le second composé organique est représenté par la formule [1-9].

**12.** Élément organique émetteur de lumière selon la revendication 1, dans lequel le second composé organique est représenté par la formule [1-10].

**13.** Élément organique émetteur de lumière comprenant :

une première électrode (200) ;
une première unité émettrice de lumière (300) ;
une partie génération de charge (400) ;
une seconde unité émettrice de lumière (500) ; et
une seconde électrode (600) dans cet ordre,
dans lequel la partie génération de charge comprend au moins une couche de génération de charge de type n, et la couche de génération de charge de type n contient au moins un premier composé organique et un second composé organique ;
**caractérisé en ce que**
le second composé organique est un composé hydrocarboné à squelette hydrocarboné polycyclique condensé.

**14.** Élément organique émetteur de lumière selon la revendication 13, dans lequel le second composé organique est représenté par l'une quelconque des formules [1-1] à [1-10] :

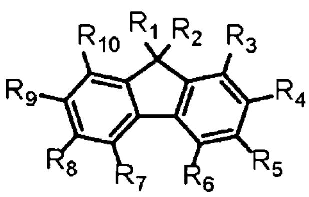
[1 − 1]

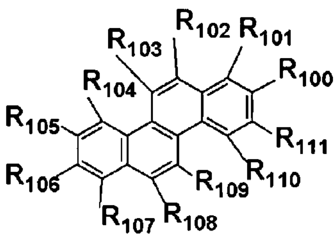
[1 − 2]

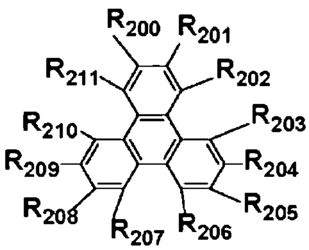
[1 − 3]

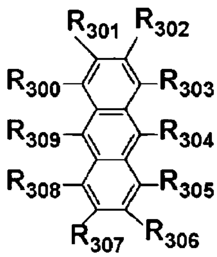
[1 − 4]

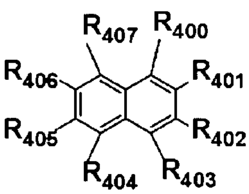
[1 − 5]

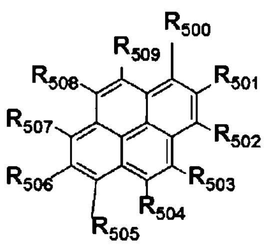
[1 − 6]

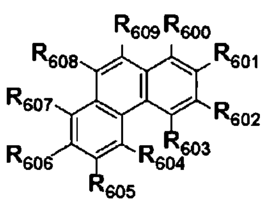
[1 − 7]

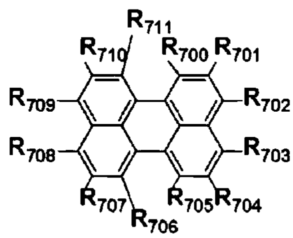
[1 − 8]

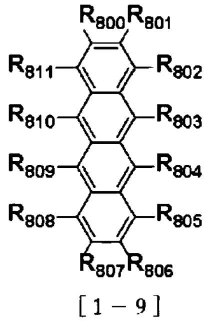
[1 − 9]

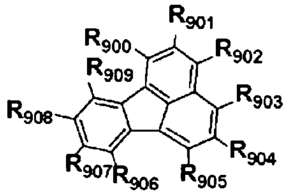
[1 − 1 0]

dans lequel $R_1$ à $R_{909}$ sont sélectionnés chacun indépendamment dans le groupe consistant en un atome d'hydrogène, un atome de deutérium, un groupe alkyle substitué ou non substitué et un groupe aryle substitué ou non substitué.

**15.** Élément organique émetteur de lumière selon l'une quelconque des revendications 1 à 12, dans lequel $R_1$ à $R_{909}$ dans les formules [1-1] à [1-10] sont sélectionnés chacun indépendamment dans le groupe consistant en un atome d'hydrogène, un atome de deutérium, un groupe alkyle substitué ou non substitué et un groupe aryle substitué ou non substitué.

**16.** Élément organique émetteur de lumière selon l'une quelconque des revendications 1 à 15, dans lequel la couche de génération de charge de type n présente en outre un atome de métal alcalin ou un atome de métal alcalinoterreux.

**17.** Appareil d'affichage comprenant une pluralité de pixels, dans lequel au moins l'un de la pluralité de pixels comprend l'élément organique émetteur de lumière selon l'une quelconque des revendications 1 à 16 et un transistor couplé à l'élément organique émetteur de lumière.

**18.** Appareil d'affichage comprenant :

une unité d'affichage (1302) comprenant l'élément organique émetteur de lumière selon l'une quelconque des revendications 1 à 16 ; et
un boîtier (1313) configuré pour comprendre l'unité d'affichage.

**19.** Appareil de conversion photoélectrique comprenant :

un élément d'imagerie configuré pour recevoir une lumière ; et
une unité d'affichage configurée pour afficher une image prise par l'élément d'imagerie,
dans lequel l'unité d'affichage comprend l'élément organique émetteur de lumière selon l'une quelconque des revendications 1 à 16.

**20.** Équipement électronique comprenant :

une unité d'affichage (1201) comprenant l'élément organique émetteur de lumière selon l'une quelconque des revendications 1 à 16 ;
un boîtier (1203) configuré pour comprendre l'unité d'affichage ; et
une unité de communication fournie dans le boîtier et configurée pour communiquer avec l'extérieur.

**21.** Dispositif portable comprenant :

une unité d'affichage comprenant l'élément organique émetteur de lumière selon l'une quelconque des revendications 1 à 16 ;
un système optique configuré pour collecter la lumière de l'unité d'affichage ; et
un dispositif de commande configuré pour commander l'affichage de l'unité d'affichage.

**22.** Appareil d'éclairage comprenant :

une source de lumière (1402) comprenant l'élément organique émetteur de lumière selon l'une quelconque des revendications 1 à 16 ; et
un boîtier (1401) configuré pour comprendre la source de lumière.

**23.** Corps mobile comprenant :

une lampe (1501) comprenant l'élément organique émetteur de lumière selon l'une quelconque des revendications 1 à 16 ; et
un corps (1503) configuré pour comprendre la lampe.

**24.** Appareil de formation d'image comprenant :

un organe photosensible (27) ; et

une source de lumière d’exposition (28) configurée pour exposer l’organe photosensible,
dans lequel la source de lumière d’exposition comprend l’élément organique émetteur de lumière selon l’une quelconque des revendications 1 à 16.

FIG. 1

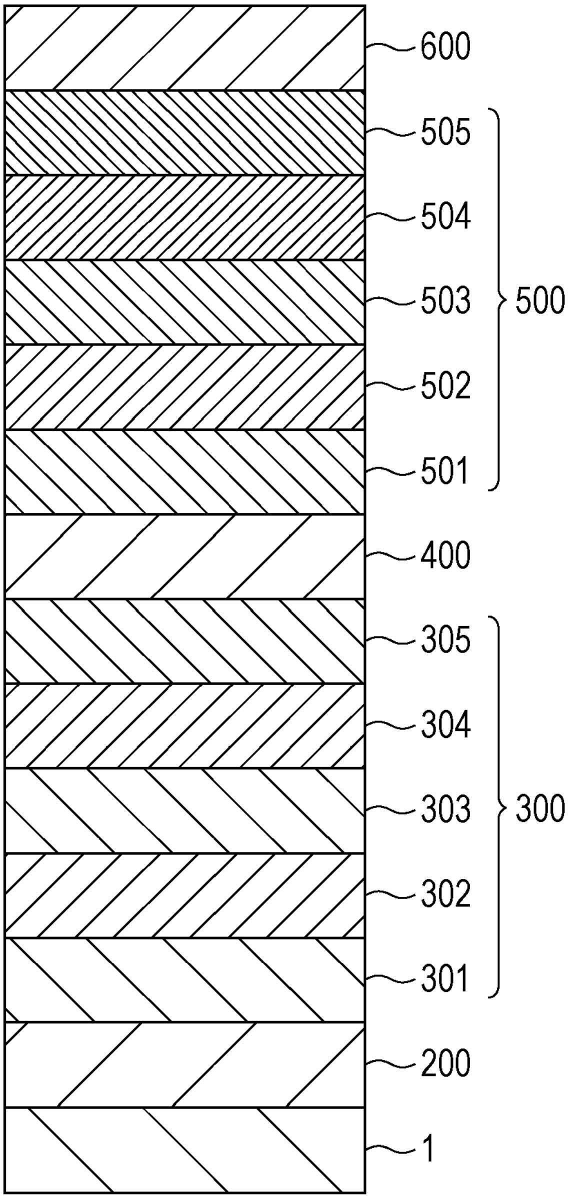

FIG. 2A

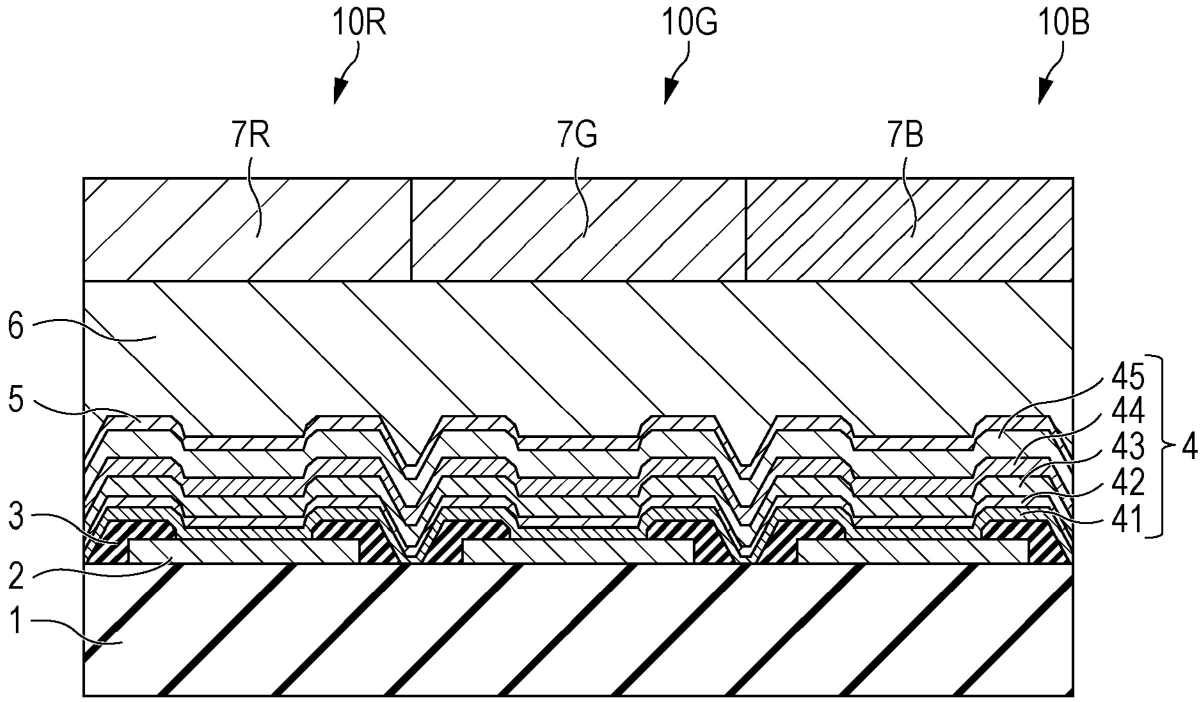
10R
10G
10B
7R
7G
7B
6
5
3
2
1
45
44
43
42
41
4

FIG. 2B

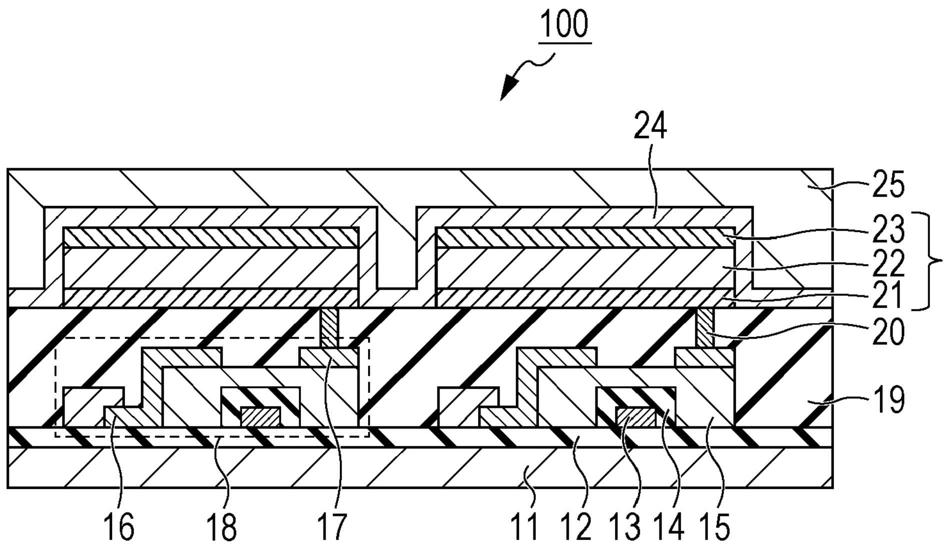
100
24
25
23
22
21
26
20
19
16
18
17
11
12
13
14
15

FIG. 3

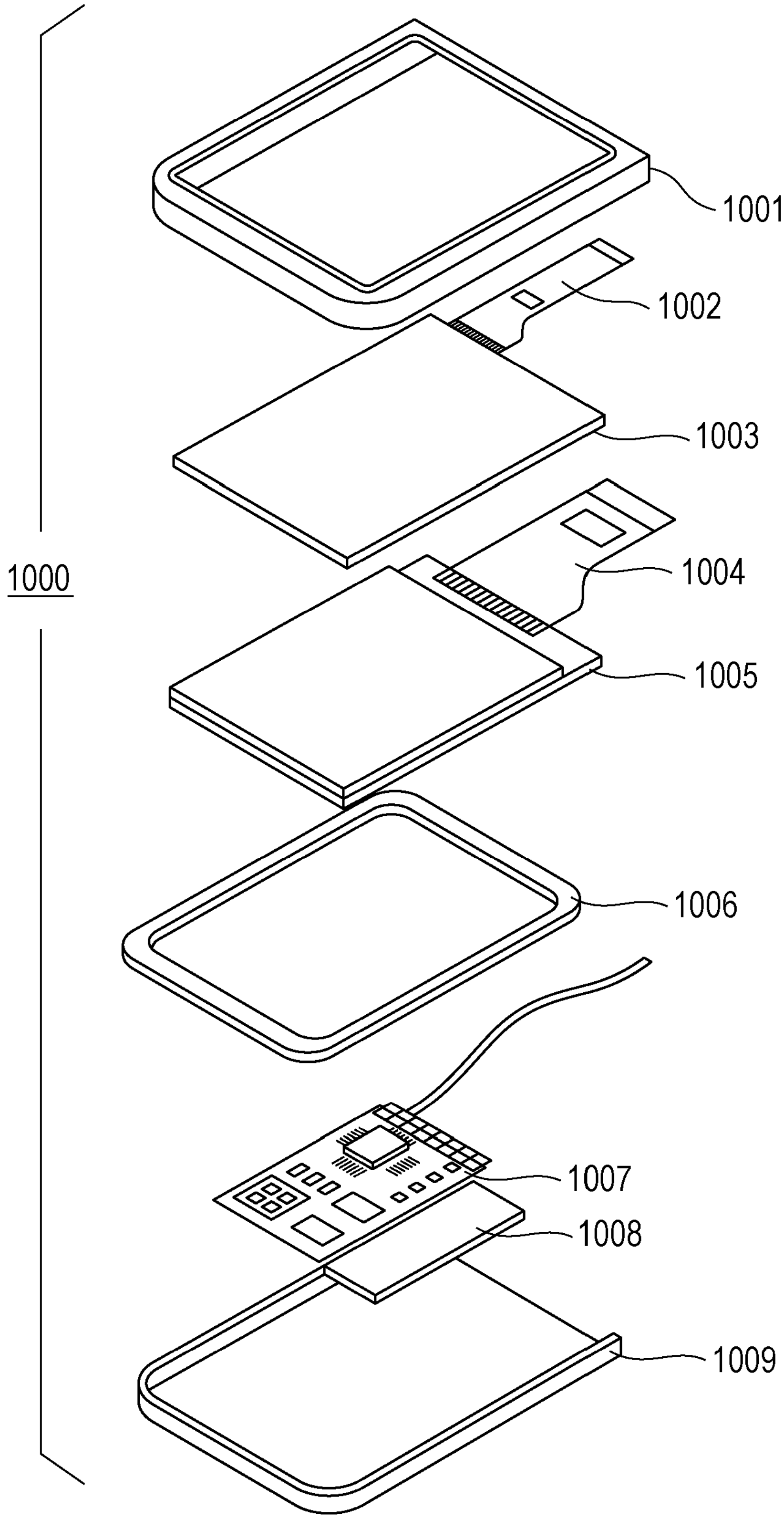

FIG. 4A

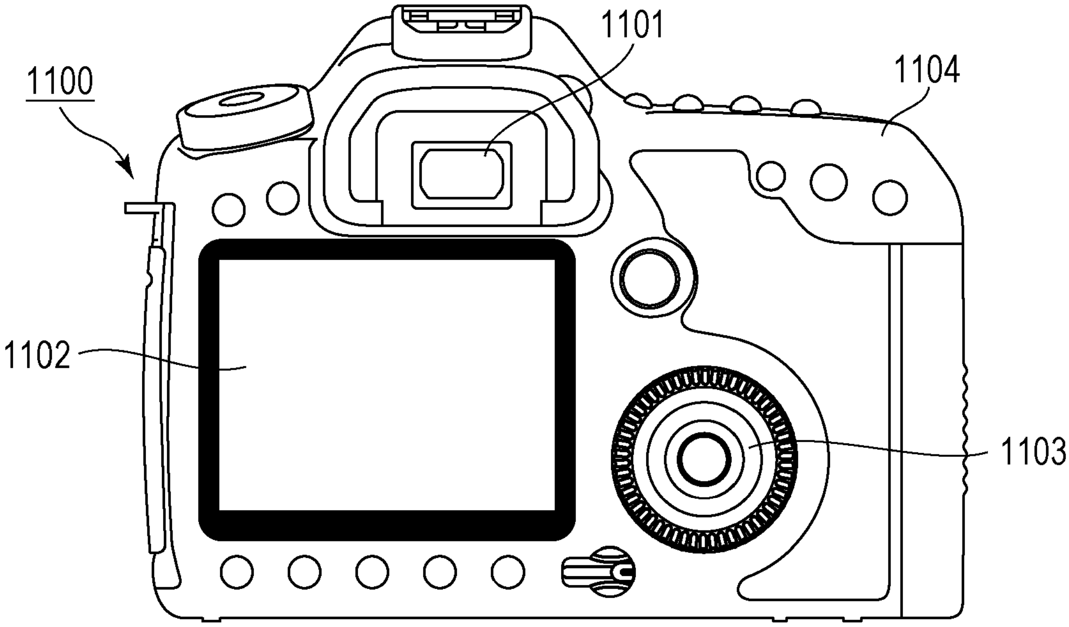


FIG. 4B

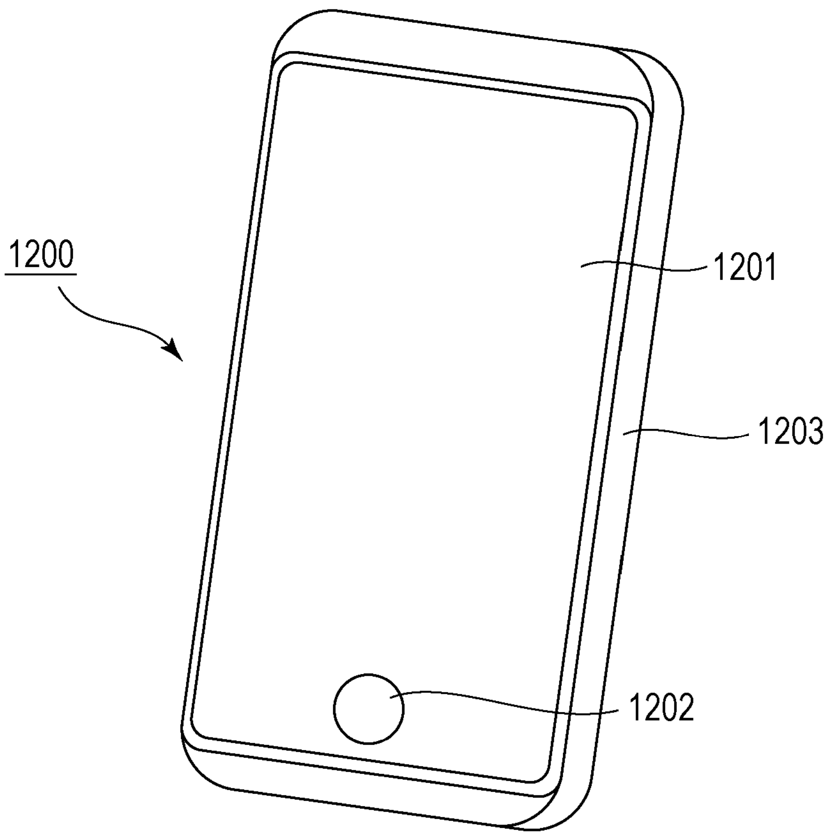

FIG. 5A

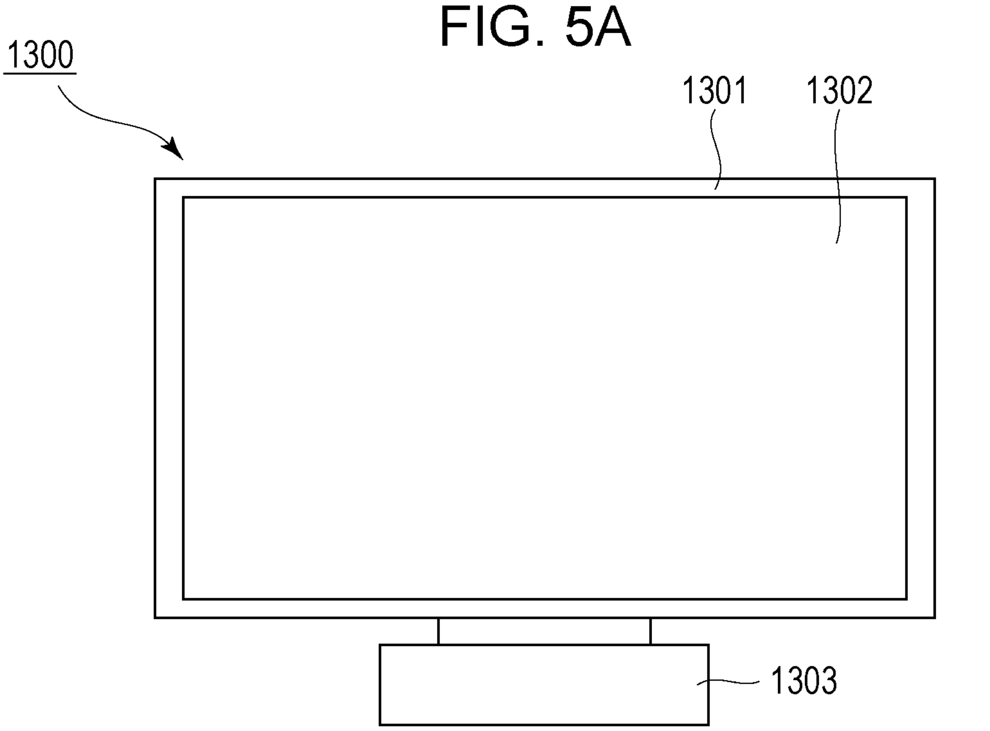


FIG. 5B

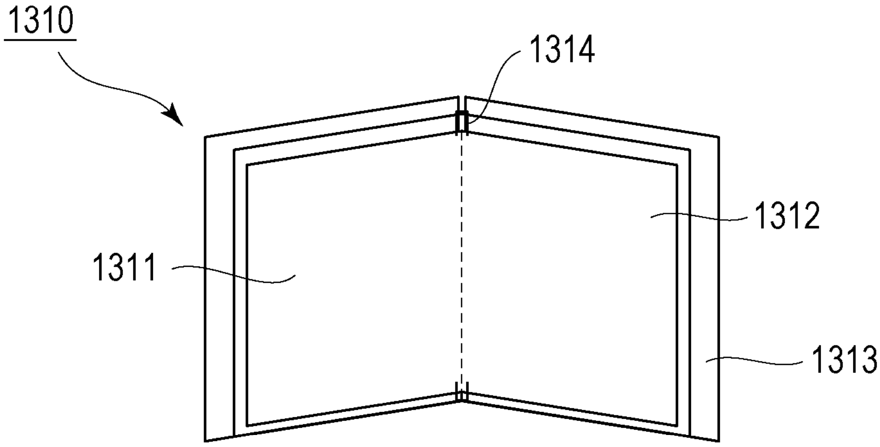

FIG. 6A

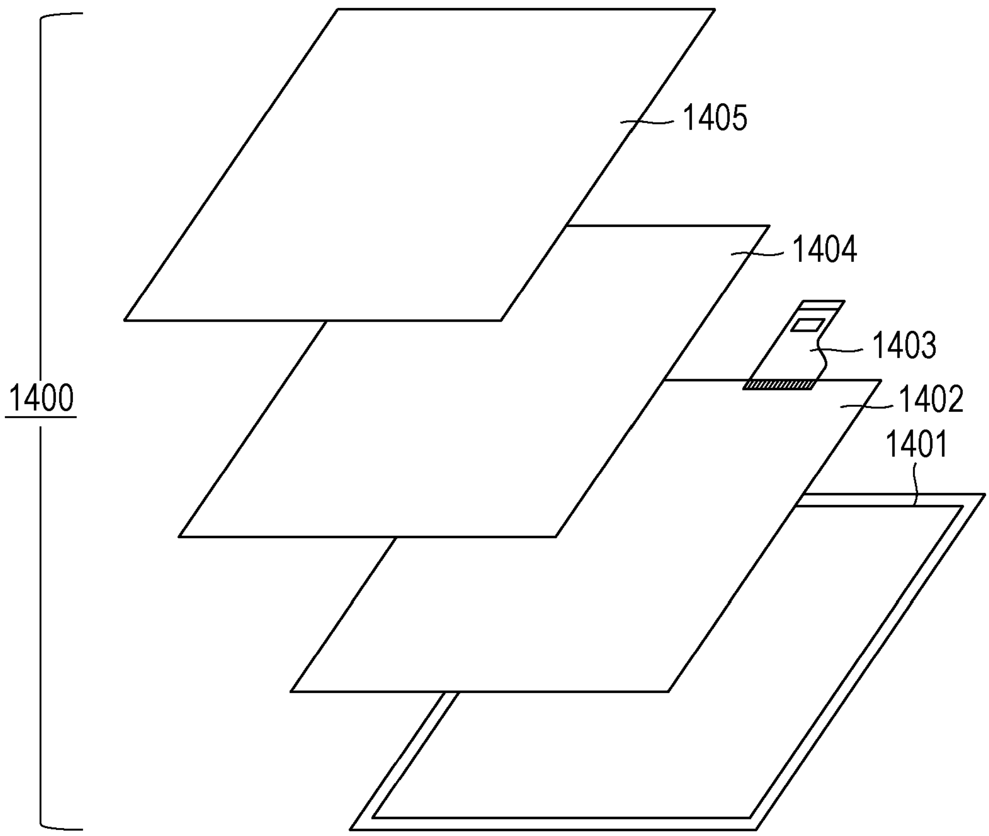


FIG. 6B

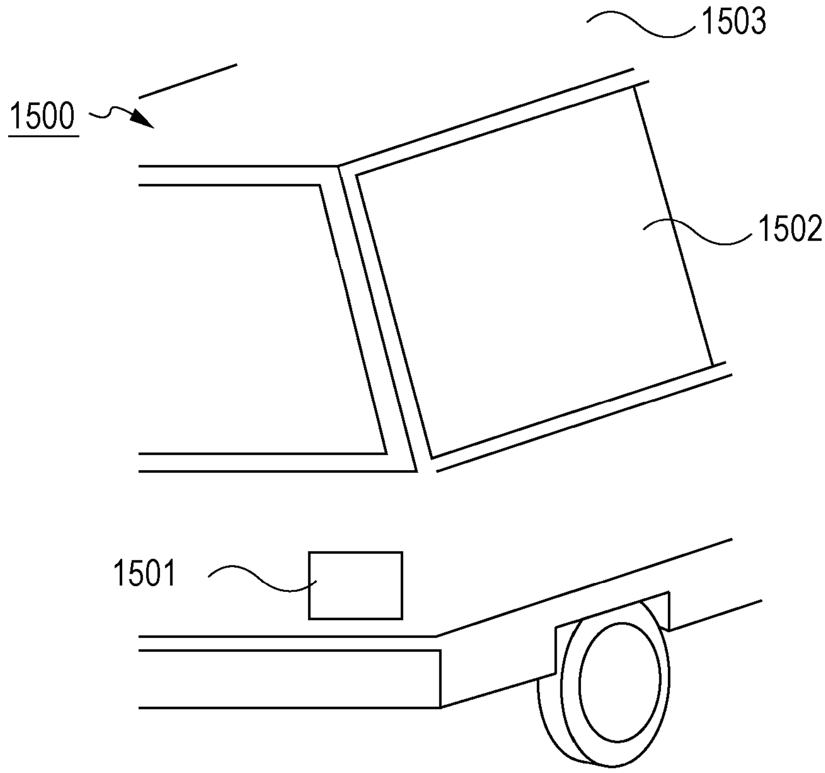

FIG. 7A

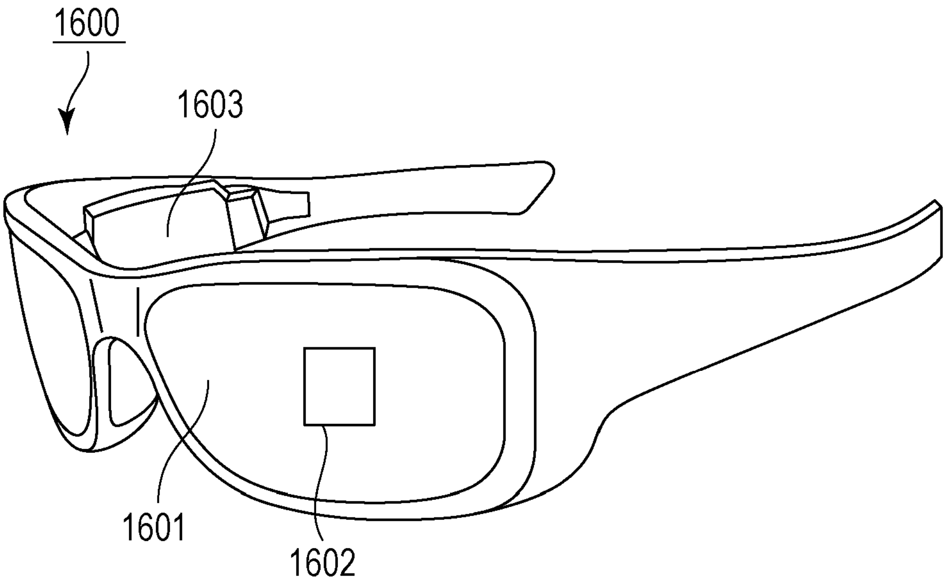


FIG. 7B

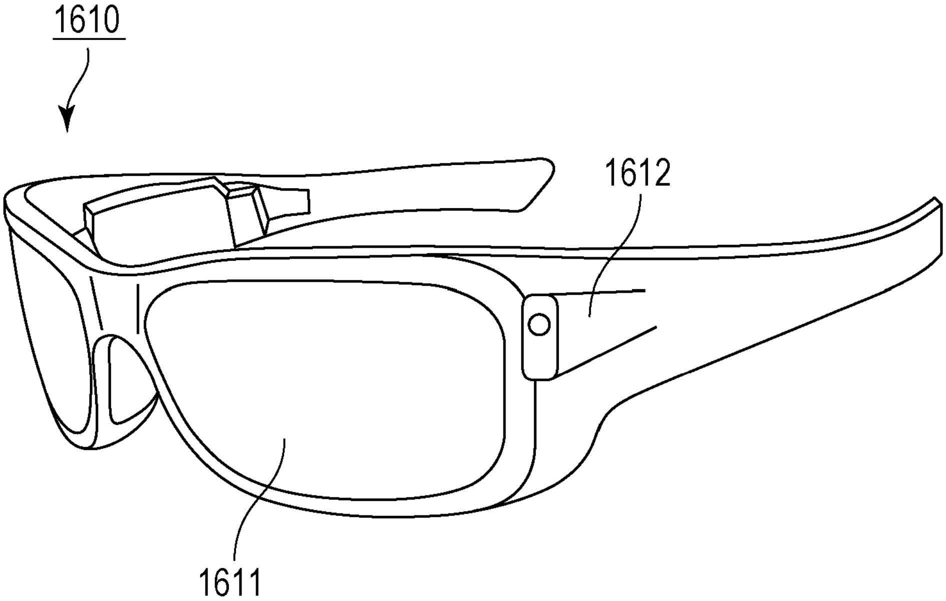

FIG. 8A

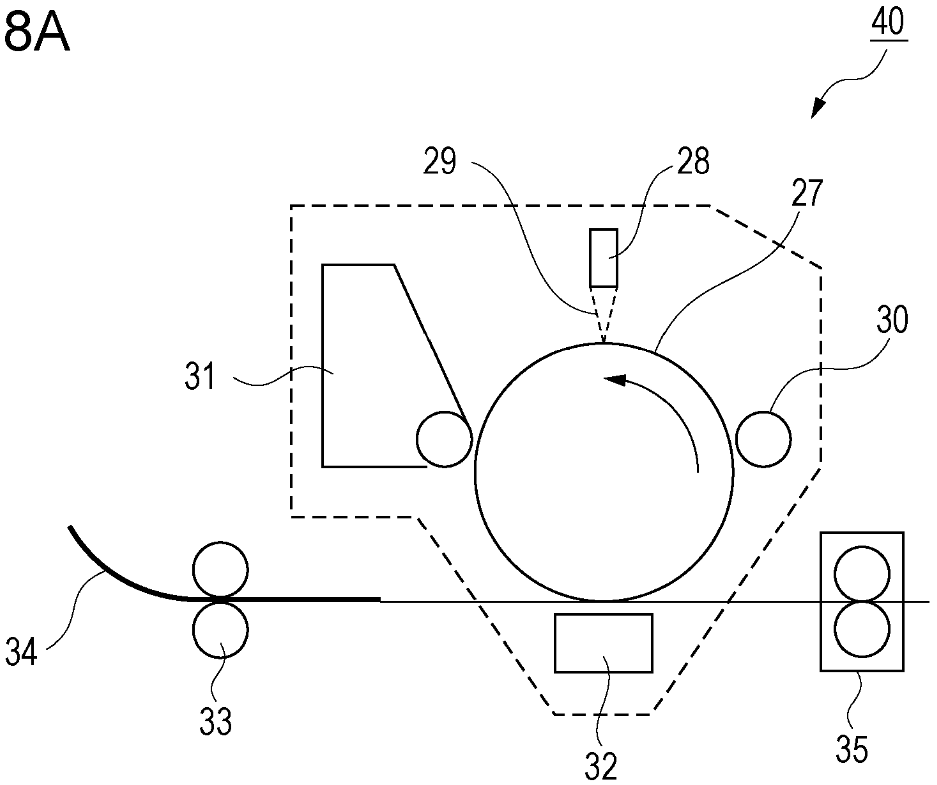


FIG. 8B

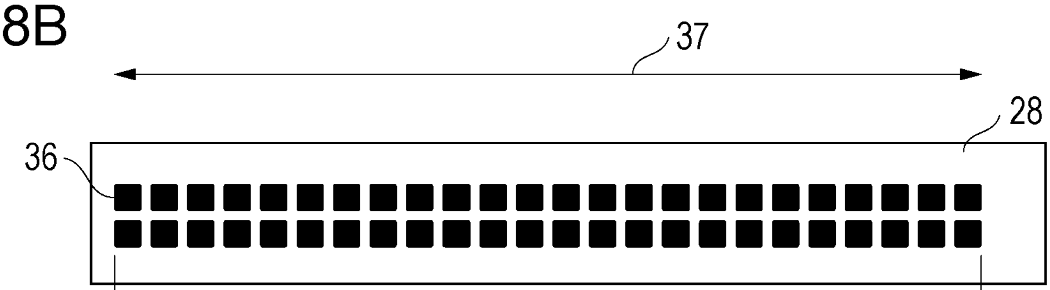


FIG. 8C

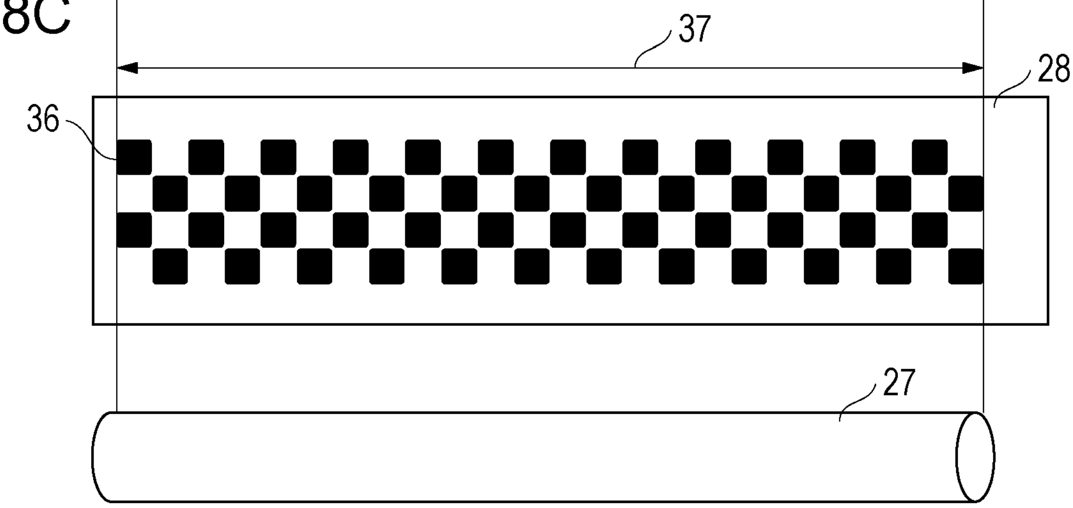

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20160104844
- JP 2014075347 A